# EUROPEAN PATENT SPECIFICATION

(11) **EP 2 112 185 B1**
(45) Date of publication and mention of the grant of the patent: **28.03.2012**
(21) Application number: 08704354.3
(22) Date of filing: 01.02.2008
(51) Int. Cl.: C08G 61/12, C08L 65/00, C09K 11/06, H01L 51/50

(54) **BLOCK COPOLYMER, COMPOSITION USING THE SAME, LIQUID COMPOSITION, LIGHT-EMITTING THIN FILM, AND POLYMER LIGHT-EMITTING DEVICE**
BLOCKCOPOLYMER, ZUSAMMENSETZUNG DAMIT, FLÜSSIGE ZUSAMMENSETZUNG, LICHTEMITTIERENDER DÜNNER FILM UND LICHTEMITTIERENDE POLYMERVORRICHTUNG
BLOC COPOLYMÈRE, COMPOSITION UTILISANT LEDIT BLOC COPOLYMÈRE, COMPOSITION LIQUIDE, FILM MINCE ÉLECTROLUMINESCENT ET DISPOSITIF ÉLECTROLUMINESCENT POLYMÈRE

(30) Priority: 01.02.2007 JP 2007023346
(43) Date of publication of application: 28.10.2009
(73) Proprietor: Sumitomo Chemical Company, Limited, Tokyo 104-8260 (JP)
(72) Inventor: NAKATANI, Tomoya, Tsukuba-shi Ibaraki 305-0821 (JP); KAKIMOTO, Hidenobu, Tsukuba-shi Ibaraki 305-0821 (JP)
(74) Representative: Duckworth, Timothy John
(86) International application number: PCT/JP2008/051645
(87) International publication number: WO 2008/093831

(56) References cited:
- WO-A1-2007/058368
- WO-A2-2006/060437
- DE-A1- 10 357 317
- JP-A- 2003 226 744
- US-A1- 2004 260 090

## Description

### TECHNICAL FIELD

The present invention relates to a block copolymer, a composition using the same, a liquid composition, a light-emitting thin film, and a polymer light-emitting device.

### BACKGROUND ART

High-molecular-weight light-emitting materials and charge transfer materials are useful as materials used for organic layers in light-emitting devices, for example, and various such materials or the like have been studied. For example, WO 2006/060437 (PATENT DOCUMENT 1) discloses a copolymer of a divalent group represented by the following general formula:

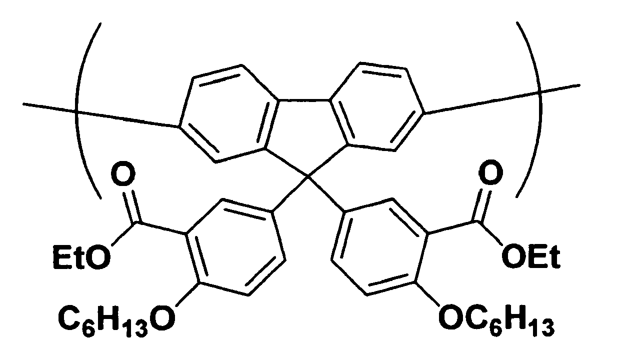

wherein Et represents an ethyl group, and a divalent triarylamine derivative. WO 2003/007395 (PATENT DOCUMENT 2) discloses a block copolymer comprising a 9,9-dioctylfluorene group and N,N,N',N'-tetraallyl-1,4-diaminobenzene.

PATENT DOCUMENT 1: WO 2006/060437
PATENT DOCUMENT 2: WO 2003/007395

### DISCLOSURE OF THE INVENTION

### PROBLEMS TO BE SOLVED BY THE INVENTION

However, the conventional copolymers described in PATENT DOCUMENTS 1 to 2 cannot sufficiently prevent an increase in driving voltage when used as light-emitting materials for light-emitting devices. Further, the conventional copolymers described in PATENT DOCUMENTS 1 to 2 do not necessarily have a sufficient luminance half-life when used as light-emitting materials for light-emitting devices.

The present invention has been achieved in view of the above problems of the conventional art. An object of the present invention is to provide a block copolymer allowing production of a light-emitting device that can sufficiently suppress an increase in driving voltage and has a sufficiently long luminance half-life when used as a material for a light-emitting device, and a composition, a liquid composition, a light-emitting thin film and a polymer light-emitting device using the same.

### MEANS FOR SOLVING THE PROBLEMS

As a result of extensive studies to achieve the above object, the present inventors have found that it is possible to produce a light-emitting device that can sufficiently suppress an increase in driving voltage and has a sufficiently long luminance half-life when using, as a material for a light-emitting device, a block copolymer obtained by comprising a block (A) containing at least one repeating unit represented by the following general formula (I), at least one repeating unit represented by the following general formula (II) and at least one repeating unit represented by the following general formula (III), and a block (B) containing at least one repeating unit represented by the following general formula (III) and at least one repeating unit represented by the following general formula (IV). This finding has led to the completion of the present invention.

Specifically, the block copolymer of the present invention is characterized by comprising:
a block (A) containing at least one repeating unit represented by the following general formula (I), at least one repeating unit represented by the following general formula (II), and at least one repeating unit represented by the following general formula (III); and
a block (B) containing at least one repeating unit represented by the following general formula (III) and at least one repeating unit represented by the following formula (IV),

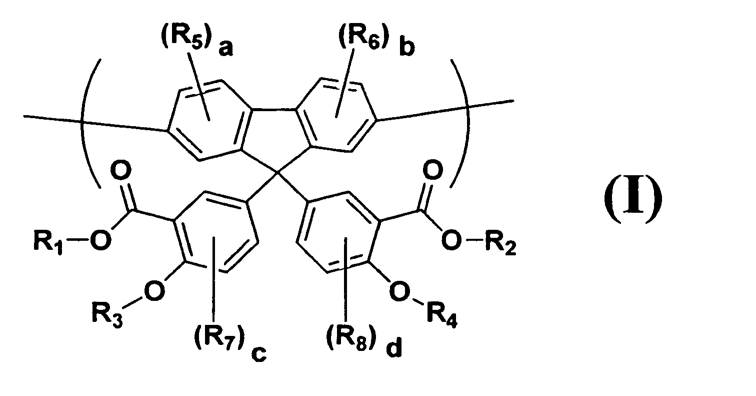

wherein R₁, R₂, R₃ and R₄ may be the same or different and each represent a hydrogen atom or an alkyl group; R₅, R₆, R₇ and R₈ may be the same or different and each represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group; a, b, c and d may be the same or different and each represent an integer of 0 to 3; and when a plurality of R₅, R₆, R₇ or R₈ are present, they may be the same or different,

-Ar₁- (II)

wherein Ar₁ represents a divalent heterocyclic group containing a five-membered ring,

-Ar₂- (III)

wherein Ar₂ represents an arylene group, and

-Ar₃- (IV)

wherein Ar₃ represents a divalent aromatic amine residue.

In the block copolymer of the present invention, Ar₁ in the general formula (II) is preferably a group represented by the following general formula (V) :

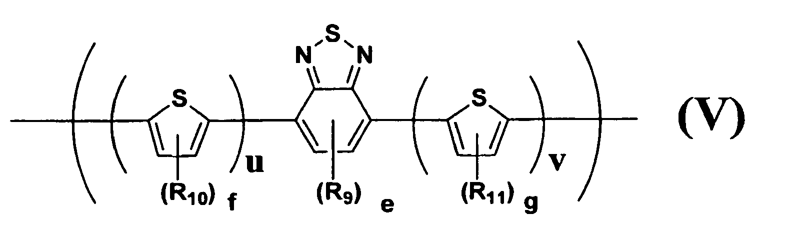

wherein R₉, R₁₀ and R₁₁ may be the same or different and each represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, e, f and g may be the same or different and each represent an integer of 0 to 2, and u and v may be the same or different and each represent an integer of 0 to 2, provided that when a plurality of R₉, R₁₀ or R₁₁ are present, they may be the same or different.

In the block copolymer of the present invention, Ar₂ in the general formula (III) is preferably a group represented by the following general formula (VI):

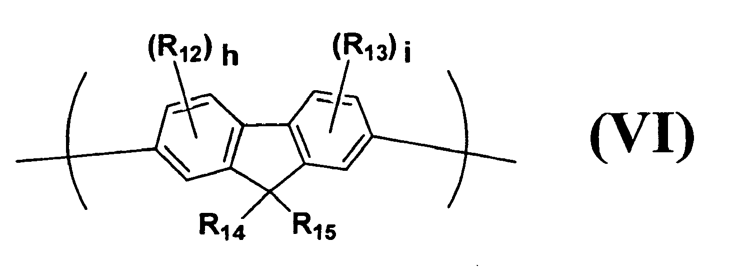

wherein R₁₂ and R₁₃ may be the same or different and each represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, h and i may be the same or different and each represent an integer of 0 to 3, and R₁₄ and R₁₅ may be the same or different and each represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, provided that when a plurality of R₁₂ or R₁₃ are present, they may be the same or different.

Further, in the block copolymer of the present invention, Ar₃ in the general formula (IV) is preferably a group represented by the following general formula (VII):

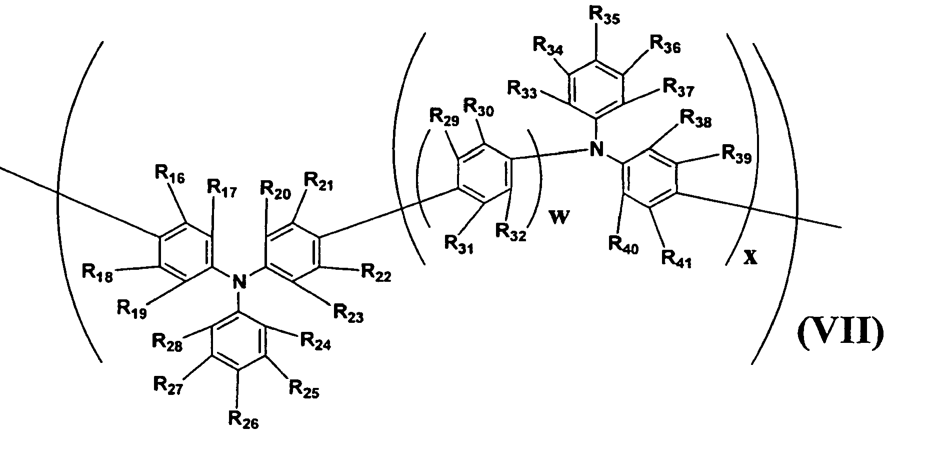

wherein R₁₆ to R₄₁ may be the same or different and each represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, and w and x may be the same or different and each represent an integer of 0 or 1,
provided that the carbon atom to which R₁₇ is bonded and the carbon atom to which R₂₀ is bonded, the carbon atom to which R₁₉ is bonded and the carbon atom to which R₂₈ is bonded, the carbon atom to which R₃₂ is bonded and the carbon atom to which R₄₀ is bonded, or the carbon atom to which R₃₇ is bonded and the carbon atom to which R₃₈ is bonded, may be directly bonded or bonded via an oxygen atom or a sulfur atom to each other to form a ring, respectively, and when such a ring is formed, R₁₇ and R₂₀, R₁₉ and R₂₈, R₃₂ and R₄₀, or R₃₇ and R₃₈, together represent the direct bond, the oxygen atom or the sulfur atom, and
R₂₂ and R₃₁, or R₂₁ and R₂₉, may be directly bonded to each other to form a ring which may have a substituent, respectively.

The block copolymer of the present invention preferably comprises the at least two repeating units in which Ar₁ in the general formula (II) is a group represented by the general formula (V). Specifically, the block copolymer of the present invention preferably comprises the at least two repeating units represented by the general formula (V) as the repeating units represented by the general formula (II).

In the block copolymer of the present invention, the total content of the repeating unit(s), in which Ar₁ in the general formula (II) is a group represented by the general formula (V), is preferably 3 mol% or more and 40 mol% or less based on the total repeating units contained in the block copolymer.

Further, in the block copolymer of the present invention, the group represented by the general formula (VII) is preferably at least one selected from the group consisting of a group in which x in the formula (VII) is 0 and a group represented by the following general formula (VIII):

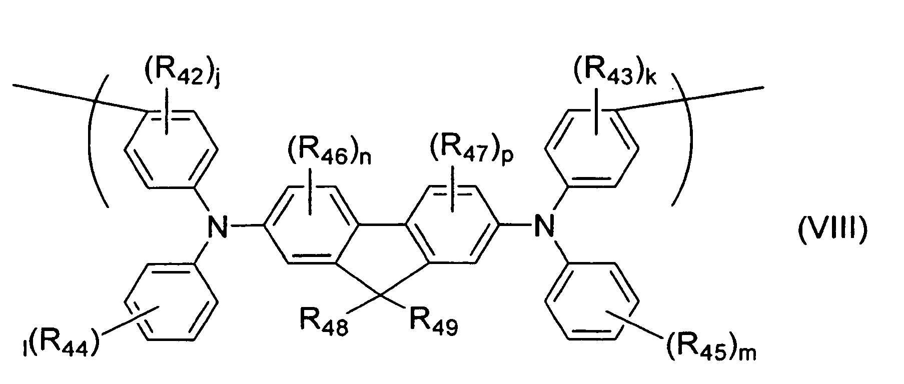

wherein R₄₂ to R₄₇ may be the same or different and each represent a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group,
j and k may be the same or different and each represent an integer of 0 to 4,
l and m may be the same or different and each represent an integer of 0 to 5, and
n and p may be the same or different and each represent an integer of 0 to 3,
provided that when a plurality of at least one of groups among R₄₂, R₄₃, R₄₄, R₄₅, R₄₆ or R₄₇, they may be the same or different, and
R₄₈ and R₄₉ may be the same or different and each represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group.
In the block copolymer of the present invention, the molar ratio of the block (A) to the block (B) ((A)/(B)) is preferably 0.1 to 10.

Moreover, for the block copolymer of the present invention, it is preferred that the block copolymer should have a weight average molecular weight based on polystyrene standards of 10³ to 10⁷.

Furthermore, in the block copolymer of the present invention, it is preferred that the weight-average molecular weight of the block (A) should be 10³ to 10⁵ based on polystyrene standards.

Moreover, a composition of the present invention is characterized by comprising the block copolymer of the present invention and at least one material selected from the group consisting of a light-emitting material, a hole transport material and an electron transport material.

Moreover, a liquid composition of the present invention is characterized by comprising the block copolymer of the present invention and a solvent.

Furthermore, a light-emitting thin film of the present invention is characterized by comprising the block copolymer of the present invention.

The polymer light-emitting device of the present invention is characterized by comprising, between electrodes consisting of an anode and a cathode, an organic layer containing the block copolymer of the present invention.

Further, in the polymer light-emitting device of the present invention, the organic layer is preferably a light-emitting layer.

### ADVANTAGES OF THE INVENTION

The present invention can provide a block copolymer allowing production of a light-emitting device that can sufficiently suppress an increase in driving voltage and has a sufficiently long luminance half-life when used as a material for a light-emitting device, and a composition, a liquid composition, a light-emitting thin film and a polymer light-emitting device using the same.

Thus, the block copolymer of the present invention can be used preferably as a material for a liquid-crystal display backlight, a curved or planar light source for illumination, a segment-type display device, a dot matrix flat-panel display, and so on.

### BEST MODE FOR CARRYING OUT THE INVENTION

The present invention will be described in detail below with reference to preferred embodiments thereof.

First, the block copolymer of the present invention will be described. Specifically, the block copolymer of the present invention is characterized by comprising a block (A) containing at least one repeating unit represented by the following general formula (I):

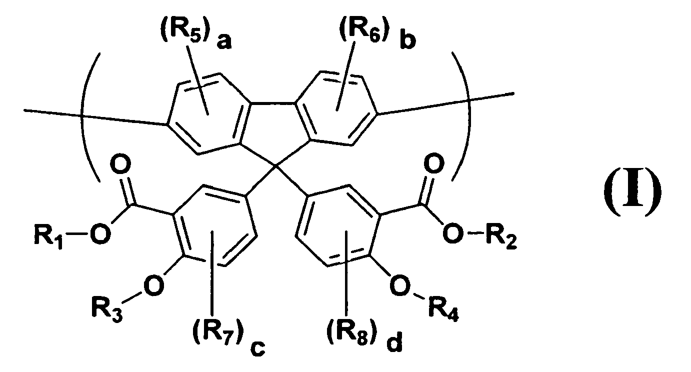

wherein R₁, R₂, R₃ and R₄ may be the same or different and each represent a hydrogen atom or an alkyl group; R₅, R₆, R₇ and R₈ may be the same or different and each represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group; a, b, c and d may be the same or different and each represent an integer of 0 to 3; and when a plurality of R₅, R₆, R₇ or R₈ are present, they may be the same or different,
at least one repeating unit represented by the following general formula (II):

-Ar₁- (II)

wherein Ar₁ represents a divalent heterocyclic group containing a five-membered ring, and
at least one repeating unit represented by the following general formula (III):

-Ar₂- (III)

wherein Ar₂ represents an arylene group, and
a block (B) containing at least one repeating unit represented by the general formula (III) and at least one repeating unit represented by the following formula (IV):

-Ar₃- (IV)

wherein Ar₃ represents a divalent aromatic amine residue.

As described above, the block (A) according to the present invention contains at least one repeating unit represented by the general formula (I). The alkyl group that may be selected as R₁, R₂, R₃, R₄, R₅, R₆, R₇ or R₈ in such a general formula (I) may be linear, branched or cyclic and may further have a substituent. Moreover, such an alkyl group has preferably 1 to 20 (more preferably 1 to 10) carbon atoms. Examples thereof include methyl, ethyl, propyl, isopropyl, butyl, isobutyl, s-butyl, t-butyl, pentyl, hexyl, cyclohexyl, heptyl, octyl, 2-ethylhexyl, nonyl, decyl, 3,7-dimethyloctyl, lauryl, trifluoromethyl, pentafluoroethyl, perfluorobutyl, perfluorohexyl and perfluorooctyl groups.

The alkoxy group that may be selected as R₅, R₆, R₇ or R₈ in the general formula (I) may be linear, branched or cyclic and may further have a substituent. Moreover, such an alkoxy group has preferably 1 to 20 (more preferably 1 to 10) carbon atoms. Examples thereof include methoxy, ethoxy, propyloxy, isopropyloxy, butoxy, isobutoxy, s-butoxy, t-butoxy, pentyloxy, hexyloxy, cyclohexyloxy, heptyloxy, octyloxy, 2-ethylhexyloxy, nonyloxy, decyloxy, 3,7-dimethyloctyloxy, lauryloxy, trifluoromethoxy, pentafluoroethoxy, perfluorobutoxy, perfluorohexyloxy, perfluorooctyloxy, methoxymethyloxy and 2-methoxyethyloxy groups.

Moreover, the alkylthio group that may be selected as R₅, R₆, R₇ or R₈ in the general formula (I) may be linear, branched or cyclic and may further have a substituent. Furthermore, such an alkylthio group has preferably 1 to 20 (more preferably 1 to 10) carbon atoms. Examples thereof include methylthio, ethylthio, propylthio, isopropylthio, butylthio, isobutylthio, s-butylthio, t-butylthio, pentylthio, hexylthio, cyclohexylthio, heptylthio, octylthio, 2-ethylhexylthio, nonylthio, decylthio, 3,7-dimethyloctylthio, laurylthio and trifluoromethylthio groups.

Furthermore, the aryl group that may be selected as R₅, R₆, R₇ or R₈ in the general formula (I) is not particularly limited as long as it is an atomic group derived from aromatic hydrocarbon by removal of one hydrogen atom. It includes those having a condensed ring and those comprising two or more independent benzene rings or condensed rings bonded directly or via a group such as vinylene. Such an aryl group has preferably 6 to 60 (more preferably 7 to 48) carbon atoms. Examples thereof include phenyl, C₁ to C₁₂ alkoxyphenyl (the term C₁ to C₁₂ means that the moiety has 1 to 12 carbon atoms; the same holds true for description below), C₁ to C₁₂ alkylphenyl, 1-naphthyl, 2-naphthyl, 1-anthracenyl, 2-anthracenyl, 9-anthracenyl and pentafluorophenyl groups. Among such aryl groups, C₁ to C₁₂ alkoxyphenyl and C₁ to C₁₂ alkylphenyl groups are more preferable.

Examples of the C₁ to C₁₂ alkoxy among such aryl groups include methoxy, ethoxy, propyloxy, isopropyloxy, butoxy, isobutoxy, s-butoxy, t-butoxy, pentyloxy, hexyloxy, cyclohexyloxy, heptyloxy, octyloxy, 2-ethylhexyloxy, nonyloxy, decyloxy, 3,7-dimethyloctyloxy and lauryloxy.

Moreover, examples of the C₁ to C₁₂ alkylphenyl group among the aryl groups include methylphenyl, ethylphenyl, dimethylphenyl, propylphenyl, mesityl, methylethylphenyl, isopropylphenyl, butylphenyl, isobutylphenyl, t-butylphenyl, pentylphenyl, isoamylphenyl, hexylphenyl, heptylphenyl, octylphenyl, nonylphenyl, decylphenyl and dodecylphenyl groups.

Moreover, the aryloxy group that may be selected as R₅, R₆, R₇ or R₈ in the general formula (I) has preferably 6 to 60 (more preferably 7 to 48) carbon atoms. Examples thereof include phenoxy, C₁ to C₁₂ alkoxyphenoxy, C₁ to C₁₂ alkylphenoxy, 1-naphthyloxy, 2-naphthyloxy and pentafluorophenyloxy groups. Moreover, among such aryloxy groups, C₁ to C₁₂ alkoxyphenoxy and C₁ to C₁₂ alkylphenoxy groups are more preferable.

Examples of the C₁ to C₁₂ alkoxy among the aryloxy groups include methoxy, ethoxy, propyloxy, isopropyloxy, butoxy, isobutoxy, s-butoxy, t-butoxy, pentyloxy, hexyloxy, cyclohexyloxy, heptyloxy, octyloxy, 2-ethylhexyloxy, nonyloxy, decyloxy, 3,7-dimethyloctyloxy and lauryloxy.

Moreover, examples of the C₁ to C₁₂ alkylphenoxy group among the aryloxy groups include methylphenoxy, ethylphenoxy, dimethylphenoxy, propylphenoxy, 1,3,5-trimethylphenoxy, methylethylphenoxy, isopropylphenoxy, butylphenoxy, isobutylphenoxy, s-butylphenoxy, t-butylphenoxy, pentylphenoxy, isoamylphenoxy, hexylphenoxy, heptylphenoxy, octylphenoxy, nonylphenoxy, decylphenoxy and dodecylphenoxy groups.

Moreover, the arylthio group that may be selected as R₅, R₆, R₇ or R₈ in the general formula (I) is not particularly limited as long as it is the aryl group bonded to a sulfur element. It may have a substituent on the aromatic ring of the aryl group. Such an arylthio group has preferably 3 to 60 (more preferably 5 to 30) carbon atoms. Examples thereof include phenylthio, C₁ to C₁₂ alkoxyphenylthio, C₁ to C₁₂ alkylphenylthio, 1-naphthylthio, 2-naphthylthio, pentafluorophenylthio, pyridylthio, pyridazinylthio, pyrimidylthio, pyrazinylthio and triazinylthio groups.

Furthermore, the arylalkyl group that may be selected as R₅, R₆, R₇ or R₈ in the general formula (I) is not particularly limited as long as it is the aryl group bonded to the alkyl group. It may have a substituent. Such an arylalkyl group has preferably 7 to 60 (more preferably 7 to 30) carbon atoms. Examples thereof include phenyl-C₁ to C₁₂ alkyl, C₁ to C₁₂ alkoxyphenyl-C₁ to C₁₂ alkyl, C₁ to C₁₂-alkylphenyl-C₁ to C₁₂ alkyl, 1-naphthyl-C₁ to C₁₂ alkyl and 2-naphthyl-C₁ to C₁₂ alkyl groups.

Moreover, the arylalkoxy group that may be selected as R₅, R₆, R₇ or R₈ in the general formula (I) is not particularly limited as long as it is the aryl group bonded to the alkoxy group. It may have a substituent. Such an arylalkoxy group has preferably 7 to 60 (more preferably 7 to 30) carbon atoms. Examples thereof include phenyl-C₁ to C₁₂ alkoxy, C₁ to C₁₂ alkoxyphenyl-C₁ to C₁₂ alkoxy, C₁ to C₁₂ alkylphenyl-C₁ to C₁₂ alkoxy, 1-naphthyl-C₁ to C₁₂ alkoxy and 2-naphthyl-C₁ to C₁₂ alkoxy groups.

Moreover, the arylalkylthio group that may be selected as R₅, R₆, R₇ or R₈ in the general formula (I) is not particularly limited as long as it is the aryl group bonded to the alkylthio group. It may have a substituent. Such an arylalkylthio group has preferably 7 to 60 (more preferably 7 to 30) carbon atoms. Examples thereof include phenyl-C₁ to C₁₂ alkylthio, C₁ to C₁₂ alkoxyphenyl-C₁ to C₁₂ alkylthio, C₁ to C₁₂ alkylphenyl-C₁ to C₁₂ alkylthio, 1-naphthyl-C₁ to C₁₂ alkylthio and 2-naphthyl-C₁ to C₁₂ alkylthio groups.

Moreover, the arylalkenyl group that may be selected as R₅, R₆, R₇ or R₈ in the general formula (I) needs only to be the aryl group bonded to an alkenyl group. Such an arylalkenyl group is not particularly limited and has preferably 8 to 60 (more preferably 8 to 30) carbon atoms. It is exemplified by phenyl-C₂ to C₁₂ alkenyl, C₁ to C₁₂ alkoxyphenyl-C₂ to C₁₂ alkenyl, C₁ to C₁₂ alkylphenyl-C₂ to C₁₂ alkenyl, 1-naphthyl-C₂ to C₁₂ alkenyl and 2-naphthyl-C₂ to C₁₂ alkenyl groups. C₁ to C₁₂ alkoxyphenyl-C₂ to C₁₂ alkenyl and C₂ to C₁₂ alkylphenyl-C₂ to C₁₂ alkenyl groups are more preferable.

Furthermore, the arylalkynyl group that may be selected as R₅, R₆, R₇ or R₈ in the general formula (I) needs only to be the aryl group bonded to an alkynyl group. Such an arylalkynyl group is not particularly limited and has preferably 8 to 60 (more preferably 8 to 30) carbon atoms. It is exemplified by phenyl-C₂ to C₁₂ alkynyl, C₁ to C₁₂ alkoxyphenyl-C₂ to C₁₂ alkynyl, C₁ to C₁₂ alkylphenyl-C₂ to C₁₂ alkynyl, 1-naphthyl-C₂ to C₁₂ alkynyl and 2-naphthyl-C₂ to C₁₂ alkynyl groups. C₁ to C₁₂ alkoxyphenyl-C₂ to C₁₂ alkynyl and C₁ to C₁₂ alkylphenyl-C₂ to C₁₂ alkynyl groups are more preferable.

Moreover, the substituted amino group that may be selected as R₅, R₆, R₇ or R₈ in the general formula (I) is not particularly limited and is preferably an amino group substituted by one or two groups selected from the group consisting of an alkyl group, an aryl group, an arylalkyl group and a monovalent heterocyclic group. Moreover, the alkyl group, the aryl group, the arylalkyl group or the monovalent heterocyclic group in such a substituted amino group may have an additional substituent. Furthermore, such a substituted amino group has 1 to 60 (more preferably 2 to 48) carbon atoms exclusive of the carbon number of the substituent.

Examples of such a substituted amino group include methylamino, dimethylamino, ethylamino, diethylamino, propylamino, dipropylamino, isopropylamino, diisopropylamino, butylamino, isobutylamino, secondary butyl, s-butylamino, t-butylamino, pentylamino, hexylamino, cyclohexylamino, heptylamino, octylamino, 2-ethylhexylamino, nonylamino, decylamino, 3,7-dimethyloctylamino, laurylamino, cyclopentylamino, dicyclopentylamino, cyclohexylamino, dicyclohexylamino, pyrrolidyl, piperidyl, ditrifluoromethylamino, phenylamino, diphenylamino, C₁ to C₁₂ alkoxyphenylamino, di(C₁ to C₁₂
alkoxyphenyl) amino, di(C₁ to C₁₂ alkylphenyl)amino, 1-naphthylamino, 2-naphthylamino, pentafluorophenylamino, pyridylamino, pyridazinylamino, pyrimidylamino, pyrazinylamino, triazinylamino, phenyl-C₁ to C₁₂ alkylamino, C₁ to C₁₂ alkoxyphenyl-C₁ to C₁₂ alkylamino, C₁ to C₁₂ alkylphenyl-C₁ to C₁₂ alkylamino, di(C₁ to C₁₂ alkoxyphenyl-C₁ to C₁₂ alkyl) amino, di (C₁ to C₁₂ alkylphenyl-C₁ to C₁₂ alkyl)amino, 1-naphthyl-C₁ to C₁₂ alkylamino and 2-naphthyl-C₁ to C₁₂ alkylamino groups.

Moreover, examples of the substituted silyl group that may be selected as R₅, R₆, R₇ or R₈ in the general formula (I) include a silyl group substituted by one to three groups selected from the group consisting of an alkyl group, an aryl group, an arylalkyl group and a monovalent heterocyclic group. Such a substituted silyl group is not particularly limited and has preferably 1 to 60 (more preferably 3 to 48) carbon atoms. In this context, the alkyl group, the aryl group, the arylalkyl group or the monovalent heterocyclic group in such a substituted silyl group may have a substituent.

Examples of such a substituted silyl group include trimethylsilyl, triethylsilyl, tripropylsilyl, tri-isopropylsilyl, dimethyl-isopropylsilyl, diethylisopropylsilyl, t-butylsilyldimethylsilyl, pentyldimethylsilyl, hexyldimethylsilyl, heptyldimethylsilyl, octyldimethylsilyl, 2-ethylhexyldimethylsilyl, nonyldimethylsilyl, decyldimethylsilyl, 3,7-dimethyloctyl-dimethylsilyl, lauryldimethylsilyl, phenyl-C₁ to C₁₂ alkylsilyl, C₁ to C₁₂ alkoxyphenyl-C₁ to C₁₂ alkylsilyl, C₁ to C₁₂ alkylphenyl-C₁ to C₁₂ alkylsilyl, 1-naphthyl-C₁ to C₁₂ alkylsilyl, 2-naphthyl-C₁ to C₁₂ alkylsilyl, phenyl-C₁ to C₁₂ alkyldimethylsilyl, triphenylsilyl, tri-p-xylylsilyl, tribenzylsilyl, diphenylmethylsilyl, t-butyldiphenylsilyl and dimethylphenylsilyl groups.

Moreover, examples of the halogen atom that may be selected as R₅, R₆, R₇ or R₈ in the general formula (I) include fluorine, chlorine, bromine and iodine atoms.

Furthermore, the acyl group that may be selected as R₅, R₆, R₇ or R₈ in the general formula (I) is not particularly limited and has preferably 2 to 20 (more preferably 2 to 18) carbon atoms. Examples thereof include acetyl, propionyl, butyryl, isobutyryl, pivaloyl, benzoyl, trifluoroacetyl and pentafluorobenzoyl groups.

Moreover, the acyloxy group that may be selected as R₅, R₆, R₇ or R₈ in the general formula (I) is not particularly limited and has preferably 2 to 20 (more preferably 2 to 18) carbon atoms. Examples thereof include acetoxy, propionyloxy, butyryloxy, isobutyryloxy, pivaloyloxy, benzoyloxy, trifluoroacetyloxy and pentafluorobenzoyloxy groups.

Moreover, the imine residue that may be selected as R₅, R₆, R₇ or R₈ in the general formula (I) is not particularly limited as long as it is a residue derived from an imine compound (which refers to an organic compound having a group represented by the formula -N=C- in the molecule; examples thereof include aldimine, ketimine, and compounds having an alkyl group or the like substituted for a hydrogen atom on N in these molecules) by removal of one hydrogen atom. The imine residue has preferably 2 to 20 (more preferably 2 to 18) carbon atoms. Examples of such an imine residue include groups represented by the following structural formulas:

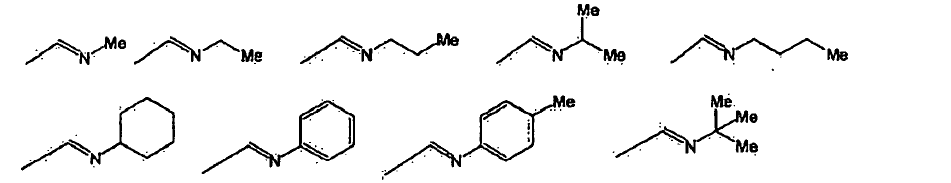

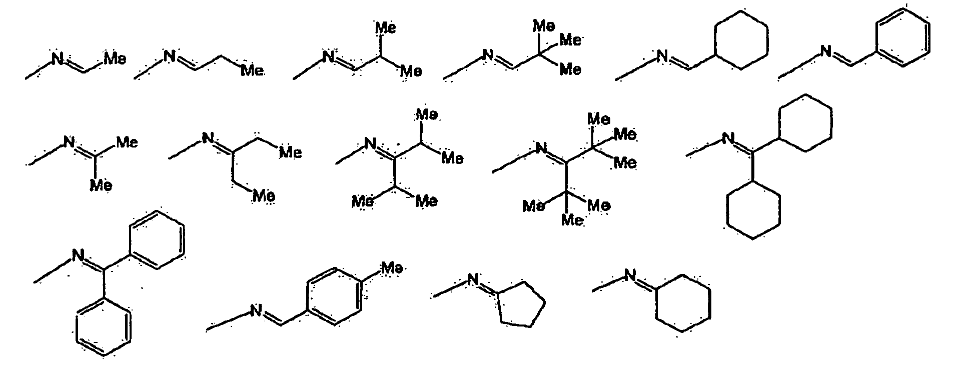

Me represents a methyl group.

Furthermore, the amide group that may be selected as R₅, R₆, R₇ or R₈ in the general formula (I) is not particularly limited and has preferably 2 to 20 (more preferably 2 to 18) carbon atoms. Examples thereof include formamide, acetamide, propionamide, butylamide, benzamide, trifluoroacetamide, pentafluorobenzamide, diformamide, diacetamide, dipropionamide, dibutylamide, dibenzamide, ditrifluoroacetamide and dipentafluorobenzamide groups.

Moreover, the acid imide group that may be selected as R₅, R₆, R₇ or R₈ in the general formula (I) is not particularly limited as long as it is a residue derived from acid imide by removal of a hydrogen atom bonded to the nitrogen atom. The acid imide group has preferably 4 to 20 (more preferably 4 to 18) carbon atoms. Examples thereof include groups represented by the following structural formulas:

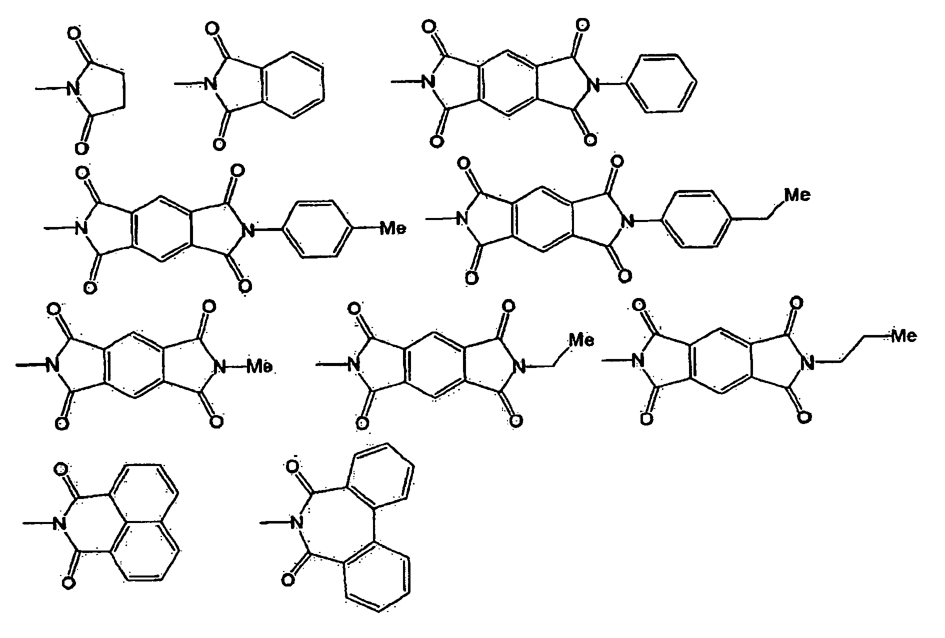

Me represents a methyl group.

Moreover, the monovalent heterocyclic group that may be selected as R₅, R₆, R₇ or R₈ in the general formula (I) refers to an atomic group derived from a heterocyclic compound by removal of one hydrogen atom. Such a monovalent heterocyclic group is not particularly limited and has preferably 4 to 60 (more preferably 4 to 20) carbon atoms. In this context, the carbon number of the substituent is excluded from the carbon number of such a monovalent heterocyclic group. Moreover, the heterocyclic compound refers to, of organic compounds having a cyclic structure, those endocyclically containing not only a carbon atom but also heteroatoms such as oxygen, sulfur, nitrogen, phosphorus and boron as elements constituting the ring. Examples of such a monovalent heterocyclic group include thienyl, C₁ to C₁₂ alkylthienyl, pyrrolyl, furyl, pyridyl, C₁ to C₁₂ alkylpyridyl, piperidyl, quinolyl and isoquinolyl groups. Among them, thienyl, C₁ to C₁₂ alkylthienyl, pyridyl and C₁ to C₁₂ alkylpyridyl groups are more preferable.

Moreover, the substituted carboxyl group that may be selected as R₅, R₆, R₇ or R₈ in the general formula (I) refers to a carboxyl group substituted by an alkyl group, an aryl group, an arylalkyl group or a monovalent heterocyclic group. Such a substituted carboxyl group has preferably 2 to 60 (more preferably 2 to 48) carbon atoms. Moreover, the alkyl group, the aryl group, the arylalkyl group or the monovalent heterocyclic group in the substituted carboxyl group may have an additional substituent. Such a substituted carboxyl group is not particularly limited, and examples thereof include methoxycarbonyl, ethoxycarbonyl, propoxycarbonyl, isopropoxycarbonyl, butoxycarbonyl, isobutoxycarbonyl, s-butoxycarbonyl, t-butoxycarbonyl, pentyloxycarbonyl, hexyloxycarbonyl, cyclohexyloxycarbonyl, heptyloxycarbonyl, octyloxycarbonyl, 2-ethylhexyloxycarbonyl, nonyloxycarbonyl, decyloxycarbonyl, 3,7-dimethyloctyloxycarbonyl, dodecyloxycarbonyl, trifluoromethoxycarbonyl, pentafluoroethoxycarbonyl, perfluorobutoxycarbonyl, perfluorohexyloxycarbonyl, perfluorooctyloxycarbonyl, phenoxycarbonyl, naphthoxycarbonyl and pyridyloxycarbonyl groups.

Moreover, R₅, R₆, R₇ or R₈ in the general formula (I) is preferably an alkyl group, an alkoxy group, an aryl group, an aryloxy group, a carboxyl group or a substituted carboxyl group from the viewpoint of easy synthesis of a raw material monomer.

Moreover, a, b, c and d in the general formula (I) are each independently more preferably 0 or 1 and most preferably 0 from the viewpoint of easy synthesis of a raw material monomer.

Furthermore, R₁, R₂, R₃ and R₄ in the general formula (I) are preferably an alkyl group from the viewpoint of easy synthesis of a raw material monomer.

Examples of such a repeating unit represented by the general formula (I) include repeating units represented by the following general formulas (I-1) to (I-9).

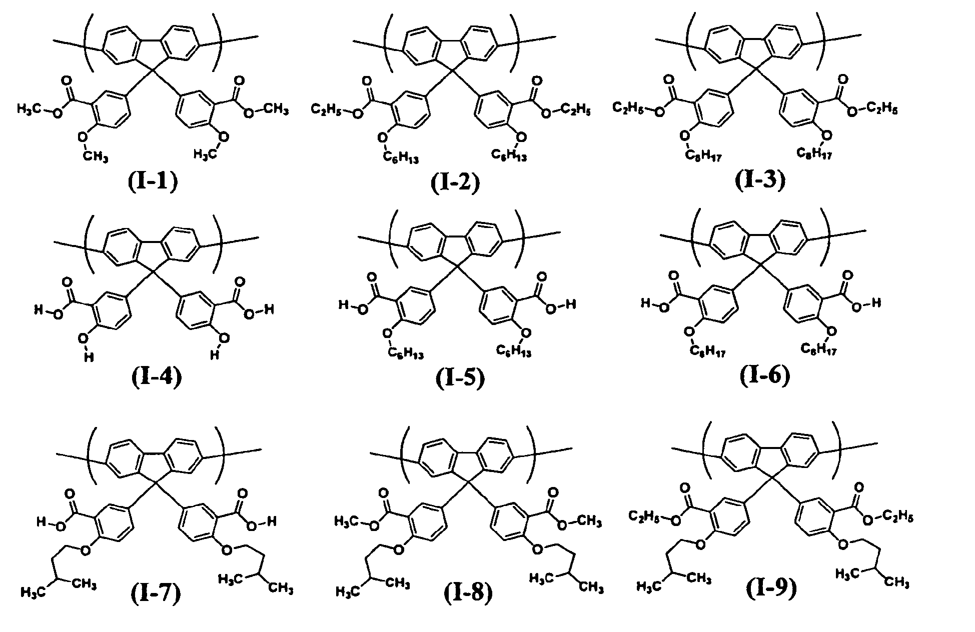

The block (A) according to the present invention contains, together with the at least one repeating unit represented by the general formula (I) as described above, at least one repeating unit represented by the general formula (II):

-Ar₁- (II)

wherein Ar₁ represents a divalent heterocyclic group containing a five-membered ring.

The divalent heterocyclic group containing a five-membered ring in the general formula (II) refers to an atomic group derived from a heterocyclic compound containing a five-membered ring by removal of two hydrogen atoms. Moreover, such a divalent heterocyclic group containing a five-membered ring may have a substituent. Moreover, such a heterocyclic compound containing a five-membered ring refers to, of organic compounds having a cyclic structure, those containing not only a carbon atom but also heteroatoms such as oxygen, sulfur, nitrogen, phosphorus, boron and arsenic as elements constituting the ring. Moreover, among such divalent heterocyclic groups containing a five-membered ring, an aromatic heterocyclic group is preferable. Moreover, the substituent which may be contained in such a divalent heterocyclic group containing a five-membered ring is not particularly limited. The substituent is preferably an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group from the viewpoint of solubility, fluorescence characteristics, easy synthesis, characteristics as the resulting device, and so on.

Moreover, such a divalent heterocyclic group containing a five-membered ring has preferably 3 to 60 (more preferably 3 to 20) carbon atoms in the moiety exclusive of the substituent. Furthermore, such a divalent heterocyclic group containing a five-membered ring has a total of preferably 3 to 100 (more preferably 3 to 50) carbon atoms inclusive of the substituent.

Examples of such a divalent heterocyclic group containing a five-membered ring include the following groups (a) to (f):
(a) groups which contain oxygen, silicon, nitrogen, sulfur, selenium, or the like as a heteroatom and have a fluorene structure (groups represented by the following general formulas 141 to 155);
(b) five-membered heterocyclic groups which contain oxygen, silicon, nitrogen, sulfur, selenium, boron, phosphorus, or the like as a heteroatom (groups represented by the following general formulas 156 to 175);
(c) five-membered condensed heterocyclic groups which contain oxygen, silicon, nitrogen, selenium, or the like as a heteroatom (groups represented by the following general formulas 176 to 187);
(d) five-membered heterocyclic groups which contain oxygen, silicon, nitrogen, sulfur, selenium, or the like as a heteroatom and form a dimer or an oligomer through a bond at the α-position relative to the heteroatom (groups represented by the following general formulas 188 to 189);
(e) five-membered heterocyclic groups which contain oxygen, silicon, nitrogen, sulfur, selenium, or the like as a heteroatom and are bonded to a phenyl group at the α-position relative to the heteroatom (groups represented by the following general formulas 190 to 196); and
(f) five-membered condensed heterocyclic group which contain oxygen, nitrogen, sulfur, selenium, or the like as a heteroatom and are substituted by a phenyl, furyl or thienyl group (groups represented by the following general formulas 197 to 202):

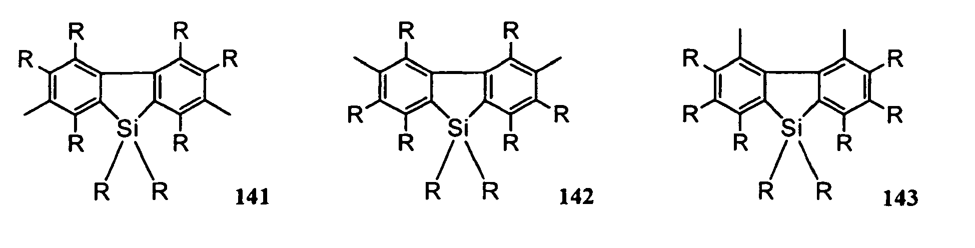

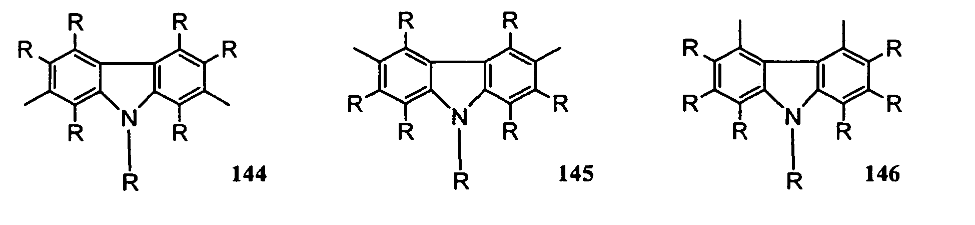

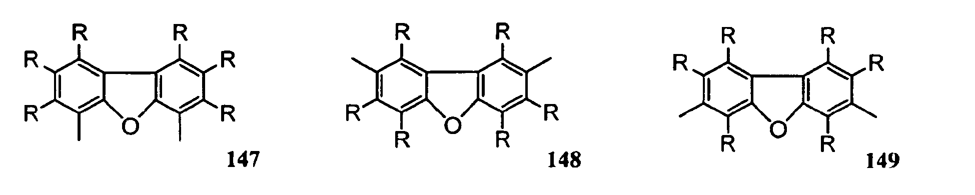

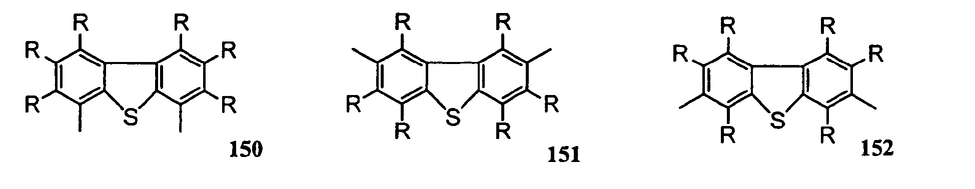

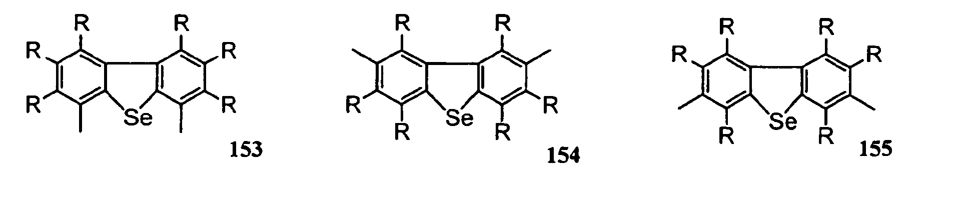

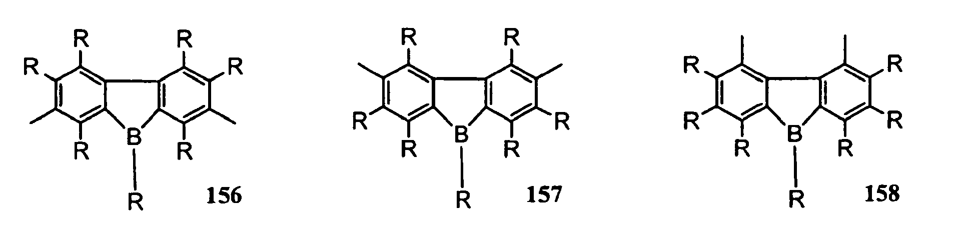

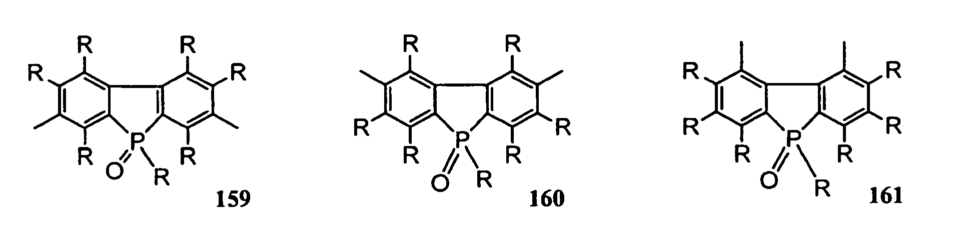

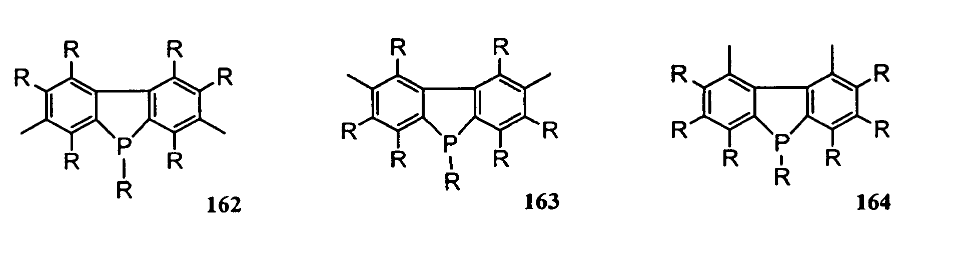

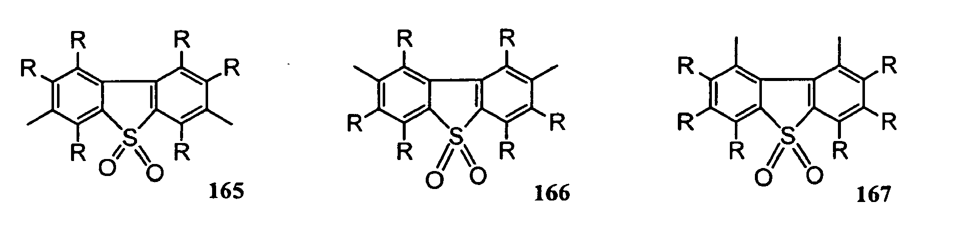

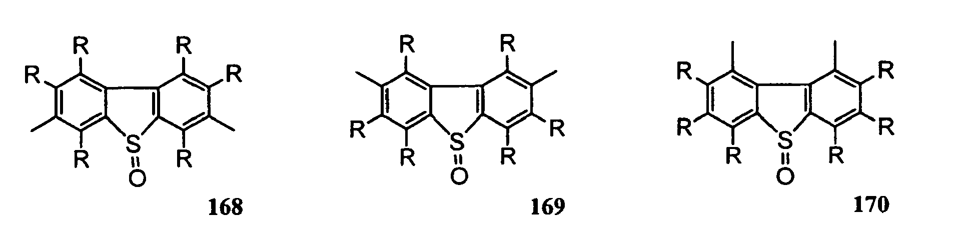

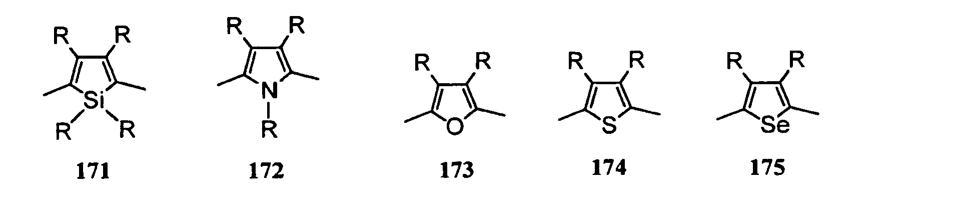

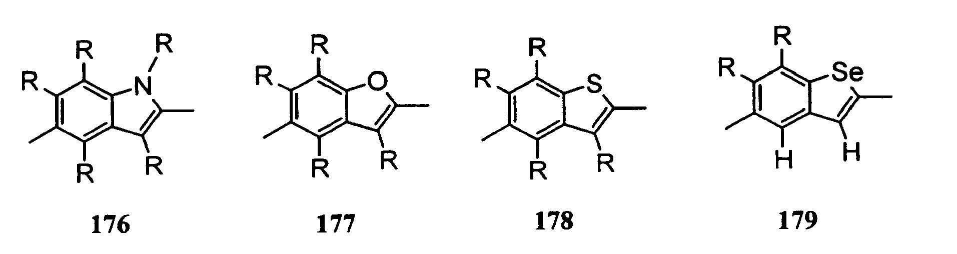

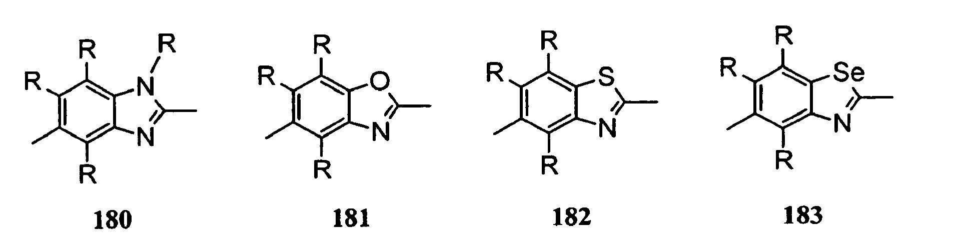

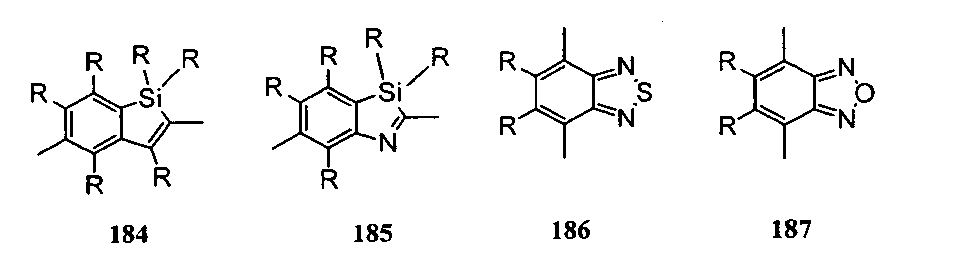

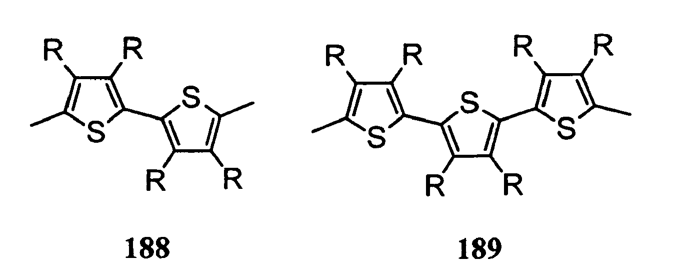

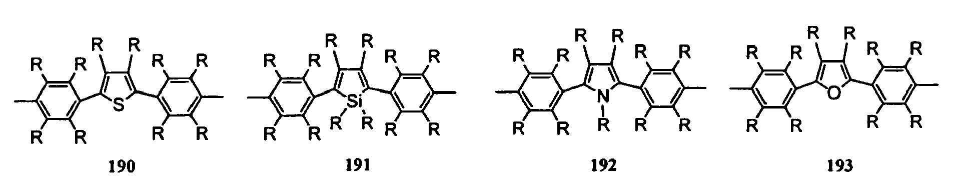

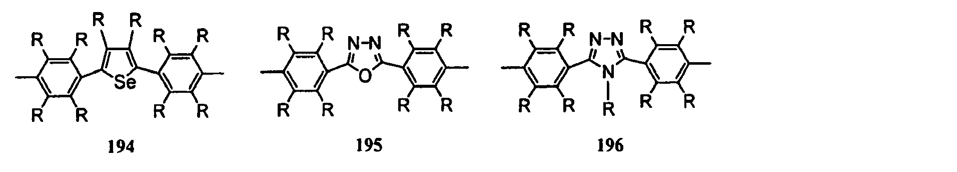

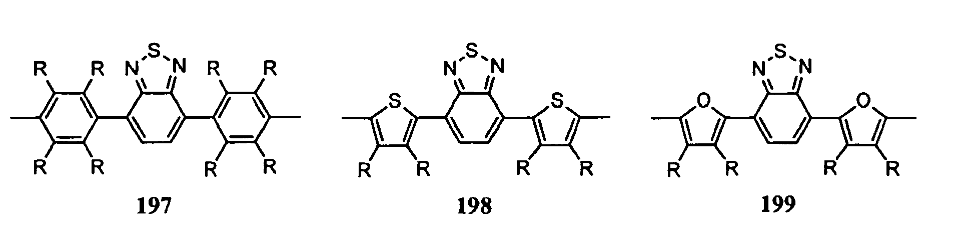

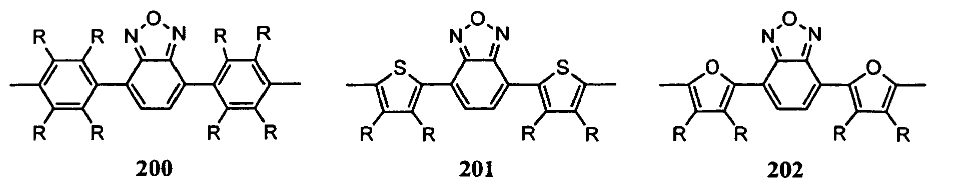

In the formulas 141 to 202, R represents a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group.

The definitions, the specific examples, and the like of such an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a substituted amino group, a substituted silyl group, a halogen atom, an acyl group, an acyloxy group, an imine residue, an amide group, an acid imide group, a monovalent heterocyclic group and a substituted carboxyl group, which may be selected as R in the groups represented by the general formulas 141 to 202, are the same as the definitions, the specific examples and the like of those groups described for R₅, R₆, R₇ and R₈ in the general formula (I).

Preferable among such repeating units represented by the general formula (II) from the viewpoint of luminance half-life of the light-emitting device obtained using the block copolymer of the present invention is a repeating unit represented by the following general formula (V):

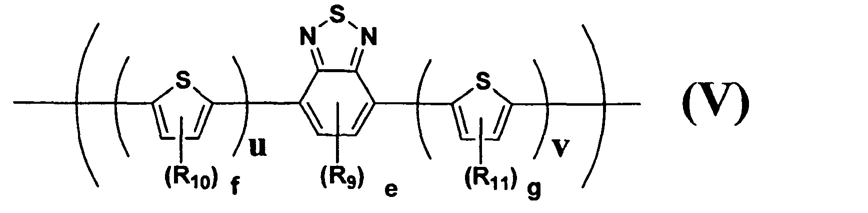

wherein in the formula (V), R₉, R₁₀ and R₁₁ may be the same or different and each represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, e, f and g may be the same or different and each represent an integer of 0 to 2, and u and v may be the same or different and each represent an integer of 0 to 2, provided that when a plurality of R₉, R₁₀ or R₁₁ are present, they may be the same or different.

The definitions, the specific examples, and the like of such an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a substituted amino group, a substituted silyl group, a halogen atom, an acyl group, an acyloxy group, an imine residue, an amide group, an acid imide group, a monovalent heterocyclic group and a substituted carboxyl group, which may be selected as R₉, R₁₀ and R₁₁ in the repeating unit represented by the general formula (V), are the same as the definitions, the specific examples and the like of those groups described for R₅, R₆, R₇ and R₈ in the general formula (I).

From the viewpoint of easy synthesis of the raw material monomer, e in the general formula (V) is preferably 0. Moreover, from the viewpoint of easy synthesis of the raw material monomer, f and g in the general formula (V) are each independently preferably 0 or 1.

Further, from the viewpoint of easy synthesis of the raw material monomer, R₉, R₁₀ and R₁₁ in the general formula (V) are each independently preferably an alkyl group, an alkoxy group, an alkylthio group, an aryl group, an aryloxy group or an arylthio group, more preferably an alkyl group, an alkoxy group or an aryl group, and still more preferably an alkyl group or an alkoxy group.

Specific examples of such a repeating unit represented by the general formula (V) include repeating units represented by the following general formulas (V-1) to (V-9).

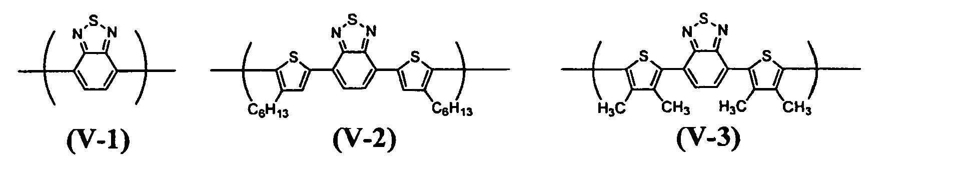

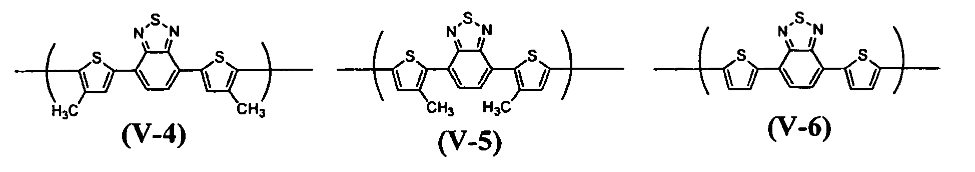

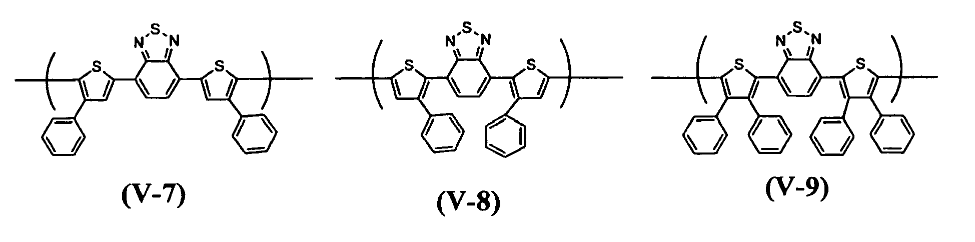

The block copolymer of the present invention preferably comprises the at least two repeating units represented by the general formula (V), from the viewpoint of luminous efficiency of the light-emitting device obtained using the block copolymer of the present invention. Specifically, the block copolymer of the present invention preferably comprises the at least two repeating units represented by the general formula (V) in which at least one of R₉, R₁₀, R₁₁, e, f, g, u and v in the general formula (V) varies. The block copolymer of the present invention more preferably comprises the at least two repeating units in which at least one of R₁₀ and R₁₁ varies, from the viewpoint of improvement of luminous efficiency of the light-emitting device obtained using the block copolymer.

The total content of the repeating unit represented by the general formula (V) (or the total content of the at least two repeating units represented by the general formula (V) when the copolymer comprises the at least two repeating units) is preferably 3 mol% or more and 40 mol% or less, and more preferably 5 mol% or more and 30 mol% or less based on the total repeating units contained in the block copolymer, from the viewpoint of life extension of the light-emitting device obtained using the block copolymer of the present invention. Such a content is based on the amount of the raw material monomers in production of the block copolymer. When the content is below the lower limit, luminous efficiency tends to be reduced. On the other hand, when the content is above the upper limit, the life of the resulting light-emitting device tends to be shorter.

The block (A) according to the present invention contains, together with the at least one repeating unit represented by the general formula (I) and the at least one repeating unit represented by the general formula (II) as described above, at least one repeating unit represented by the general formula (III):

-Ar₂- (III)

wherein Ar₂ represents an arylene group.

The arylene group in the general formula (III) refers to an atomic group derived from aromatic hydrocarbon by removal of two hydrogen atoms and includes those having a condensed ring and those comprising two or more independent benzene rings or condensed rings bonded directly or via a group such as vinylene. Moreover, such an arylene group may have a substituent. The type of such a substituent is not particularly limited. The substituent is preferably an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group from the viewpoint of solubility, fluorescence characteristics, easy synthesis, characteristics as the resulting device, and so on.

Moreover, such an arylene group has preferably 6 to 60 (more preferably 6 to 20) carbon atoms in the moiety exclusive of the substituent. Moreover, the arylene group has a total of preferably 6 to 100 carbon atoms inclusive of the substituent.

Moreover, examples of such an arylene group include phenylene groups (e.g., groups represented by the following general formulas 1 to 3), naphthalenediyl groups (groups represented by the following general formulas 4 to 13), anthracene-diyl groups (groups represented by the following general formulas 14 to 19), biphenyl-diyl groups (groups represented by the following general formulas 20 to 25), terphenyl-diyl groups (groups represented by the following general formulas 26 to 28), condensed-ring compound groups (groups represented by the following general formulas 29 to 35), fluorene-diyl groups (groups represented by the following general formulas 36 to 38) and benzofluorene-diyl (groups represented by the following general formulas 39 to 46):

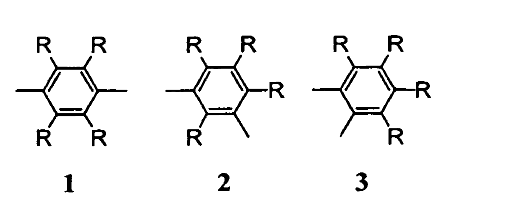

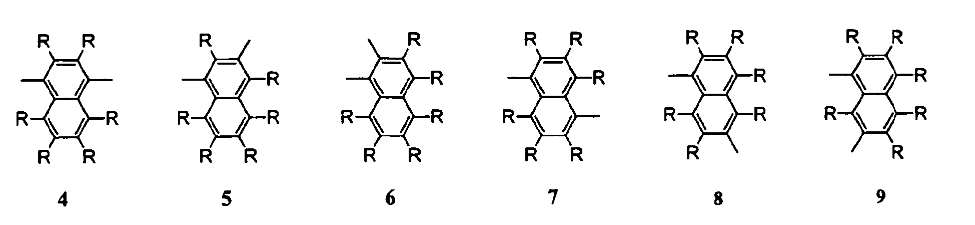

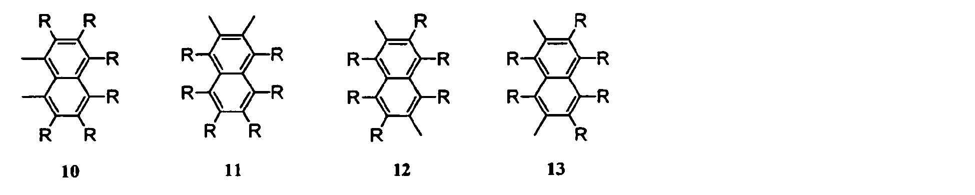

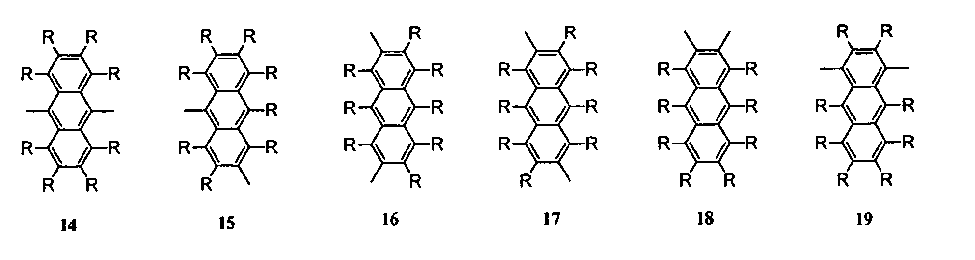

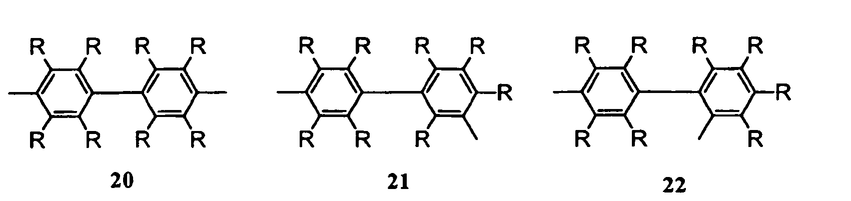

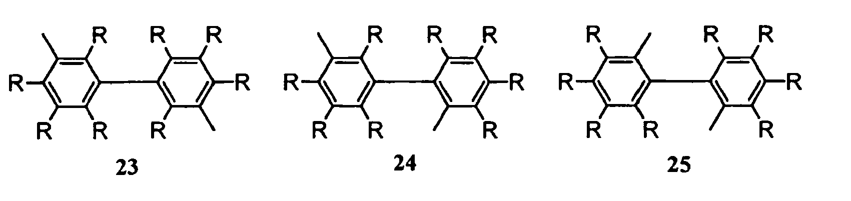

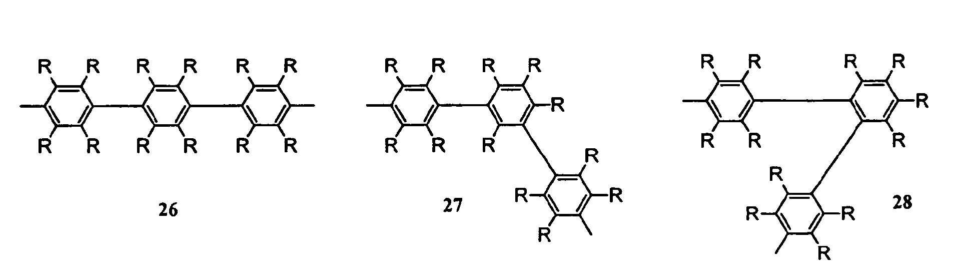

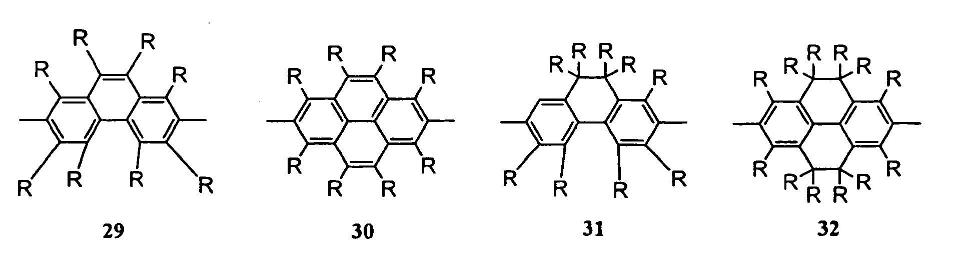

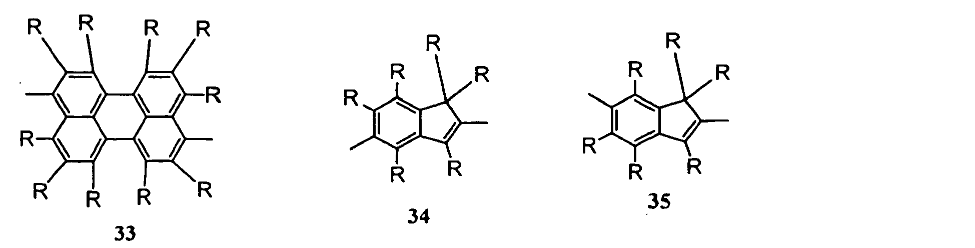

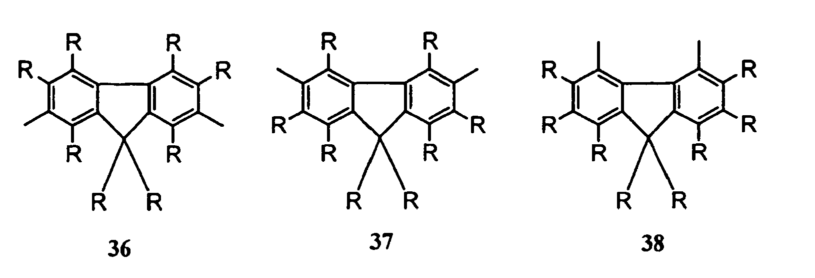

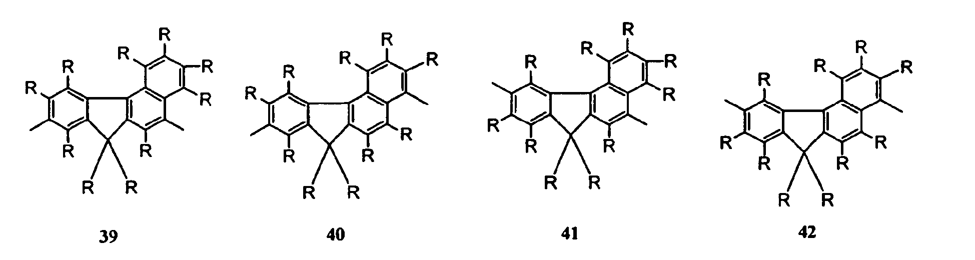

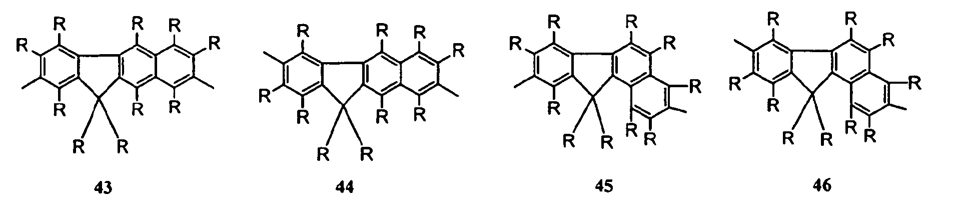

In the formulas 1 to 46, R represents a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group.
The definitions, the specific examples, and the like of such an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a substituted amino group, a substituted silyl group, a halogen atom, an acyl group, an acyloxy group, an imine residue, an amide group, an acid imide group, a monovalent heterocyclic group and a substituted carboxyl group, which may be selected as R in the arylene groups represented by the general formulas 1 to 46, are the same as the definitions, the specific examples and the like of those groups described for R₅, R₆, R₇ and R₈ in the general formula (I).

Preferable among such repeating units represented by the general formula (III) from the viewpoint of luminance half-life of the light-emitting device obtained using the block copolymer of the present invention is a repeating unit represented by the following general formula (VI):

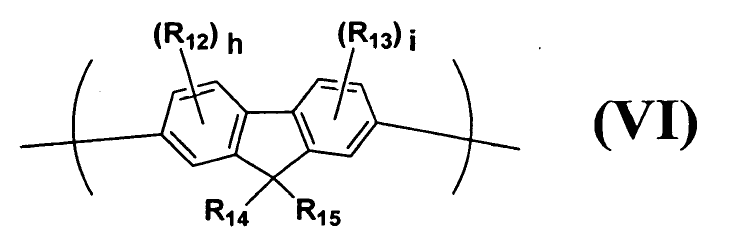

wherein in the formula (VI), R₁₂ and R₁₃ may be the same or different and each represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, h and i may be the same or different and each represent an integer of 0 to 3, and R₁₄ and R₁₅ may be the same or different and each represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, provided that when a plurality of R₁₂ or R₁₃ are present, they may be the same or different.

The definitions, the specific examples, and the like of such an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a substituted amino group, a substituted silyl group, a halogen atom, an acyl group, an acyloxy group, an imine residue, an amide group, an acid imide group, a monovalent heterocyclic group and a substituted carboxyl group, which may be selected as R₁₂, R₁₃, R₁₄ and R₁₅ in the repeating unit represented by the general formula (VI), are the same as the definitions, the specific examples and the like of those groups described for R₅, R₆, R₇ and R₈ in the general formula (I).

From the viewpoint of easy synthesis of the raw material monomer, h and i in the general formula (VI) are each preferably 0 or 1, and most preferably 0.

From the viewpoint of easy synthesis of the raw material monomer, R₁₄ and R₁₅ in the general formula (VI) are each preferably an alkyl group or an aryl group.

Specific examples of such a repeating unit represented by the general formula (VI) include repeating units represented by the following general formulas (VI-1) to (VI-8).

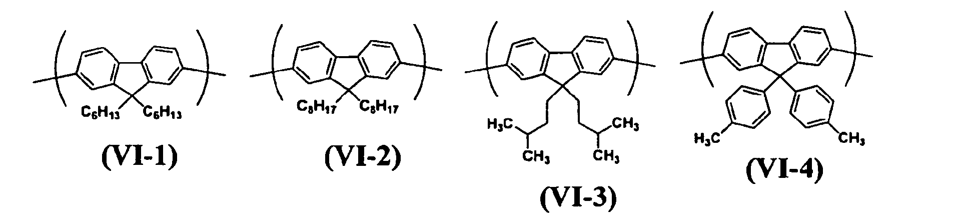

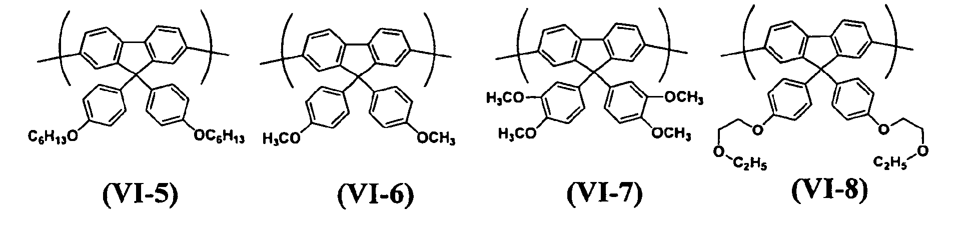

The block (A) according to the present invention can contain at least one repeating unit represented by the general formula (I), at least one repeating unit represented by the general formula (II) and at least one repeating unit represented by the general formula (III), and may also contain two or more such repeating units, respectively. The block (A) according to the present invention may contain at least one other repeating unit, in addition to the above repeating units.

Further, the block (A) according to the present invention preferably has a number average molecular weight based on polystyrene standards of 10³ to 10⁵ and a weight average molecular weight based on polystyrene standards of 10³ to 10⁵, from the viewpoint of life characteristics of the device obtained using the block copolymer of the present invention.

In the present invention, the "number average molecular weight" and the "weight average molecular weight" are determined as a number average molecular weight and a weight average molecular weight, respectively, based on polystyrene standards using size exclusion chromatography (SEC) (manufactured by Shimadzu Corp.; LC-10Avp). Moreover, a sample to be measured is dissolved at a concentration of approximately 0.5 wt% in tetrahydrofuran and injected in an amount of 50 pL in GPC. Furthermore, tetrahydrofuran is used as a GPC mobile phase at a flow rate of 0.6 mL/min. Moreover, two TSKgel SuperHM-H (manufactured by TOSOH CORP.) columns and one TSKgel SuperH2000 (manufactured by TOSOH CORP.) column are connected in series and used as a column. Moreover, a differential refractive index detector (manufactured by Shimadzu Corp.; RID-10A) is used as a detector.

The block (B) according to the present invention contains at least one repeating unit represented by the general formula (III) and at least one repeating unit represented by the following general formula (IV):

-Ar₃- (IV)

wherein Ar₃ represents a divalent aromatic amine.

Such a repeating unit represented by the general formula (III) which is contained in the block (B) is the same as the repeating unit represented by the general formula (III) in the block (A).

The divalent aromatic amine residue in the general formula (IV) refers to a remaining atomic group obtained by excluding two hydrogen atoms from an aromatic amine and may have a substituent. Such a divalent aromatic amine residue is not particularly limited, but preferably has 5 to 100 (more preferably 15 to 60) carbon atoms. The number of carbon atoms in such an aromatic amine residue does not include the number of carbon atoms in a substituent.

Specific examples of such a divalent aromatic amine residue include divalent aromatic amine residues represented by the following general formulas 401 to 410:

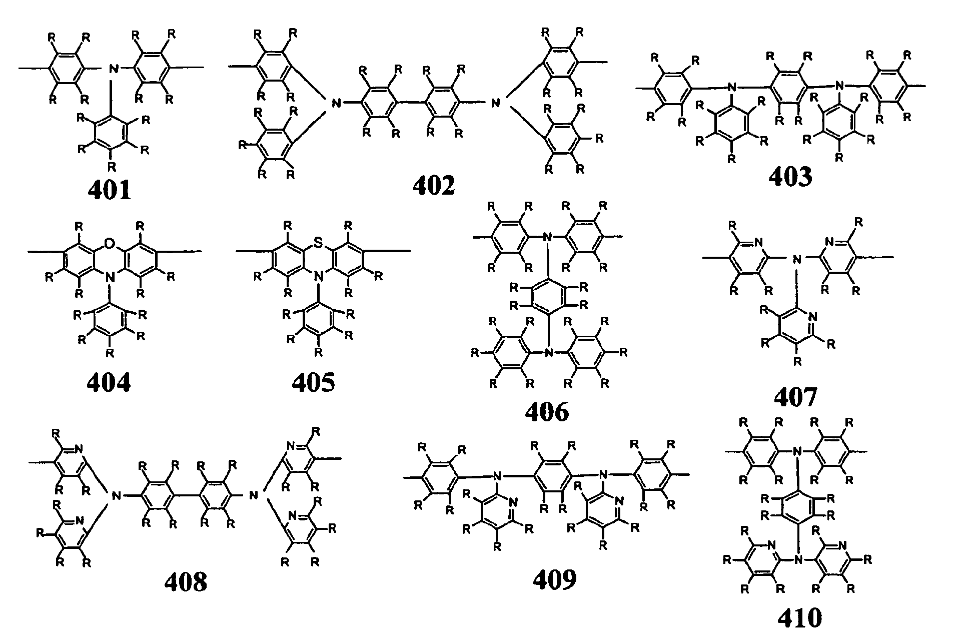

wherein in the formulas 401 to 410, R represents a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group.
The definitions, the specific examples, and the like of such an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a substituted amino group, a substituted silyl group, a halogen atom, an acyl group, an acyloxy group, an imine residue, an amide group, an acid imide group, a monovalent heterocyclic group and a substituted carboxyl group, which may be selected as R in the general formulas 401 to 410, are the same as the definitions, the specific examples and the like of those groups described for R₅, R₆, R₇ and R₈ in the general formula (I).

Preferable among such repeating units represented by the general formula (IV) from the viewpoint of production of the light-emitting device using the block copolymer of the present invention with a long half-life is a repeating unit represented by the following general formula (VII):

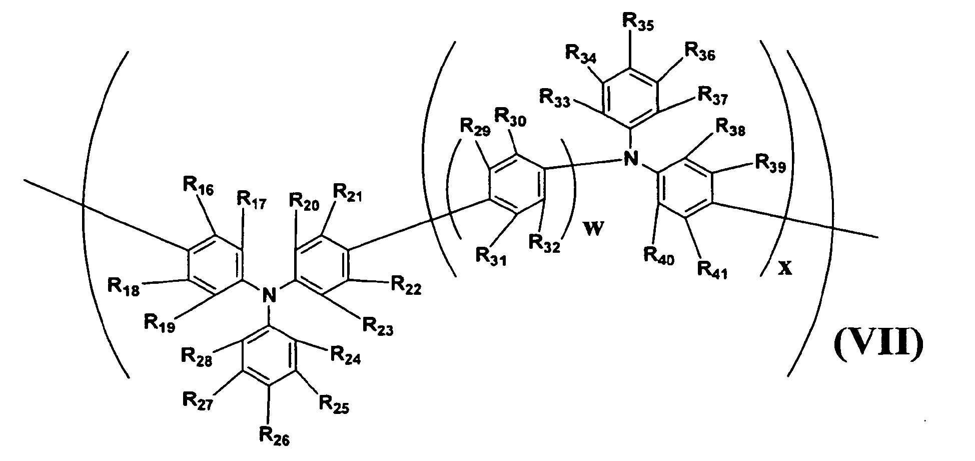

wherein R₁₆ to R₄₁ may be the same or different and each represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, and w and x may be the same or different and each represent an integer of 0 or 1,
provided that the carbon atom to which R₁₇ is bonded and the carbon atom to which R₂₀ is bonded, the carbon atom to which R₁₉ is bonded and the carbon atom to which R₂₈ is bonded, the carbon atom to which R₃₂ is bonded and the carbon atom to which R₄₀ is bonded, or the carbon atom to which R₃₇ is bonded and the carbon atom to which R₃₈ is bonded, may be directly bonded or bonded via an oxygen atom or a sulfur atom to each other to form a ring, respectively, and when such a ring is formed, R₁₇ and R₂₀, R₁₉ and R₂₈, R₃₂ and R₄₀, or R₃₇ and R₃₈, together represent the direct bond, the oxygen atom or the sulfur atom, and
R₂₂ and R₃₁, or R₂₁ and R₂₉, may be directly bonded to each other to form a ring which may have a substituent, respectively.

The definitions, the specific examples, and the like of such an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a substituted amino group, a substituted silyl group, a halogen atom, an acyl group, an acyloxy group, an imine residue, an amide group, an acid imide group, a monovalent heterocyclic group and a substituted carboxyl group, which may be selected as R₁₆ to R₄₁ in the general formula (VII), are the same as the definitions, the specific examples and the like of those groups described for R₅, R₆, R₇ and R₈ in the general formula (I).

Further, R₁₆ to R₄₁ in the general formula (VII) are each preferably a hydrogen atom, an alkyl group, an alkoxy group, an alkylthio group, an aryl group, an aryloxy group or an arylthio group, more preferably a hydrogen atom, an alkyl group, an alkoxy group, an aryl group or an aryloxy group, and still more preferably a hydrogen atom, an alkyl group or an alkoxy group, from the viewpoint of easy synthesis of the raw material monomer.

When R₂₂ and R₃₁, or R₂₁ and R₂₉, in the general formula (VII) are directly bonded to each other to form a ring which may have a substituent, respectively (for example, when the general formula (VII) represents a repeating unit represented by the following (VII-18) or (IV-19)), examples of the formed ring which may have a substituent include a C₄-C₁₀ cycloalkyl ring which may have a substituent, a C₄-C₁₀ cycloalkenyl ring which may have a substituent, a C₆-C₁₄ aromatic hydrocarbon ring which may have a substituent or a C₆-C₁₄ heterocycle which may have a substituent. Examples of the substituent which may be possessed by such a ring include groups which may be selected as R₄₈ in the general formula (VIII) described later.

Examples of such a cycloalkyl ring include cyclobutane, cyclopentane, cyclohexane, cycloheptane, cyclooctane, cyclononane and cyclodecane. Examples of the cycloalkenyl ring include a cycloalkenyl ring having two or more double bonds. Examples of such a cycloalkenyl ring include a cyclohexene ring, a cyclohexadiene ring and a cyclooctatriene ring. Examples of the aromatic hydrocarbon ring include a benzene ring, a naphthalene ring and an anthracene ring. Examples of the heterocycle include a furan ring, a tetrahydrofuran ring, a thiophene ring, a tetrahydrothiophene ring, an indole ring, a tetrahydroindole ring, an isoquinoline ring, a pyridine ring, a thiazole ring and an oxazole ring.

When R₂₂ and R₃₁, or R₂₁ and R₂₉, in the general formula (VII) are directly bonded to each other to form a ring which may have a substituent, respectively, the formed ring is preferably a cycloalkyl ring or an aromatic hydrocarbon ring, from the viewpoint of easy synthesis of the raw material monomer.

When the carbon atom to which R₁₇ is bonded and the carbon atom to which R₂₀ is bonded, or the carbon atom to which R₃₂ is bonded and the carbon atom to which R₄₀ is bonded, in the general formula (VII) are directly bonded or bonded via an oxygen atom or a sulfur atom to each other to form a ring, respectively (for example, when the general formula (VII) represents a repeating unit represented by the following general formula (VII-5), (VII-6) or(VII-9)), the carbon atoms are preferably bonded via an oxygen atom or a sulfur atom to each other to form a ring, from the viewpoint of easy synthesis of the raw material monomer.

Further, when the carbon atom to which R₁₉ is bonded and the carbon atom to which R₂₈ is bonded, or the carbon atom to which R₃₇ is bonded and the carbon atom to which R₃₈ is bonded, in the general formula (VII) are bonded to each other to form a ring (for example, when the general formula (VII) represents a repeating unit represented by the following general formula (VII-17)), the carbon atoms are preferably directly bonded to each other to form a ring, from the viewpoint of easy synthesis of the raw material monomer.

Specific examples of such a repeating unit represented by the general formula (VII) include repeating units represented by the following formulas (VII-1) to (VII-19).

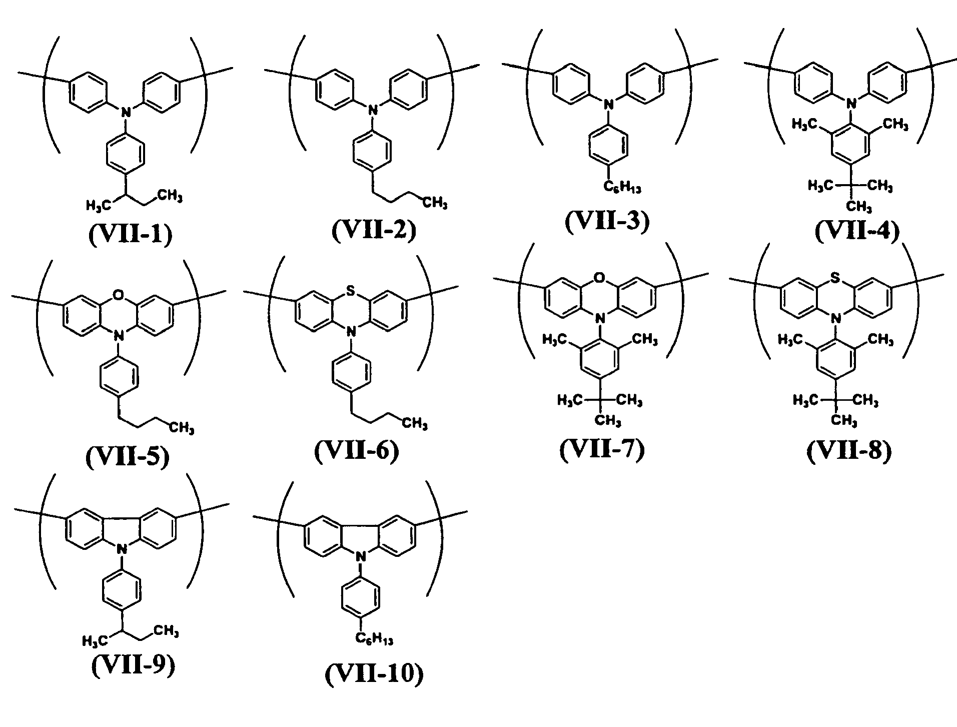

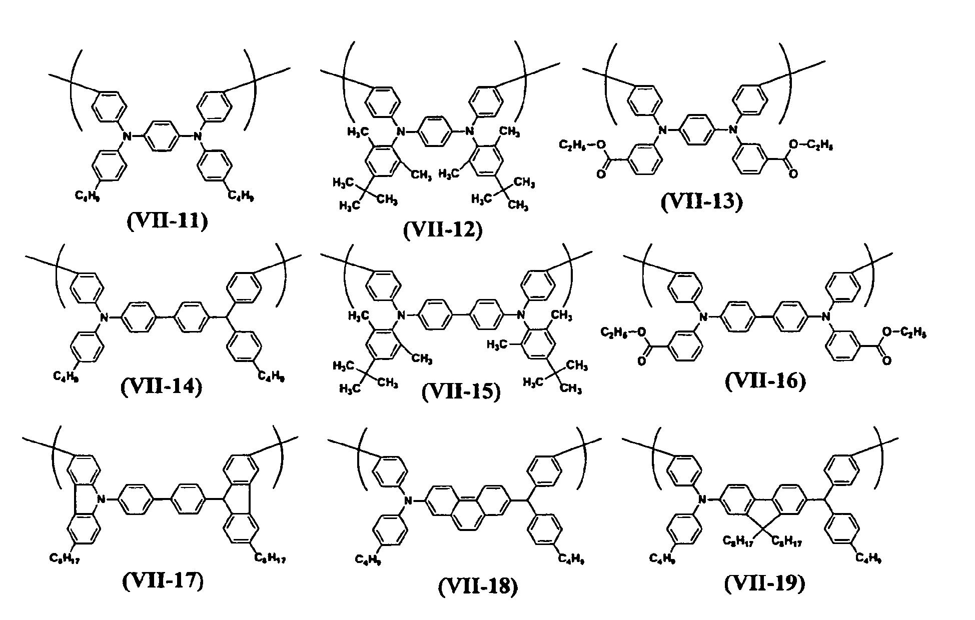

Further, in the block copolymer of the present invention, the group represented by the general formula (VII) is preferably at least one selected from the group consisting of a group in which x in the formula (VII) is 0 and a group represented by the following general formula (VIII). Such a group represented by the general formula (VII) is more preferably a group in which x in the formula (VII) is 0, from the viewpoint of increasing hole transport properties. On the other hand, such a group is more preferably a group represented by the following formula (VIII), from the viewpoint of allowing emission with higher luminance.

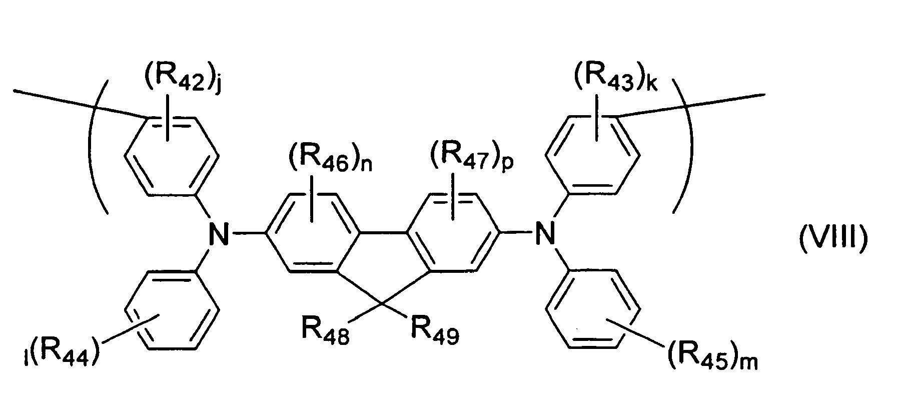

In the formula, R₄₂ to R₄₇ may be the same or different and each represent a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, an acyl group, an acyloxy group, an imine residue, an amide group, an acid imide group, a monovalent heterocyclic group, a carboxyl group, a substituted carboxyl group, a cyano group or a nitro group,
j and k may be the same or different and each represent an integer of 0 to 4,
l and m may be the same or different and each represent an integer of 0 to 5, and
n and p may be the same or different and each represent an integer of 0 to 3,
provided that when a plurality of at least one of groups among R₄₂, R₄₃, R₄₄, R₄₅, R₄₆ or R₄₇, they may be the same or different, and
R₄₈ and R₄₉ may be the same or different and each represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group.
The definitions, the specific examples, and the like of such an alkyl group, an alkoxy group, an alkylthio group, an aryl group, sn aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group and a substituted carboxyl group, which may be selected as R₄₂ to R₄₉ in the general formula (VIII), are the same as the definitions, the specific examples and the like of those groups described for R₅, R₆, R₇ and R₈ in the general formula (I).

The block (B) according to the present invention can contain at least one repeating unit represented by the general formula (III) and at least one repeating unit represented by the general formula (IV), and may also contain two or more such repeating units, respectively. The block (B) according to the present invention may further contain at least one other repeating unit, in addition to the above repeating units.

The block (A) and the block (B) preferably further contain at least one other repeating unit, in addition to the aforementioned repeating units represented by the general formulas (I) to (IV), from the viewpoint of changing charge transport properties and improving thermal resistance, for example. Such another repeating unit is preferably a repeating unit represented by the following general formula (C):

-Arₐ- (C)

wherein Arₐ represents an arylene group or a divalent heterocyclic group. The block may contain one repeating unit represented by the general formula (C) singly, or may contain two or more such repeating units.

Preferable among the repeating units represented by the general formula (C) is a repeating unit represented by the following formula (D), (E) or (F):

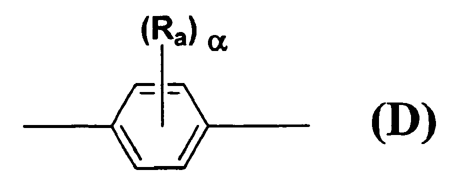

wherein Rₐ represents an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, and α represents an integer of 0 to 4, provided that when a plurality of Rₐ, they may be the same or different,

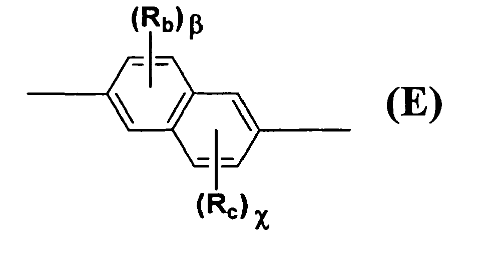

wherein R_{b} and R_{c} may be the same or different and each represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, and β and χ may be the same or different and each represent an integer of 0 to 3, provided that when a plurality of R_{b} or R_{c} are present, they may be the same or different, or

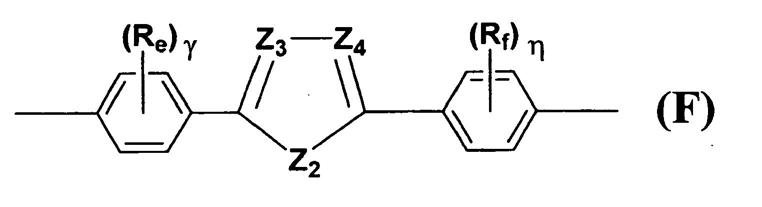

wherein Rₑ and R_{f} may be the same or different and each represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, γ and η may be the same or different and each represent an integer of 0 to 4, Z₂ represents O, S, SO₂, Se, Te, N-R_{g} or SiRₕRᵢ, Z₃ and Z₄ may be the same or different and each represent N or C-Rⱼ, and R_{g}, Rₕ, Rᵢ and Rⱼ may be the same or different and each represent a hydrogen atom, an alkyl group, an aryl group, an arylalkyl group or a monovalent heterocyclic group, provided that when a plurality of Rₑ or R_{f} are present, they may be the same or different.
Examples of the five-membered ring in the center of such a repeating unit represented by the general formula (F) include thiadiazole, oxadiazole, triazole, thiophene, furan and silole.

In the block copolymer of the present invention, the molar ratio of the block (A) to the block (B) ((A)/(B)) is preferably 0.1 to 10, and more preferably 0.3 to 3. When the content of the block (A) is below the lower limit or above the upper limit, the hole-electron balance tends to be impaired and luminous efficiency tends to be reduced.

The content of the repeating unit(s) represented by the general formula (I) (hereinafter sometimes referred to as "repeating unit(s) (I)") in the block copolymer of the present invention is preferably in the range of 0.02 to 30 mol% (more preferably 0.1 to 20 mol%) based on the amount of the raw material monomers in production of the block copolymer. When the content of the repeating unit(s) (I) in the block copolymer is below the lower limit, the luminance half-life of the resulting light-emitting device tends to be reduced if the block copolymer of the present invention is used as a material for a polymer light-emitting device. On the other hand, when the content is above the upper limit, the solubility of the block copolymer of the present invention in an organic solvent tends to be reduced.

The content of the repeating unit(s) represented by the general formula (II) (hereinafter sometimes referred to as "repeating unit(s) (II)") in the block copolymer of the present invention is preferably in the range of 0.1 to 60 mol% (more preferably 0.1 to 30 mol%) based on the amount of the raw material monomers in production of the block copolymer. When the content of the repeating unit(s) (II) is below the lower limit, only insufficient luminance tends to be achieved if the block copolymer of the present invention is used as a material for a polymer light-emitting device. On the other hand, when the content is above the upper limit, the solubility of the block copolymer of the present invention in an organic solvent tends to be reduced.

Further, the content of the repeating unit(s) represented by the general formula (III) (hereinafter sometimes referred to as "repeating unit(s) (III)") in the block copolymer of the present invention is preferably in the range of 10 to 90 mol% (more preferably 10 to 80 mol%) based on the amount of the raw material monomers in production of the block copolymer. When the content of the repeating unit(s) (III) is below the lower limit, the solubility of the block copolymer of the present invention in an organic solvent tends to be reduced. On the other hand, when the content is above the upper limit, emission characteristics and charge transport properties of the block copolymer of the present invention tend to be reduced.

The content of the repeating unit(s) represented by the general formula (IV) (hereinafter sometimes referred to as "repeating unit(s) (IV)") in the block copolymer of the present invention is preferably in the range of 0.1 to 60 mol% (more preferably 1 to 50 mol%) based on the amount of the raw material monomers in production of the block copolymer. When the content of the repeating unit(s) (IV) is below the lower limit, hole transport properties and luminous efficiency tend to be reduced if the block copolymer of the present invention is used as a material for a polymer light-emitting device. On the other hand, when the content is above the upper limit, the solubility of the block copolymer of the present invention in an organic solvent tends to be reduced.

The block copolymer of the present invention has a polystyrene equivalent number average molecular weight of preferably 10³ to 10⁸, more preferably 10³ to 10⁷, and still more preferably 10⁴ to 10⁷, from the viewpoint of life characteritstics of the device. The block copolymer of the present invention has a polystyrene equivalent weight average molecular weight of preferably 10³ to 10⁸, more preferably 10³ to 10⁷, and still more preferably 10⁴ to 10⁷, from the viewpoint of life characteritstics of the device.

The end group of the block copolymer of the present invention may be protected with a stable group. This is because emission characteristics and life of the light-emitting device produced may be reduced, when the substituent involved in condensation polymerization remains as is. The end group protected in this manner preferably has a conjugated bond continuous with the conjugated structure of the main chain. Examples of such a structure include a structure in which the end group is bonded to an aryl group or a heterocyclic group via a carbon-carbon bond. Examples of such a stable group protecting the end group include substituents such as a monovalent aromatic compound group represented by the structural formula of Formula 10 in JP-A-09-045478.

The block copolymer of the present invention may be contained in a solvent. Such a solvent is not particularly limited. Examples of the solvent include chloroform, methylene chloride, dichloroethane, tetrahydrofuran, toluene, xylene, mesitylene, tetralin, decalin and n-butylbenzene. Such a solvent can usually dissolve the block copolymer at 0.1 mass% or more, although the solubility varies according to the structure and the molecular weight of the block copolymer and cannot be generalized.

Next, preferred methods for producing the block copolymer of the present invention will be described.

Preferred methods for producing the block copolymer of the present invention include a method for producing the block copolymer comprising synthesizing the block (A) having a high molecular weight, and then adding a monomer forming the block (B) thereto and polymerizing them; and a method for producing the block copolymer comprising synthesizing the block (A) having a high molecular weight and the block (B) having a high molecular weight previously, and combining and polymerizing them. Known methods described in WO 2005/36666 and WO 2003/007395 may be used as such a method for producing the block copolymer, for example.

A specific example of the preferred method for producing the block copolymer of the present invention will be described below. First, a flask is charged with a monomer forming the block (A), a degassed solvent, a catalyst and a base, and the block (A) is polymerized. Then, the flask is charged with a monomer forming the block (B), a solvent, a catalyst and a base, and the block (B) is polymerized. In this manner, the block copolymer (polymer) has a structure with the block (A) and the block (B) each having a high molecular weight.

A more specific example of such a preferred method for producing the block copolymer of the present invention may be a method for producing the block copolymer comprising adding a monomer forming the block (A) having a high molecular weight to a compound appropriately selected as a raw material, which is represented by the following formula (X):

Y₁-A-Y₂ (X)

wherein -A- represents a repeating unit represented by the formula (I), (II), (III) or (IV), and Y₁ and Y₂ each independently represent a condensation polymerizable substituent, to synthesize the block (A), and then adding a monomer forming the block (B).

To make the block copolymer of the present invention have a repeating unit other than the repeating unit represented by -A- in the formula (X), a compound having two substituents involved in condensation polymerization which is a repeating unit other than the -A- can be present together with the compound represented by the formula (X) to carry out condensation polymerization.

Examples of the compound having two condensation polymerizable substituents which has a repeating unit other than the repeating unit represented by -A- in the formula (X) include a compound represented by the following formula (XI):

Y₃-Arₐ-Y₄ (XI)

wherein Arₐ is as described above, and Y₃ and Y₄ each independently represent a substituent involved in condensation polymerization. In this manner, the block copolymer of the present invention further having a repeating unit represented by -Arₐ- can be produced by condensation polymerization of the compound represented by Y₃-Arₐ-Y₄, in addition to the compound represented by Y₁-A-Y₂.

Moreover, examples of a compound having two substituents that participate in condensation polymerization, which corresponds to the additional repeating unit represented by the formula (E) other than the repeating units represented by the formulas (I), (II), (III) or (IV), include a compound represented by the following formula (H):

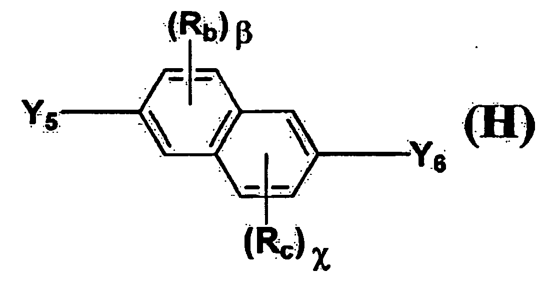

wherein R_{b}, R_{c}, β and χ are the same as those described in the formula (E); and Y₅ and Y₆ each independently represent the substituent that participates in condensation polymerization.
In the preferred method for producing such a block copolymer of the present invention, examples of the substituents (Y₁, Y₂, Y₃, Y₄, Y₅ and Y₆) that participate in condensation polymerization include a halogen atom, an alkylsulfonate group, an arylsulfonate group, an arylalkylsulfonate group, a borate group, a sulfonium methyl group, a phosphonium methyl group, a phosphonatomethyl group, a methyl monohalide group, - B(OH)₂, a formyl group, a cyano group and a vinyl group.

Examples of such a halogen atom that may be selected as a substituent that participates in condensation polymerization include fluorine, chlorine, bromine and iodine atoms.

Moreover, examples of the alkylsulfonate group that may be selected as a substituent that participates in condensation polymerization include methanesulfonate, ethanesulfonate and trifluoromethanesulfonate groups. Examples of the arylsulfonate that may be selected as such a substituent include benzenesulfonate and p-toluenesulfonate groups. Examples of the arylsulfonate group that may be selected as such a substituent include a benzylsulfonate group.

Furthermore, the borate group that may be selected as a substituent that participates in condensation polymerization is exemplified by a group represented by the following formula:

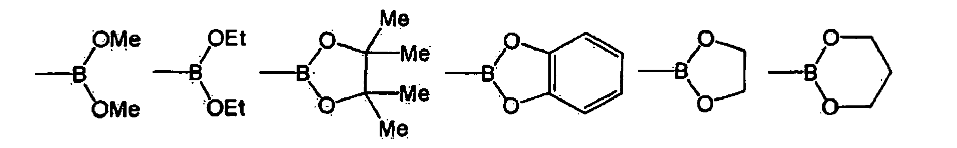

wherein Me represents a methyl group; and Et represents an ethyl group.

Moreover, the sulfonium methyl group that may be selected as a substituent that participates in condensation polymerization is exemplified by a group represented by the following formula:

-CH₂S⁺Me₂X⁻ or -CH₂S⁺Ph₂X⁻

wherein X represents a halogen atom; and Ph represents a phenyl group.

Moreover, the phosphonium methyl group that may be selected as a substituent that participates in condensation polymerization is exemplified by a group represented by the following formula:

-CH₂P⁺Ph₃X⁻

wherein X represents a halogen atom.

Furthermore, the phosphonatomethyl group that may be selected as a substituent that participates in condensation polymerization is exemplified by a group represented by the following formula:

-CH₂PO(OR')₂

wherein X represents a halogen atom; and R' represents an alkyl group, an aryl group or an arylalkyl group.

Moreover, the methyl monohalide group that may be selected as a substituent that participates in condensation polymerization is exemplified by methyl fluoride, methyl chloride, methyl bromide and methyl iodide groups.

Furthermore, substituents preferable as the substituents that participate in condensation polymerization differ depending on the type of a polymerization reaction. Examples thereof include a halogen atom, an alkylsulfonate group, an arylsulfonate group and an arylalkylsulfonate group for use of a zerovalent nickel (Ni(0)) complex, such as Yamamoto coupling reaction. Moreover, examples thereof include an alkylsulfonate group, a halogen atom, a borate group and -B(OH)₂ for use of a nickel or palladium catalyst, such as Suzuki coupling reaction.

In the preferred method for producing the block copolymer of the present invention, a polymerization method may be used in which a monomer compound having a plurality of substituents involved in condensation polymerization is dissolved in an organic solvent as necessary and reacted with an alkali and an appropriate catalyst at a temperature not less than the melting point of the organic solvent and not more than the boiling point of the organic solvent, for example. For example, methods known in the art such as methods described in, e.g., "Organic Reactions", vol. 14, p. 270-490, John Wiley & Sons, Inc., 1965, "Organic Syntheses", Collective Volume VI, p. 407-411, John Wiley & Sons, Inc., 1988, Chem. Rev., vol. 95, p. 2457 (1995), J. Organomet. Chem., vol. 576, p. 147 (1999), Macromol. Chem., Macromol. Symp., vol. 12, p. 229 (1987) can be adopted appropriately as such a polymerization method.

In such a preferred method for producing the block copolymer of the present invention, it is also possible to employ a known condensation reaction appropriately according to the substituent involved in condensation polymerization. Examples of such a polymerization method include a method comprising polymerizing the corresponding monomers through Suzuki coupling reaction, a method comprising polymerizing the corresponding monomers through Grignard reaction, a method comprising polymerizing the corresponding monomers using a Ni(0) complex, a method comprising polymerizing the corresponding monomers using an oxidizing agent such as FeCl₃, a method comprising electrochemically oxidation-polymerizing the corresponding monomers, and a method comprising decomposing an intermediate polymer having an appropriate leaving group. Among such polymerization methods, a method comprising polymerizing the monomers through Suzuki coupling reaction, a method comprising polymerizing the monomers through Grignard reaction, and a method comprising polymerizing the monomers using a Ni(O) complex are preferable because the structure of the obtained copolymer is easily controlled.

Moreover, in the preferred method for producing the block copolymer of the present invention, a method is preferably adopted which comprises each independently selecting the substituents (Y₁, Y₂, Y₃, Y₄, Y₅ and Y₆) that participate in condensation polymerization from a halogen atom, an alkylsulfonate group, an arylsulfonate group and an arylalkylsulfonate group and condensation-polymerizing the corresponding compounds in the presence of a Ni(O) complex. Accordingly, examples of the raw material compounds represented by the formula (X) and (XI) and the formula (H) include a dihalogenated compound, a bis(alkylsulfonate) compound, a bis(arylsulfonate) compound, a bis(arylalkylsulfonate) compound, a halogen-alkylsulfonate compound, a halogen-arylsulfonate compound, a halogen-arylalkylsulfonate compound, an alkylsulfonate-arylsulfonate compound, an alkylsulfonate-arylalkylsulfonate compound and an arylsulfonate-arylalkylsulfonate compound.

One example of a preferred method for producing the block copolymer of the present invention using such raw material compounds includes a method for producing a sequence-controlled block copolymer by using a halogen-alkylsulfonate compound, a halogen-arylsulfonate compound, a halogen-arylalkylsulfonate compound, an alkylsulfonate-arylsulfonate compound, an alkylsulfonate-arylalkylsulfonate compound or an arylsulfonate-arylalkylsulfonate compound.

Moreover, among the methods for producing the block copolymer as described above, a method is more preferably adopted which comprises each independently selecting the substituents (Y₁, Y₂, Y₃, Y₄, Y₅ and Y₆) that participate in condensation polymerization from a halogen atom, an alkylsulfonate group, an arylsulfonate group, an arylalkylsulfonate group, a boric acid group and a borate group and condensation-polymerizing the corresponding compounds using a nickel or palladium catalyst to produce the block copolymer, wherein the ratio of the total number of moles (K) of the boric acid group (-B(OH)₂) and the borate group contained in all the raw material compounds to the total number of moles (J) of the halogen atom, the alkylsulfonate group, the arylsulfonate group and the arylalkylsulfonate group contained therein is substantially 1 (preferably K/J ranges from 0.7 to 1.2).

Specific examples of combinations of the raw material compounds in such an adopted method for producing the block copolymer include combinations of a dihalogenated compound, a bis(alkylsulfonate) compound, a bis(arylsulfonate) compound or a bis(arylalkylsulfonate) compound with a diboric acid compound or a diborate compound.

Furthermore, examples of the raw material compounds include a halogen-boric acid compound, a halogen-borate compound, an alkylsulfonate-boric acid compound, an alkylsulfonate-borate compound, an arylsulfonate-boric acid compound, an arylsulfonate-borate compound, an arylalkylsulfonate-boric acid compound and an arylalkylsulfonate-borate compound.

One example of a method for producing the block copolymer of the present invention using such raw material compounds includes a method for producing a sequence-controlled block copolymer by using a halogen-boric acid compound, a halogen-borate compound, an alkylsulfonate-boric acid compound, an alkylsulfonate-borate compound, an arylsulfonate-boric acid compound, an arylsulfonate-borate compound, an arylalkylsulfonate-boric acid compound or an arylalkylsulfonate-borate compound.

Moreover, the organic solvent differs depending on the compounds used or the reaction used. In general, those sufficiently treated by deoxygenation for suppressing side reactions are preferably used.
For producing the block copolymer, it is preferred that the reaction should be allowed to proceed in an inert atmosphere using such an organic solvent. Moreover, it is preferred that the organic solvent should be treated by dehydration, as with the deoxygenation treatment. However, this shall not apply in a reaction in a two-phase system containing water, such as Suzuki coupling reaction.

Moreover, such an organic solvent is exemplified by: saturated hydrocarbons such as pentane, hexane, heptane, octane and cyclohexane; unsaturated hydrocarbons such as benzene, toluene, ethylbenzene and xylene; saturated halogenated hydrocarbons such as carbon tetrachloride, chloroform, dichloromethane, chlorobutane, bromobutane, chloropentane, bromopentane, chlorohexane, bromohexane, chlorocyclohexane and bromocyclohexane; unsaturated halogenated hydrocarbons such as chlorobenzene, dichlorobenzene and trichlorobenzene; alcohols such as methanol, ethanol, propanol, isopropanol, butanol and t-butyl alcohol; carboxylic acids such as formic acid, acetic acid and propionic acid; ethers such as dimethyl ether, diethyl ether, methyl-t-butyl ether, tetrahydrofuran, tetrahydropyran and dioxane; amines such as trimethylamine, triethylamine, N,N,N',N'-tetramethylethylenediamine and pyridine; and amides such as N,N-dimethylformamide, N,N-dimethylacetamide, N,N-diethylacetamide and N-methylmorpholine oxide. These organic solvents may be used alone or as a mixture of two or more thereof. Among such organic solvents, ethers are more preferable, and tetrahydrofuran and diethyl ether are even more preferable.

Moreover, for producing the block copolymer of the present invention, it is preferred that an alkali or an appropriate catalyst should be added appropriately for the reaction. Such an alkali or a catalyst needs only to be appropriately selected according to the polymerization method. It is preferred that such an alkali or a catalyst should be dissolved sufficiently in the solvent used in the reaction. Moreover, the method for mixing the alkali or the catalyst thereinto is exemplified by a method comprising gradually adding a solution of the alkali or the catalyst to the reaction solution with stirring in an inert atmosphere such as an argon or nitrogen atmosphere or, by contraries, gradually adding the reaction solution to a solution of the alkali or the catalyst under these conditions.

Such a block copolymer of the present invention can be used not only for a light-emitting material but also for a thin film, an organic semiconductor material, an organic transistor, an optical material, a solar cell, or a conductive material by doping. The block copolymer of the present invention can also be used for a polymer LED or the like. In this case, the monomers are preferably polymerized after purification using a method such as distillation, sublimation purification or recrystallization before polymerization, since the purity of the block copolymer affects performance of the device such as emission characteristics. It is preferable to carry out purification treatment such as reprecipitation purification or chromatographic fractionation after polymerization.

Examples of the thin film that can be produced using the block copolymer of the present invention include a light-emitting thin film, a conductive thin film and an organic semiconductor thin film. Such a conductive thin film preferably has a surface resistance of 1 KΩ/□ or less. Conductivity can be increased by doping the thin film with a Lewis acid, an ionic compound or the like. The surface resistance is more preferably 100 Ω/□ or less, and still more preferably 10 Ω/□ or less.

The organic semiconductor thin film preferably has either a high electron mobility or a high hole mobility, and has an electron mobility or a hole mobility of more preferably 10⁻⁵ cm²/V-sec or more, still more preferably 10⁻³ cm²/V-sec or more, and particularly preferably 10⁻¹ cm²/V-sec or more. Moreover, such an organic semiconductor thin film can be used to prepare an organic transistor. Specifically, the organic semiconductor thin film is formed on a Si substrate comprising an insulating film (e.g., a film of SiO₂) and a gate electrode formed thereon, and source and drain electrodes can be formed thereon using Au or the like to prepare an organic transistor.

The block copolymer of the present invention can be used as a material for a polymer field-effect transistor and particularly, can be used preferably as an active layer therein. For the structure of the polymer field-effect transistor, usually, it is only required that source and drain electrodes should be disposed in contact with the active layer comprising the polymer and a gate electrode should further be disposed such that an insulating layer is placed between the active layer and the gate electrode.

Such a polymer field-effect transistor is usually formed on a supporting substrate. A material for the supporting substrate is not particularly limited as long as it does not inhibit characteristics as a field-effect transistor. A glass, flexible film or plastic substrate can also be used. Moreover, such a polymer field-effect transistor can be produced by methods known in the art and can be produced according to, for example, a method described in JP-A-5-110069.

In formation of the active layer, it is highly advantageous and preferable to use an organic solvent-soluble block copolymer in terms of production. As a method of forming a film from a solution in which an organic solvent-soluble block copolymer is dissolved in a solvent, it is possible to use an application method such as spin coating, casting, microgravure coating, gravure coating, bar coating, roll coating, wire bar coating, dip coating, spray coating, screen printing, flexographic printing, offset printing or inkjet printing.

Moreover, a sealed polymer field-effect transistor is preferred which is obtained by preparing a polymer field-effect transistor and then sealing the transistor. This blocks the polymer field-effect transistor from atmosphere. Thus, reduction in the characteristics of the polymer field-effect transistor can be suppressed. Examples of the sealing method include: a method comprising covering the transistor with a UV-curable resin, a thermosetting resin, an inorganic SiONx film, or the like; and a method comprising gluing a glass plate or a film thereto using a UV-curable resin, a thermosetting resin, or the like. For effectively blocking the polymer field-effect transistor from atmosphere, it is preferred that steps from polymer field-effect transistor preparation to sealing should be performed without exposing the transistor to atmosphere (e.g., performed in a dried nitrogen atmosphere, in vacuum, or the like).

Moreover, a solar cell that can be produced using the block copolymer of the present invention will be described by taking, as an example, an organic photoelectric conversion device which is one aspect of an organic solar cell and is a solid photoelectric conversion device using photovoltaic effects.

The block copolymer of the present invention can be used as a material for the organic photoelectric conversion device and can be used particularly preferably as an organic semiconductor layer in a Schottky barrier-type device that utilizes the interface between an organic semiconductor and a metal and as an organic semiconductor layer in a p-n heterojunction-type device that utilizes the interface between organic and inorganic semiconductors or between organic semiconductors.

Furthermore, the first and second polymer compounds of the present invention can be used preferably as an electron-donating or electron-accepting polymer in a bulk heterojunction-type device having an increased area of donor-acceptor contact and as an electron-donating conjugated polymer (dispersed support) in an organic photoelectric conversion device that utilizes a polymer and low-molecular compound composite system, for example, a bulk heterojunction-type organic photoelectric conversion device comprising dispersed fullerene derivatives as electron acceptors.

For the structure of such an organic photoelectric conversion device, for example, a p-n heterojunction-type device, it is only required that a p-type semiconductor layer should be formed on an ohmic electrode (e.g., ITO) and an n-type semiconductor layer and subsequently an ohmic electrode should be stacked thereon.

Such an organic photoelectric conversion device is usually formed on a supporting substrate. A material for the supporting substrate is not particularly limited as long as it does not inhibit characteristics as an organic photoelectric conversion device. A glass, flexible film or plastic substrate can also be used.

Moreover, such an organic photoelectric conversion device can be produced by methods known in the art, for example, methods described in Synth. Met., 102, 982 (1999) and Science, 270, 1789 (1995).

The block copolymer of the present invention has been described above. The composition and the liquid composition of the present invention will be described below.

The composition of the present invention is characterized by comprising the block copolymer of the present invention and at least one material selected from the group consisting of a light-emitting material, a hole transport material and an electron transport material. The composition of the present invention may also contain the two or more block copolymers of the present invention.

Such a light-emitting material is not particularly limited, and light-emitting materials known in the art can be used appropriately. For example, naphthalene derivatives, anthracene and derivatives thereof, perylene and derivatives thereof, dyes (e.g., polymethine, xanthene, coumarin and cyanine), metal complexes of 8-hydroxyquinoline and derivatives thereof, aromatic amine, tetraphenylcyclopentadiene and derivatives thereof and tetraphenylbutadiene and derivatives thereof can be used. Moreover, as such a low-molecular-weight light-emitting layer material, materials known in the art, such as those described in JP-A-57-51781 and JP-A-59-194393, can be used.

Moreover, the hole transport material is not particularly limited, and hole transport materials known in the art can be used appropriately. Examples of such a hole transport material include polyvinylcarbazole and derivatives thereof, polysilane and derivatives thereof, polysiloxane derivatives having aromatic amine in the side chain or the main chain, pyrazoline derivatives, arylamine derivatives, stilbene derivatives, triphenyldiamine derivatives, polyaniline and derivatives thereof, polythiophene and derivatives thereof, polypyrrole and derivatives thereof, poly(p-phenylene vinylene) and derivatives thereof and poly(2,5-thienylene vinylene) and derivatives thereof.

Examples of the electron transport material include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, and polyfluorene and derivatives thereof.

When the composition of the present invention comprises at least one material selected from the group consisting of a light-emitting material, a hole transport material and an electron transport material, the content of the materials in the composition is preferably 1 wt% to 80 wt%, and more preferably 5 wt% to 60 wt%. When such a content of the materials is below the lower limit, the composition tends to fail to have sufficient emission characteristics and charge transport properties. On the other hand, when the content is above the upper limit, the composition tends to fail to sufficiently exhibit emission characteristics and charge transport properties of the block copolymer of the present invention.

The liquid composition of the present invention is characterized by comprising the block copolymer of the present invention and a solvent.
Here, the "liquid composition" means a composition which is liquid when the device is prepared, and typically means a composition which is liquid at normal pressure (that is, 1 atm) and 25°C. Such a liquid composition may generally be called an ink, an ink composition, a solution or the like. Such a liquid composition is useful for preparing a light-emitting device such as a polymer light-emitting device, or an organic transistor.

The ratio of the solvent in the liquid composition of the present invention is preferably 1 wt% to 99.9 wt%, more preferably 60 wt% to 99.9 wt%, even more preferably 90 wt% to 99.8 wt%, with respect to the total weight of the liquid composition. Moreover, the preferable viscosity of the liquid composition differs depending on a printing method adopted for producing a thin film or the like using this liquid composition. The viscosity is preferably in the range of 0.5 to 500 mPa·s at 25°C and is preferably in the range of 0.5 to 20 mPa·s at 25°C for preventing clogging or flight bending during discharge, for example, in an inkjet printing method which involves passing the liquid composition through a discharging apparatus.

Moreover, it is preferred that such a solvent should be capable of dissolving or discharging therein components other than the solvent in the liquid composition of the present invention. Such a solvent is exemplified by: chlorine solvents such as chloroform, methylene chloride, 1,2-dichloroethane, 1,1,2-trichloroethane, chlorobenzene and o-dichlorobenzene; ether solvents such as tetrahydrofuran and dioxane; aromatic hydrocarbon solvents such as toluene, xylene, trimethylbenzene and mesitylene; aliphatic hydrocarbon solvents such as cyclohexane, methylcyclohexane, n-pentane, n-hexane, n-heptane, n-octane, n-nonane and n-decane; ketone solvents such as acetone, methyl ethyl ketone and cyclohexanone; ester solvents such as ethyl acetate, butyl acetate, methyl benzoate and ethyl cellosolve acetate; polyhydric alcohols and derivatives thereof such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin and 1,2-hexanediol; alcoholic solvents such as methanol, ethanol, propanol, isopropanol and cyclohexanol; sulfoxide solvents such as dimethyl sulfoxide; and amide solvents such as N-methyl-2-pyrrolidone and N,N-dimethylformamide. Moreover, these solvents may be used alone or in combination of two or more thereof. It is preferred from the viewpoint of viscosity, film formation properties, and so on that, of the solvents, one or more organic solvents that have a structure containing at least one or more benzene rings and have a melting point of 0°C or lower and a boiling point of 100°C or higher should be contained in the liquid composition.

Moreover, the type of the solvent is preferably aromatic hydrocarbon solvents, aliphatic hydrocarbon solvents, ester solvents and ketone solvents and is preferably toluene, xylene, ethylbenzene, diethylbenzene, trimethylbenzene, mesitylene, n-propylbenzene, isopropylbenzene, n-butylbenzene, isobutylbenzene, s-butylbenzene, anisole, ethoxybenzene, 1-methylnaphthalene, cyclohexane, cyclohexanone, cyclohexylbenzene, bicyclohexyl, cyclohexenylcyclohexanone, n-heptylcyclohexane, n-hexylcyclohexane, methyl benzoate, 2-propylcyclohexanone, 2-heptanone, 3-heptanone, 4-heptanone, 2-octanone, 2-nonanone, 2-decanone and dicyclohexyl ketone, from the viewpoint of the solubility, in the organic solvent, of components other than the solvent in the liquid composition, uniform film formation, viscosity characteristics, and so on. It is more preferred that at least one of xylene, anisole, mesitylene, cyclohexylbenzene, bicyclohexyl and methyl benzoate should be contained therein.

Furthermore, the liquid composition of the present invention contains more preferably two or more, even more preferably two to three, particularly preferably two solvents, from the viewpoint of film formation properties, device characteristics, and so on.

When the liquid composition of the present invention contains two solvents, one of the solvents may be in a solid state at 25°C. Moreover, it is preferred from the viewpoint of film formation properties that one of the solvents should have a boiling point of 180°C or higher and the other solvent should have a boiling point lower than 180°C. It is more preferred that one of the solvents should have a boiling point of 200°C or higher and the other solvent should have a boiling point lower than 180°C. Furthermore, it is preferred from the viewpoint of viscosity that 0.2 wt% or more of components other than the solvents in the liquid composition should be dissolved in the solvents at 60°C and in one of the solvents at 25°C.

Moreover, when the liquid composition of the present invention contains three solvents, one or two of these three solvents may be in a solid state at 25°C. It is preferred from the viewpoint of film formation properties that at least one of the three solvents should have a boiling point of 180°C or higher and at least one of the remaining solvents should have a boiling point lower than 180°C. It is more preferred that at least one of the three solvents should have a boiling point of between 200°C and 300°C inclusive and at least one of the remaining solvents should have a boiling point lower than 180°C. Moreover, it is preferred from the viewpoint of viscosity that 0.2 mass% or more of components other than the solvents in the liquid composition should be dissolved in two of the three solvents at 60°C and in one of the three solvents at 25°C.

Furthermore, when the liquid composition of the present invention contains two or more solvents, the solvent having the highest boiling point occupies preferably 40 to 90 wt%, more preferably 50 to 90 wt%, even more preferably 65 to 85 wt% of the total weight of the solvents contained in the liquid composition from the viewpoint of viscosity and film formation properties. When the content of such a solvent having the highest boiling point is less than the lower limit, the resulting liquid composition tends to have low viscosity, resulting in difficulty in producing a film at the optimum film thickness using this composition. On the other hand, when the content exceeds the upper limit, the resulting liquid composition tends to have high viscosity, resulting in difficulty in producing a uniform film using this composition.

Moreover, the liquid composition of the present invention may contain, in addition to the block copolymer of the present invention and the solvent, a light-emitting material, a hole transport material, an electron transport material, a stabilizer, an additive for adjusting viscosity and/or surface tension, and an antioxidant. Each of these optional components may be used alone or in combination of two or more thereof.

Examples of the fluorescent material that may be contained in the liquid composition of the present invention include naphthalene derivatives, anthracene, anthracene derivatives, perylene, perylene derivatives, polymethine dyes, xanthene dyes, coumarin dyes, cyanine dyes, metal complexes having a metal complex of 8-hydroxyquinoline as a ligand, metal complexes having a metal complex of an 8-hydroxyquinoline derivative as a ligand, other fluorescent metal complexes, aromatic amine, tetraphenylcyclopentadiene, tetraphenylcyclopentadiene derivatives, tetraphenylcyclobutadiene, tetraphenylcyclobutadiene derivatives and fluorescent materials of low-molecular compounds (e.g., stilbene compounds, silicon-containing aromatic compounds, oxazole compounds, furoxan compounds, thiazole compounds, tetraarylmethane compounds, thiadiazole compounds, pyrazole compounds, metacyclophane compounds and acetylene compounds). Moreover, examples of such a fluorescent material include materials known in the art such as those described in JP-A-57-51781 and JP-A-59-194393.

Moreover, the hole transport material and the electron transport material that may be contained in the liquid composition of the present invention is the same as those described in the composition of the present invention.

Furthermore, the stabilizer that may be contained in the liquid composition of the present invention is not particularly limited. Examples of the stabilizer include phenol antioxidants and phosphorus antioxidants.

The additive for adjusting viscosity and/or surface tension that may be contained in the liquid composition of the present invention is not particularly limited. For example, high-molecular-weight compounds for increasing viscosity (thickeners), poor solvents, low-molecular-weight compounds for decreasing viscosity and surfactants for decreasing surface tension may be combined appropriately and used. Moreover, such high-molecular-weight compounds (thickeners) may be those which do not inhibit light emission or charge transport. It is preferred that these compounds should be soluble in the solvent in the liquid composition of the present invention. Examples of such a high-molecular-weight compound include high-molecular-weight polystyrene and high-molecular-weight polymethyl methacrylate. Furthermore, such a high-molecular-weight compound should have a polystyrene equivalent weight average molecular weight of preferably 500,000 or higher, more preferably 1,000,000 or higher. Moreover, the poor solvents can also be used as thickeners.

The antioxidant that may be contained in the liquid composition of the present invention may be that which does not inhibit light emission or charge transport. It is preferred that the antioxidant should contained in the solvent in the liquid composition. Such an antioxidant is exemplified by phenol antioxidants and phosphorus antioxidants. Moreover, the use of such an antioxidant tends to improve the storage stability of the block copolymer or the solvent.

Moreover, when the liquid composition of the present invention contains a hole transport material, the ratio of the hole transport material in the liquid composition is preferably 1 wt% to 80 wt%, more preferably 5 wt% to 60 wt%. Furthermore, when the liquid composition of the present invention contains an electron transport material, the ratio of the electron transport material in the liquid composition is preferably 1 wt% to 80 wt%, more preferably 5 wt% to 60 wt%. When the content of such a hole transport material and such an electron transport material is less than the lower limit, the material tends to fail to impart sufficient hole transport or electron transport ability to a film formed using the obtained liquid composition. On the other hand, when the content exceeds the upper limit, the composition tends to fail to exert emission characteristics and electron transport properties of the block copolymer of the present invention.

A polymer light-emitting device can be produced by forming a film from such a liquid composition of the present invention. In production of such a polymer light-emitting device, it is sufficient if the liquid composition of the present invention is applied and then the solvent is removed by drying. The same technique can be applied if the liquid composition is mixed with a charge transport material or a light-emitting material. Accordingly, the liquid composition of the present invention is highly advantageous for production of a polymer light-emitting device or the like. Drying may be carried out in a state heated to about 50 to 150°C, or at a pressure reduced to about 10⁻³ Pa.

As a method of forming a film using the liquid composition of the present invention, it is possible to employ an application method such as spin coating, casting, microgravure coating, gravure coating, bar coating, roll coating, wire bar coating, dip coating, slit coating, capillary coating, spray coating, screen printing, flexographic printing, offset printing, inkjet printing or nozzle coating.

The composition and the liquid composition of the present invention have been described above. The light-emitting thin film of the present invention will be described below.

The light-emitting thin film of the present invention is characterized by comprising the block copolymer of the present invention. Such a light-emitting thin film can be suitably produced by forming a film from the liquid composition of the present invention. Such a film formation method is not particularly limited, and it is possible to use an application method such as spin coating, casting, microgravure coating, gravure coating, bar coating, roll coating, wire bar coating, dip coating, slit coating, capillary coating, spray coating, screen printing, flexographic printing, offset printing, inkjet printing or nozzle coating.

The light-emitting thin film of the present invention has an emission quantum yield of preferably 50% or more, more preferably 60% or more, and still more preferably 70% or more, from the viewpoint of luminance and emission voltage of the device. When such a quantum yield is below the lower limit, the thin film tends to fail to exhibit sufficient luminance.

The light-emitting thin film of the present invention has been described above. The polymer light-emitting device of the present invention will be described below.

The polymer light-emitting device of the present invention is characterized by comprising, between electrodes consisting of an anode and a cathode, an organic layer containing the block copolymer of the present invention. Examples of such an organic layer include a light-emitting layer, an electron transport layer and a hole transport layer.
In such a polymer light-emitting device, the organic layer is more preferably a light-emitting layer.

Examples of the polymer light-emitting device of the present invention include (1) a polymer light-emitting device having an electron transport layer between a cathode and a light-emitting layer, (2) a polymer light-emitting device having a hole transport layer between an anode and a light-emitting layer and (3) a polymer light-emitting device having an electron transport layer between a cathode and a light-emitting layer and having a hole transport layer between an anode and the light-emitting layer.

Examples of such a polymer device include the following structures a) to d).
a) Anode/light-emitting layer/cathode
b) Anode/hole transport layer/light-emitting layer/cathode
c) Anode/light-emitting layer/electron transport layer/cathode
d) Anode/hole transport layer/light-emitting layer/electron transport layer/cathode (Here, "/" indicates that the respective layers are adjacently laminated; Hereinafter the same.)

Here, the light-emitting layer is a layer having a function of emitting light, the hole transport layer is a layer having a function of transporting holes, and the electron transport layer is a layer having a function of transporting electrons. The electron transport layer and the hole transport layer are generally called charge transport layers. The two or more light-emitting layers, the two or more hole transport layers and the two or more electron transport layers may be used each independently. The hole transport layer adjacent to the light-emitting layer may be called interlayer layer. The film formation method for such a light-emitting layer is not particularly limited. Examples of the method include a method of forming a film from the liquid composition of the present invention comprising a light-emitting material.

As a specific film formation method, it is possible to employ an application method such as spin coating, casting, microgravure coating, gravure coating, bar coating, roll coating, wire bar coating, dip coating, slit coating, capillary coating, spray coating, screen printing, flexographic printing, offset printing, inkjet printing or nozzle coating.

When the above method for forming a film from the liquid composition of the present invention is employed in preparation of the polymer light-emitting device, it is sufficient if the liquid composition is applied and then dried to remove the solvent. This tends to improve production efficiency and be advantageous in terms of production.

The optimal film thickness of the light-emitting layer varies according to the material used. The film thickness may be selected appropriately so that the driving voltage and luminous efficiency are adequate values, and is preferably 1 nm to 1 µm, more preferably 2 nm to 500 nm, and still more preferably 5 nm to 200 nm.

In the polymer light-emitting device of the present invention, the light-emitting layer may be mixed with a light-emitting material other than the block copolymer. In the polymer light-emitting device of the present invention, the light-emitting layer containing a light-emitting material other than the block copolymer may be laminated together with the light-emitting layer containing the block copolymer.

A known material can be used as a light-emitting material other than the block copolymer. Low-molecular compounds can be used, for example, naphthalene derivatives, anthracene and derivatives thereof, perylene and derivatives thereof, dyes such as polymethine dyes, xanthene dyes, coumarin dyes and cyanine dyes, metal complexes of 8-hydroxyquinoline and derivatives thereof, aromatic amines, tetraphenylcyclopentadiene and derivatives thereof, and tetraphenylbutadiene and derivatives thereof. Specifically, it is possible to use known materials such as those described in JP-A-57-051781 and JP-A-59-194393, for example.

When the polymer light-emitting device of the present invention has a hole transport layer, examples of the hole transport material used include polyvinylcarbazole and derivatives thereof, polysilane and derivatives thereof, polysiloxane derivatives having an aromatic amine in the side chain or main chain, pyrazoline derivatives, arylamine derivatives, stilbene derivatives, triphenyldiamine derivatives, polyaniline and derivatives thereof, polythiophene and derivatives thereof, polypyrrole and derivatives thereof, poly(p-phenylenevinylene) and derivatives thereof, and poly(2,5-thienylenevinylene) and derivatives thereof. Specific examples of the hole transport material include those described in JP-A-63-070257, JP-A-63-175860, JP-A-02-135359, JP-A-02-135361, JP-A-02-209988, JP-A-03-037992 and JP-A-03-152184.

Among them, the hole transport materials used in the hole transport layer are preferably polymer hole transport materials such as polyvinylcarbazole and derivatives thereof, polysilane and derivatives thereof, polysiloxane derivatives having an aromatic amine compound group in the side chain or main chain, polyaniline and derivatives thereof, polythiophene and derivatives thereof, poly(p-phenylenevinylene) and derivatives thereof, and poly(2,5-thienylenevinylene) and derivatives thereof, and more preferably polyvinylcarbazole and derivatives thereof, polysilane and derivatives thereof, and polysiloxane derivatives having an aromatic amine in the side chain or main chain. A low-molecular hole transport material is preferably dispersed in a polymer binder.

As such polyvinylcarbazole and derivatives thereof, those obtained from vinyl monomers by cationic polymerization or radical polymerization can be suitably used, for example.

Examples of the polysilane and derivatives thereof include compounds described in Chem. Rev., vol. 89, p. 1359 (1989) and GB 2300196. As a method for synthesizing such polysilane and derivatives thereof, the method described in the above documents can be used, and the Kipping method is particularly suitably used.

As the polysiloxane derivatives, those having a structure of the low-molecular hole transport material in the side chain or main chain are suitably used, since the siloxane backbone has almost no hole transport properties. Particularly preferred examples of such polysiloxane derivatives include those having an aromatic amine having hole transport properties in the side chain or main chain.

The film formation method for the hole transport layer is not particularly limited. Examples of the method using a low-molecular hole transport material include a method of forming a film from a mixed solution with a polymer binder. Examples of the method using a polymer hole transport material include a method of forming a film from a solution.

The solvent used for such film formation from a solution is not particularly limited insofar as it can dissolve a hole transport material. Examples of such a solvent include chlorine solvents such as chloroform, methylene chloride and dichloroethane, ether solvents such as tetrahydrofuran, aromatic hydrocarbon solvents such as toluene and xylene, ketone solvents such as acetone and methyl ethyl ketone, and ester solvents such as ethyl acetate, butyl acetate and ethyl cellosolve acetate.

As a film formation method from a solution, it is possible to use an application method such as spin coating, casting, microgravure coating, gravure coating, bar coating, roll coating, wire bar coating, dip coating, slit coating, capillary coating, spray coating, screen printing, flexographic printing, offset printing, inkjet printing or nozzle coating.

As such a polymer binder mixed in film formation, one which does not extremely inhibit charge transport is preferable, and one which does not show strong absorption of visible light is suitably used. Examples of such a polymer binder include polycarbonate, polyacrylate, polymethyl acrylate, polymethyl methacrylate, polystyrene, polyvinyl chloride and polysiloxane.

A film of the hole transport layer may be formed using the liquid composition of the present invention comprising a hole transport material. Use of the liquid composition of the present invention in this manner tends to improve production efficiency and be advantageous in terms of production, since it is sufficient if the liquid composition is applied and dried to remove the solvent.

The optimal film thickness of the hole transport layer varies according to the material used. The film thickness may be selected so that the driving voltage and luminous efficiency are adequate values, but must be at least a thickness not causing generation of pinholes. If the thickness is too large, the driving voltage of the device is increased, unfavorably. Accordingly, such a hole transport layer has a film thickness of, for example, 1 nm to 1 µm, preferably 2 nm to 500 nm, and more preferably 5 nm to 200 nm.

When the polymer light-emitting device of the present invention has an electron transport layer, a known electron transport material can be used. Examples of the material include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, and polyfluorene and derivatives thereof. Specific examples of the material include those described in JP-A-63-070257, JP-A-63-175860, JP-A-02-135359, JP-A-02-135361, JP-A-02-209988, JP-A-03-037992 and JP-A-03-152184.

Among them, oxadiazole derivatives, benzoquinone and derivatives thereof, anthraquinone and derivatives thereof, metal complexes of 8-hydroxyquinoline and derivatives thereof, polyquinoline and derivatives thereof, polyquinoxaline and derivatives thereof, and polyfluorene and derivatives thereof are preferable, and 2-(4-biphenylyl)-5-(4-t-butylphenyl)-1,3,4-oxadiazole, benzoquinone, anthraquinone, tris(8-quinolinol)aluminum and polyquinoline are more preferable.

The film formation method for the electron transport layer is not particularly limited. Examples of the method using a low-molecular electron transport material include vacuum deposition from powder; and film formation from a solution or molten state. Examples of the method using a polymer electron transport material include film formation from a solution or molten state. A polymer binder may be used in combination in film formation from a solution or molten state.

The solvent used for such film formation from a solution is not particularly limited insofar as it can dissolve an electron transport material and/or a polymer binder. Examples of such a solvent include chlorine solvents such as chloroform, methylene chloride and dichloroethane, ether solvents such as tetrahydrofuran, aromatic hydrocarbon solvents such as toluene and xylene, ketone solvents such as acetone and methyl ethyl ketone, and ester solvents such as ethyl acetate, butyl acetate and ethyl cellosolve acetate.

As a film formation method from a solution or molten state, it is possible to use an application method such as spin coating, casting, microgravure coating, gravure coating, bar coating, roll coating, wire bar coating, dip coating, slit coating, capillary coating, spray coating, screen printing, flexographic printing, offset printing, inkjet printing or nozzle coating.

As such a polymer binder mixed in film formation, one which does not extremely inhibit charge transport is preferable, and one which does not show strong absorption of visible light is suitably used. Examples of the polymer binder include poly(N-vinylcarbazole), polyaniline and derivatives thereof, polythiophene and derivatives thereof, poly(p-phenylenevinylene) and derivatives thereof, poly(2,5-thienylenevinylene) and derivatives thereof, polycarbonate, polyacrylate, polymethyl acrylate, polymethyl methacrylate, polystyrene, polyvinyl chloride and polysiloxane.

A film of the electron transport layer may be formed using the liquid composition of the present invention comprising an electron transport material. Use of the liquid composition of the present invention in this manner tends to improve production efficiency and be advantageous in terms of production, since it is sufficient if the liquid composition is applied and dried to remove the solvent.

The optimal film thickness of the electron transport layer varies according to the material used. The film thickness may be selected so that the driving voltage and luminous efficiency are adequate values, but must be at least a thickness not causing generation of pinholes. If the thickness is too large, the driving voltage of the device is increased, unfavorably. Accordingly, the electron transport layer has a film thickness of preferably 1 nm to 1 µm, more preferably 2 nm to 500 nm, and still more preferably 5 nm to 200 nm.

The charge transport layer provided adjacent to the electrode, which has a function of improving efficiency of charge injection from the electrode and reducing the driving voltage of the device, may be generally called charge injection layer (hole injection layer, electron injection layer).

In order to improve adhesion to the electrode and charge injection from the electrode, the charge injection layer or an insulating layer may be provided adjacent to the electrode. In order to improve adhesion of the interface and prevent mixing in the interface, for example, a thin buffer layer may be inserted into the interface of the charge transport layer or the light-emitting layer. The order and number of the layers laminated and the thickness of each layer may be selected appropriately taking luminous efficiency and device life into consideration.

Examples of the polymer light-emitting device of the present invention having a charge injection layer (electron injection layer, hole injection layer) include a polymer light-emitting device having a charge injection layer adjacent to the cathode, and a polymer light-emitting device having a charge injection layer adjacent to the anode.

Examples of such a polymer light-emitting device include the following structures e) to p).
e) Anode/charge injection layer/light-emitting layer/cathode
f) Anode/light-emitting layer/charge injection layer/cathode
g) Anode/charge injection layer/light-emitting layer/charge injection layer/cathode
h) Anode/charge injection layer/hole transport layer/light-emitting layer/cathode
i) Anode/hole transport layer/light-emitting layer/charge injection layer/cathode
j) Anode/charge injection layer/hole transport layer/light-emitting layer/charge injection layer/cathode
k) Anode/charge injection layer/light-emitting layer/charge transport layer/cathode
l) Anode/light-emitting layer/electron transport layer/charge injection layer/cathode
m) Anode/charge injection layer/light-emitting layer/electron transport layer/charge injection layer/cathode
n) Anode/charge injection layer/hole transport layer/light-emitting layer/charge transport layer/cathode
o) Anode/hole transport layer/light-emitting layer/electron transport layer/charge injection layer/cathode
p) Anode/charge injection layer/hole transport layer/light-emitting layer/electron transport layer/charge injection layer/cathode

Specific examples of the charge injection layer include a layer containing a conductive polymer; a layer provided between the anode and the hole transport layer and containing a material having an ionization potential intermediate between that of the anode material and that of the hole transport material contained in the hole transport layer; and a layer provided between the cathode and the electron transport layer and containing a material having an electron affinity intermediate between that of the cathode material and that of the electron transport material contained in the electron transport layer.

When the charge injection layer is a layer containing a conductive polymer, the conductive polymer has a conductivity of preferably 10⁻⁵ S/cm or more and 10³ S/cm or less, and is more preferably 10⁻⁵ S/cm or more and 10² S/cm or less, and still more preferably 10⁻⁵ S/cm or more and 10¹ S/cm or less in order to reduce the leak current between light-emitting pixels. In order that the conductive polymer has a conductivity of 10⁻⁵ S/cm or more and 10³ S/cm or less, the conductive polymer is usually doped with an appropriate amount of ions.

Such doping ions are anions for the hole injection layer and cations for the electron injection layer. Examples of the anions include polystyrenesulfonate ions, alkylbenzenesulfonate ions and camphorsulfonate ions. Examples of the cations include lithium ions, sodium ions, potassium ions and tetrabutylammonium ions.

The charge injection layer has a film thickness of, for example, 1 nm to 100 nm, and preferably 2 nm to 50 nm.

The material used for the charge injection layer is not particularly limited and may be selected appropriately according to the material for the electrode or the adjacent layer. Examples of the material include conductive polymers such as polyaniline and derivatives thereof, polythiophene and derivatives thereof, polypyrrole and derivatives thereof, polyphenylenevinylene and derivatives thereof, polythienylenevinylene and derivatives thereof, polyquinoline and derivatives thereof, polyquinoxaline and derivatives thereof, and polymers containing an aromatic amine structure in the main chain or side chain, metal phthalocyanine (such as copper phthalocyanine) and carbon.

The insulating layer has a function of making charge injection easier. The insulating layer has an average thickness of preferably 0.1 to 20 nm, more preferably 0.5 to 10 nm, and still more preferably 1 to 5 nm. Examples of the material for such an insulating layer include metal fluorides, metal oxides and organic insulating materials. Examples of the polymer light-emitting device having an insulating layer include a polymer light-emitting device having an insulating layer adjacent to the cathode, and a polymer light-emitting device having an insulating layer adjacent to the anode.

Examples of such a polymer light-emitting device include the following structures q) to ab).
q) Anode/insulating layer/light-emitting layer/cathode
r) Anode/light-emitting layer/insulating layer/cathode
s) Anode/insulating layer/light-emitting layer/insulating layer/cathode
t) Anode/insulating layer/hole transport layer/light-emitting layer/cathode
u) Anode/hole transport layer/light-emitting layer/insulating layer/cathode
v) Anode/insulating layer/hole transport layer/light-emitting layer/insulating layer/cathode
w) Anode/insulating layer/light-emitting layer/electron transport layer/cathode
x) Anode/light-emitting layer/electron transport layer/insulating layer/cathode
y) Anode/insulating layer/light-emitting layer/electron transport layer/insulating layer/cathode
z) Anode/insulating layer/hole transport layer/light-emitting layer/electron transport layer/cathode aa) Anode/hole transport layer/light-emitting layer/electron transport layer/insulating layer/cathode ab) Anode/insulating layer/hole transport layer/light-emitting layer/electron transport layer/insulating layer/cathode

Any substrate forming the polymer light-emitting device of the present invention may be used insofar as it forms an electrode and is not changed in forming an organic substance layer. Examples of the substrate include glass, plastic, polymer film and silicon substrates. When the substrate is non-transparent, the opposite electrode is preferably transparent or semi-transparent.

In the polymer light-emitting device of the present invention, at least one of the electrodes composed of the anode and the cathode is preferably transparent or semi-transparent, and the anode is more preferably transparent or semi-transparent.

A conductive metal oxide film, a semi-transparent metal thin film or the like is used as a material for such an anode. Examples of the material for such an anode include indium oxide, zinc oxide, tin oxide and indium tin oxide (ITO) which is their complex; a film prepared using conductive glass composed of indium tin oxide or the like (such as NESA); gold, platinum, silver and copper. ITO, indium zinc oxide and tin oxide are preferable. The method for preparing such an anode is not particularly limited and a known method may be appropriately used. Examples of the method include vacuum deposition, sputtering, ion plating and plating. An organic transparent conductive film of polyaniline or a derivative thereof, polythiophene or a derivative thereof, or the like may be used as such an anode.

The film thickness of such an anode can be selected appropriately in consideration of optical transparency and conductivity. The anode has a film thickness of preferably 10 nm to 10 µm, more preferably 20 nm to 1 µm, even more preferably 50 nm to 500 nm.

Moreover, a layer comprising a phthalocyanine derivative, a conductive polymer, carbon, or the like or a layer comprising a metal oxide, a metal fluoride, an organic insulating material, or the like may be disposed on the anode for facilitating charge injection.

Moreover, materials having a small work function are preferable as materials for the cathode. Examples of such materials for the cathode include: metals such as lithium, sodium, potassium, rubidium, cesium, beryllium, magnesium, calcium, strontium, barium, aluminum, scandium, vanadium, zinc, yttrium, indium, cerium, samarium, europium, terbium and ytterbium, and alloys of two ore more thereof or alloys of one or more thereof with one or more of gold, silver, platinum, copper, manganese, titanium, cobalt, nickel, tungsten and tin; and graphite or intercalated graphite. Moreover, examples of the alloys include magnesium-silver, magnesium-indium, magnesium-aluminum, indium-silver, lithium-aluminum, lithium-magnesium, lithium-indium and calcium-aluminum alloys. The cathode may have a double- or more layered structure.

Furthermore, the film thickness of such a cathode can be selected appropriately in consideration of conductivity and durability. The cathode has a film thickness of preferably 10 nm to 10 µm, more preferably 20 nm to 1 µm, even more preferably 50 nm to 500 nm.

As a method for preparing such a cathode, vacuum deposition, sputtering, lamination in which a metal thin film is subjected to thermocompression bonding, or the like is used. It is also possible to provide, between the cathode and the organic substance layer, a layer composed of a conductive polymer, or a layer composed of a metal oxide, a metal fluoride, an organic insulating material or the like. After preparation of the cathode, a protecting layer to protect the resulting polymer light-emitting device may be further mounted. In order to use the polymer light-emitting device of the present invention stably for a long time, a protecting layer and/or a protecting cover are preferably mounted to protect the device from outside.

As such a protecting layer, it is possible to use a resin, a metal oxide, a metal fluoride, a metal boride or the like. As a protecting cover, it is possible to use a glass plate, a plastic plate whose surface is subjected to low water permeability treatment, or the like. In mounting such a protecting cover, a method is suitably used in which the device substrate and the protecting cover are adhered to each other by a thermosetting resin or a photocurable resin to carry out sealing. When a space is maintained by a spacer, the device can be easily prevented from being damaged. When the space formed by such a spacer is filled with an inert gas such as nitrogen or argon, the cathode can be prevented from being oxidized. Further, when a drying agent such as barium oxide is placed in the space, it is easy to suppress damage to the device by the moisture adsorbed during the production process. Any one or more among these measures are preferably carried out.

Moreover, the polymer light-emitting device of the present invention can be used in planar light sources, display devices (e.g., segment display devices, dot matrix display devices and liquid-crystal display devices (e.g., backlights)), and so on.

Furthermore, for obtaining planar light emission using the polymer light-emitting device of the present invention, it is only required that planar anode and cathode should be arranged such that they overlap with each other. Moreover, for obtaining patterned light emission, methods are used which include: a method comprising placing a mask provided with a window with the pattern on the surface of the planar light-emitting device; a method comprising forming an extremely thick organic layer of a non-light-emitting portion such that the portion becomes substantially non-light-emitting; and a method comprising forming the pattern on either or both of the anode and the cathode. The pattern is formed by any of these methods, and some electrodes are arranged such that they can independently be switched between the ON and OFF positions. As a result, a segment-type display device is obtained which can display numbers, letters, simple symbols, and so on. Furthermore, for preparing a dot matrix device, it is only required that both the anode and cathode should be formed in a striped form and arranged orthogonally. Partial color display or multicolor display is achieved by a method comprising separately applying plural types of polymer compounds differing in the color of emitted light or by a method using a color filter or a fluorescence conversion filter. The dot matrix device can be driven passively or may be driven actively in combination with TFT or the like. These display devices can be used as display devices for computers, televisions, mobile terminals, cellular phones, car navigation systems, video camera view finders, and so on.

The polymer light-emitting device of the present invention can be a self-light-emitting thin type, and can be suitably used as a planar light source for a liquid crystal display backlight, or as a planar light source for illumination. The polymer light-emitting device can also be used as a curved light source or display by use of a flexible substrate.

### EXAMPLES

The present invention will be described more specifically below with reference to Examples and Comparative Examples; however, the present invention is not limited to the following Examples.

### [Production of polymer compounds <P-1> to <P-7>]

### (Example 1)

A polymer compound <P-1> was produced containing a block (A) and a block (B) represented by the following structural formulas.

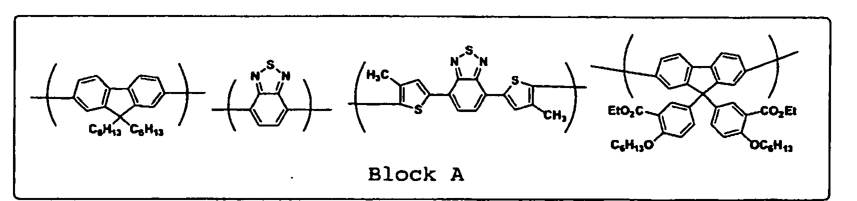

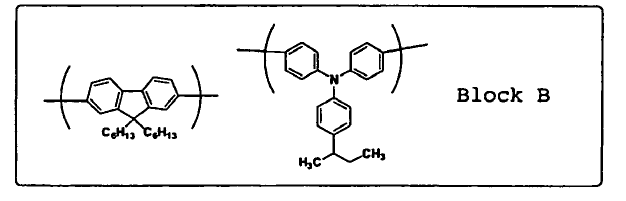

Specifically, 2,7-bis(1,3,2-dioxaborolan-2-yl)-9,9-dihexylfluorene (0.77 g), 4,7-bis(5-bromo-4-methyl-2-thienyl)-2,1,3-benzothiadiazole (0.11 g), 4,7-dibromo-2,1,3-benzothiadiazole (0.40 g), 2,7-dibromo-9,9-bis(4'-hexyloxy-3-ethoxycarbonylphenyl)-fluorene (0.15 g), bistriphenylphosphinepalladium dichloride (3.7 mg), Aliquat 336 (0.23 g, manufactured by Aldrich) and toluene (18 ml) were mixed in an inert atmosphere first, and the resulting reaction solution was heated to 105°C. Then, a 2 M aqueous Na₂CO₃ solution (4.8 ml) was added dropwise to the reaction solution, followed by refluxing for five hours to provide a block (A) in the reaction solution. The resulting block (A) had a polystyrene equivalent weight average molecular weight (MwA) of 5.0 × 10⁴.

Next, the reaction solution was cooled to 70°C. Then, 2,7-bis(1,3,2-dioxaborolan-2-yl)-9,9-dihexylfluorene (1.37 g), 2,7-dibromo-9,9-dihexylfluorene (0.80 g), bis(4-bromophenyl)-(4-sec-butylphenyl)-amine (0.52 g), bistriphenylphosphinepalladium dichloride (5.8 mg), Aliquat 336 (0.36 g, manufactured by Aldrich) and toluene (28 ml) were added to the reaction solution, and the mixture was heated to 105°C. Thereafter, a 2 M aqueous Na₂CO₃ solution (7.5 ml) was added dropwise to the reaction solution, followed by refluxing for one hour. Then, phenylboric acid (50 mg) was added, followed by further refluxing for three hours. Next, a 1.8 M aqueous sodium diethyldithiacarbamate solution (20 ml) was added to the resulting reaction solution, followed by stirring at 80°C for four hours. Thereafter, the reaction solution was cooled to 25°C, and then washed with water (50 ml) three times, a 3 wt% aqueous acetic acid solution (50 ml) three times and water (50 ml) three times and purified by allowing it to pass through an alumina column and a silica gel column to provide a toluene solution. Subsequently, the toluene solution was added dropwise to methanol (1 L), followed by stirring for one hour. Then, the resulting solid was filtered and dried to provide a polymer compound <P-1>. The yield of the resulting polymer compound <P-1> was 2.3 g. The resulting polymer compound <P-1> had a polystyrene equivalent weight average molecular weight (Mw) of 1.3 × 10⁵ and a polystyrene equivalent number average molecular weight (Mn) of 4.3 × 10⁴.

4,7-Dibromo-2,1,3-benzothiadiazole was synthesized by the method described in US 3577427. 4,7-Bis(5-bromo-4-methyl-2-thienyl)-2,1,3-benzothiadiazole was synthesized by the method described in WO 2000/046321. Bis(4-bromophenyl)-(4-sec-butylphenyl)-amine was synthesized by the method described in WO 2002/045184. 2,7-Dibromo-9,9-bis(4'-hexyloxy-3-ethoxycarbonylphenyl)-fluorene.was synthesized by the method described in WO 2006/060437.

### (Comparative Example 1)

A polymer compound <P-2> was produced containing a repeating unit represented by the following structural formula.

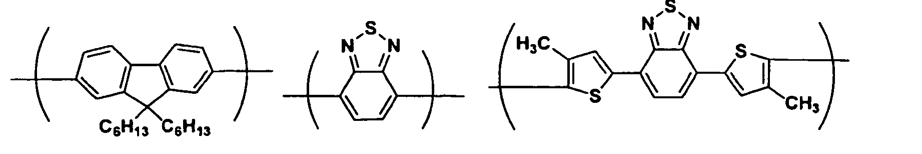

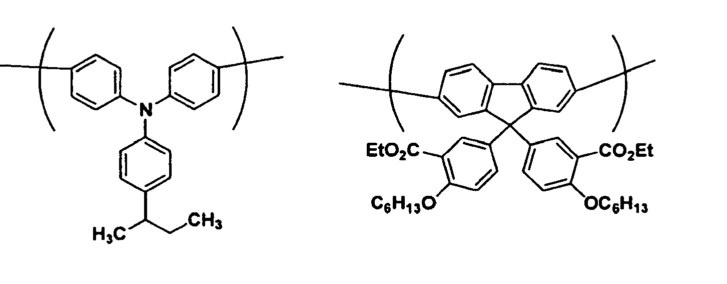

Specifically, 2,7-bis(1,3,2-dioxaborolan-2-yl)-9,9-dihexylfluorene (1.91 g), 4,7-bis(5-bromo-4-methyl-2-thienyl)-2,1,3-benzothiadiazole (0.10 g), 4,7-dibromo-2,1,3-benzothiadiazole (0.36 g), 2,7-dibromo-9,9-bis(4'-hexyloxy-3-ethoxycarbonylphenyl)-fluorene (0.13 g), 2,7-dibromo-9,9-dihexylfluorene (0.71 g), bis(4-bromophenyl)-(4-sec-butylphenyl)-amine (0.46 g), bistriphenylphosphinepalladium dichloride (8.4 mg), Aliquat 336 (0.51 g, manufactured by Aldrich) and toluene (40 ml) were mixed in an inert atmosphere first, and the resulting reaction solution was heated to 105°C. Next, a 2 M aqueous Na₂CO₃ solution (11 ml) was added dropwise to the reaction solution, and the reaction was carried out by refluxing for four hours. Then, phenylboric acid (50 mg) was added, followed by further refluxing for three hours. Next, a 1.8 M aqueous sodium diethyldithiacarbamate solution (20 ml) was added to the reaction solution, followed by stirring at 80°C for four hours. Thereafter, the reaction solution was cooled to 25°C, washed with water (50 ml) three times, a 3 wt% aqueous acetic acid solution (50 ml) three times and water (50 ml) three times and purified by allowing it to pass through an alumina column and a silica gel column to provide a toluene solution. Subsequently, the resulting toluene solution was added dropwise to methanol (1 L), followed by stirring for one hour. Then, the resulting solid was filtered and dried to provide a polymer compound <P-2>. The yield of the resulting polymer compound <P-2> was 2.1 g. The resulting polymer compound <P-2> had a weight average molecular weight based on polystyrene standards (Mw) of 1.6 × 10⁵ and a number average molecular weight based on polystyrene standards (Mn) of 6.6 × 10⁴.

### (Comparative Example 2)

A polymer compound <P-3> was produced containing a block (A') and a block (B) represented by the following structural formulas.

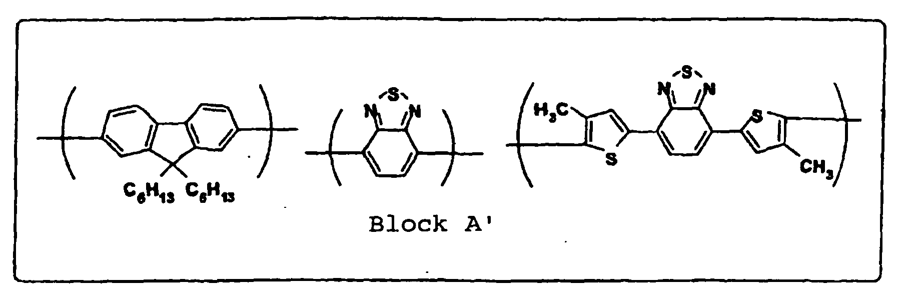

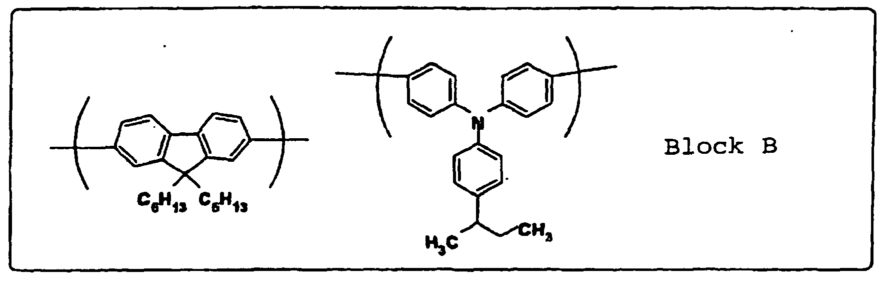

Specifically, 2,7-bis(1,3,2-dioxaborolan-2-yl)-9,9-dihexylfluorene (0.69 g), 4,7-bis(5-bromo-4-methyl-2-thienyl)-2,1,3-benzothiadiazole (0.11 g), 4,7-dibromo-2,1,3-benzothiadiazole (0.40 g), bistriphenylphosphinepalladium dichloride (3.3 mg), Aliquat 336 (0.23 g, manufactured by Aldrich) and toluene (18 ml) were mixed in an inert atmosphere first, and the resulting reaction solution was heated to 105°C. Then, a 2 M aqueous Na₂CO₃ solution (4.8 ml) was added dropwise to the reaction solution, followed by refluxing for two hours to provide a block (A) in the reaction solution. The resulting block (A) had a polystyrene equivalent weight average molecular weight (MwA) of 3.4 × 10⁴.

Next, the reaction solution was cooled to 70°C. Then, 2,7-bis(1,3,2-dioxaborolan-2-yl)-9,9-dihexylfluorene (1.46 g), 2,7-dibromo-9,9-dihexylfluorene (0.89 g), bis(4-bromophenyl)-(4-sec-butylphenyl)-amine (0.52 g), bistriphenylphosphinepalladium dichloride (6.2 mg), Aliquat 336 (0.36 g, manufactured by Aldrich) and toluene (28 ml) were added to the reaction solution, and the mixture was heated to 105°C. Thereafter, a 2 M aqueous Na₂CO₃ solution (7.5 ml) was added dropwise to the reaction solution, followed by refluxing for three hours. Then, phenylboric acid (50 mg) was added, followed by further refluxing for three hours. Next, a 1.8 M aqueous sodium diethyldithiacarbamate solution (20 ml) was added to the reaction solution, followed by stirring at 80°C for four hours. Thereafter, the resulting reaction solution was cooled to 25°C, and then washed with water (50 ml) three times, a 3 wt% aqueous acetic acid solution (50 ml) three times and water (50 ml) three times and purified by allowing it to pass through an alumina column and a silica gel column to provide a toluene solution. Subsequently, the resulting toluene solution was added dropwise to methanol (1 L), followed by stirring for one hour. Then, the resulting solid was filtered and dried to provide a polymer compound <P-3>. The yield of the resulting polymer compound <P-3> was 2.4 g. The polymer compound <P-3> had a polystyrene equivalent weight average molecular weight (Mw) of 2.4 × 10⁵ and a polystyrene equivalent number average molecular weight (Mn) of 8.9 × 10⁴.

### (Synthetic Example 1)

A polymer compound <P-4> was produced containing a repeating unit represented by the following structural formula.

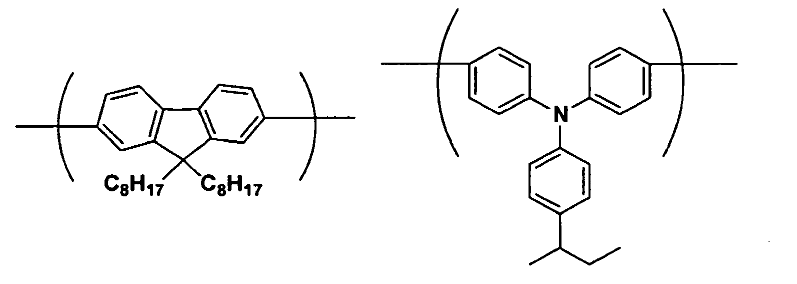

Specifically, 2,7-bis(1,3,2-dioxaborolan-2-yl)-9,9-dioctylfluorene (5.20 g), bis(4-bromophenyl)-(4-sec-butylphenyl)-amine (0.14 g), palladium acetate (2.2 mg), tri(2-methylphenyl)phosphine (15.1 mg), Aliquat 336 (0.91 g, manufactured by Aldrich) and toluene (70 ml) were mixed in an inert atmosphere first, and the resulting reaction solution was heated to 105°C. Next, a 2 M aqueous Na₂CO₃ solution (19 ml) was added dropwise to the reaction solution, followed by refluxing for four hours. Then, phenylboric acid (121 mg) was added, followed by further refluxing for three hours. Next, a 1.8 M aqueous sodium diethyldithiacarbamate solution (50 ml) was added to the reaction solution, followed by stirring at 80°C for four hours. Thereafter, the reaction solution was cooled to 25°C, and then washed with water (60 ml) three times, a 3 wt% aqueous acetic acid solution (60 ml) three times and water (60 ml) three times and purified by allowing it to pass through an alumina column and a silica gel column to provide a toluene solution. Subsequently, the resulting toluene solution was added dropwise to methanol (3 L), followed by stirring for three hours. Then, the resulting solid was filtered and dried to provide a polymer compound <P-4>. The yield of the resulting polymer compound <P-4> was 5.25 g. The polymer compound <P-4> had a polystyrene equivalent weight average molecular weight of 2.6 × 10⁵ and a polystyrene equivalent number average molecular weight of 1.2 × 10⁴.

### (Example 2)

A polymer compound <P-5> was produced containing a block (A) and a block (B) represented by the following structural formulas.

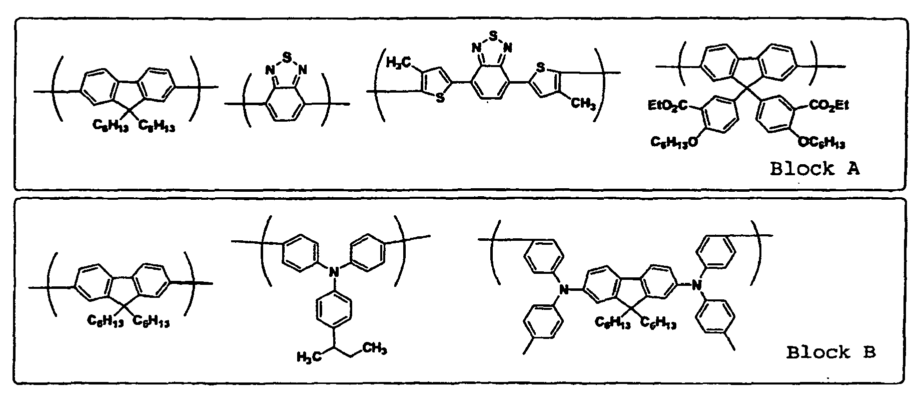

Specifically, 2,7-bis(1,3,2-dioxaborolan-2-yl)-9,9-dihexylfluorene (0.92 g), 4,7-bis(5-bromo-4-methyl-2-thienyl)-2,1,3-benzothiadiazole (0.16 g), 4,7-dibromo-2,1,3-benzothiadiazole (0.48 g), 2,7-dibromo-9,9-bis(4'-hexyloxy-3-ethoxycarbonylphenyl)-fluorene (0.11 g), bistriphenylphosphinepalladium dichloride (4.4 mg), Aliquat 336 (0.32 g, manufactured by Aldrich) and toluene (21 ml) were mixed in an inert atmosphere first, and the resulting reaction solution was heated to 105°C. Then, a 17.5 wt% aqueous Na₂CO₃ solution (5.7 ml) was added dropwise to the reaction solution, followed by refluxing for 1.5 hours to provide a block (A) in the reaction solution. The resulting block (A) had a polystyrene equivalent weight average molecular weight (MwA) of 1.3 × 10⁵.

Next, the reaction solution was cooled to 70°C. Then, 2,7-bis(1,3,2-dioxaborolan-2-yl)-9,9-dihexylfluorene (2.18 g), 2,7-dibromo-9,9-dihexylfluorene (1.06 g), bis(4-bromophenyl)-(4-sec-butylphenyl)-amine (0.90 g), N,N'-bis-(4-bromophenyl)-N,N'-di-p-toluyl-9,9-dioctylfluorene-2,7-diamine (0.09 g), bistriphenylphosphinepalladium dichloride (9.3 mg), Aliquat 336 (0.57 g, manufactured by Aldrich) and toluene (45 ml) were added to the reaction solution, and the mixture was heated to 105°C. Thereafter, a 17.5 wt% aqueous Na₂CO₃ solution (7.5 ml) was added dropwise to the reaction solution, followed by refluxing for eight hours. Then, phenylboric acid (50 mg) and bistriphenylphosphinepalladium dichloride (9.3 mg) were added, followed by further refluxing for two hours. Next, 40 ml of an aqueous sodium diethyldithiacarbamate solution was added to the resulting reaction solution, followed by stirring at 80°C for two hours. Thereafter, the reaction solution was cooled to 25°C, and then washed with water (50 ml) twice, a 3 wt% aqueous acetic acid solution (50 ml) twice and water (50 ml) twice and purified by allowing it to pass through an alumina column and a silica gel column to provide a toluene solution. Subsequently, the toluene solution was added dropwise to methanol (1 L), followed by stirring for one hour. Then, the resulting solid was filtered and dried to provide a polymer compound <P-5>. The yield of the resulting polymer compound <P-5> was 2.7 g. The resulting polymer compound <P-5> had a polystyrene equivalent weight average molecular weight (Mw) of 1.0 × 10⁵ and a polystyrene equivalent number average molecular weight (Mn) of 5.5 × 10⁴.

### (Example 3)

A polymer compound <P-6> was produced containing a block (A) and a block (B) represented by the following structural formulas.

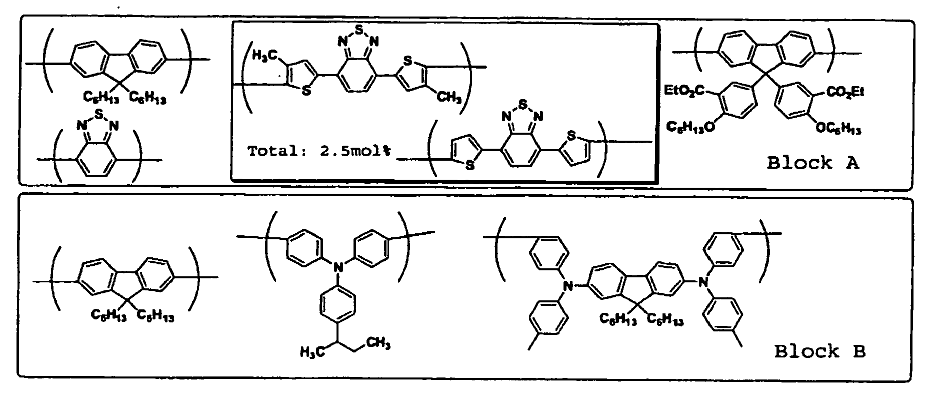

Specifically, 2,7-bis(1,3,2-dioxaborolan-2-yl)-9,9-dihexylfluorene (0.79 g), 4,7-bis(5-bromo-4-methyl-2-thienyl)-2,1,3-benzothiadiazole (0.11 g), 4,7-bis(5-bromo-2-thienyl)-2,1,3-benzothiadiazole (0.03 g), 4,7-dibromo-2,1,3-benzothiadiazole (0.41 g), 2,7-dibromo-9,9-bis(4'-hexyloxy-3-ethoxycarbonylphenyl)-fluorene (0.09 g), bistriphenylphosphinepalladium dichloride (3.7 mg), Aliquat 336 (0.37 g, manufactured by Aldrich) and toluene (24 ml) were mixed in an inert atmosphere first, and the resulting reaction solution was heated to 105°C. Then, a 2 M aqueous Na₂CO₃ solution (4.0 ml) was added dropwise to the reaction solution, followed by refluxing for five hours to provide a block (A) in the reaction solution. The resulting block (A) had a polystyrene equivalent weight average molecular weight (MwA) of 7.2 × 10⁴.

Next, the reaction solution was cooled to 70°C. Then, 2,7-bis(1,3,2-dioxaborolan-2-yl)-9,9-dihexylfluorene (2.01 g), 2,7-dibromo-9,9-dihexylfluorene (0.90 g), bis(4-bromophenyl)-(4-sec-butylphenyl)-amine (0.77 g), N,N'-bis-(4-bromophenyl)-N,N'-di-p-toluyl-9,9-dioctylfluorene-2,7-diamine (0.25 g), bistriphenylphosphinepalladium dichloride (8.0 mg), Aliquat 336 (0.58 g, manufactured by Aldrich) and toluene (45 ml) were added to the reaction solution, and the mixture was heated to 105°C. Thereafter, a 17.5 wt% aqueous Na₂CO₃ solution (7.0 ml) was added dropwise to the reaction solution, followed by refluxing for seven hours. Then, phenylboric acid (70 mg) and bistriphenylphosphinepalladium dichloride (8.0 mg) were added, followed by further refluxing for two hours. Next, 40 ml of an aqueous sodium diethyldithiacarbamate solution was added to the resulting reaction solution, followed by stirring at 80°C for two hours. Thereafter, the reaction solution was cooled to 25°C, and then washed with water (70 ml) twice, a 3 wt% aqueous acetic acid solution (70 ml) twice and water (70 ml) twice and purified by allowing it to pass through an alumina column and a silica gel column to provide a toluene solution. Subsequently, the toluene solution was added dropwise to methanol (1 L), followed by stirring for one hour. Then, the resulting solid was filtered and dried to provide a polymer compound <P-6>. The yield of the resulting polymer compound <P-6> was 1.2 g. The resulting polymer compound <P-6> had a polystyrene equivalent weight average molecular weight (Mw) of 4.7 × 10⁴ and a polystyrene equivalent number average molecular weight (Mn) of 2.5 × 10⁴.

### (Example 4)

A polymer compound <P-7> was produced containing a block (A) and a block (B) represented by the following structural formulas.

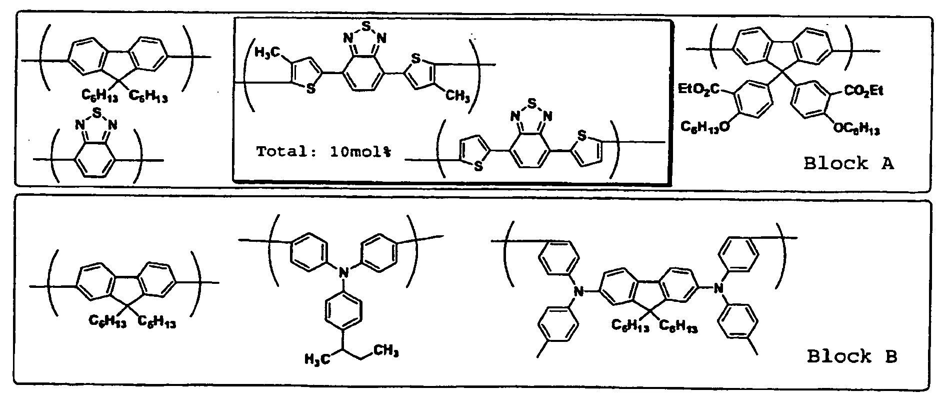

Specifically, 2,7-bis(1,3,2-dioxaborolan-2-yl)-9,9-dihexylfluorene (1.05 g), 4,7-bis(5-bromo-4-methyl-2-thienyl)-2,1,3-benzothiadiazole (0.43 g), 4,7-bis(5-bromo-2-thienyl)-2,1,3-benzothiadiazole (0.10 g), 4,7-dibromo-2,1,3-benzothiadiazole (0.41 g), 2,7-dibromo-9,9-bis(4'-hexyloxy-3-ethoxycarbonylphenyl)-fluorene (0.09 g), bistriphenylphosphinepalladium dichloride (5.5 mg), Aliquat 336 (0.50 g, manufactured by Aldrich) and toluene (35 ml) were mixed in an inert atmosphere first, and the resulting reaction solution was heated to 105°C. Then, a 2 M aqueous Na₂CO₃ solution (6.0 ml) was added dropwise to the reaction solution, followed by refluxing for five hours to provide a block (A) in the reaction solution. The resulting block (A) had a polystyrene equivalent weight average molecular weight (MwA) of 9.0 × 10⁴.

Next, the reaction solution was cooled to 70°C. Then, 2,7-bis(1,3,2-dioxaborolan-2-yl)-9,9-dihexylfluorene (1.60 g), 2,7-dibromo-9,9-dihexylfluorene (0.49 g), bis(4-bromophenyl)-(4-sec-butylphenyl)-amine (0.77 g), N,N'-bis-(4-bromophenyl)-N,N'-di-p-toluyl-9,9-dioctylfluorene-2,7-diamine (0.25 g), bistriphenylphosphinepalladium dichloride (6.2 mg), Aliquat 336 (0.45 g, manufactured by Aldrich) and toluene (29 ml) were added to the reaction solution, and the mixture was heated to 105°C. Thereafter, a 17.5 wt% aqueous Na₂CO₃ solution (5.0 ml) was added dropwise to the reaction solution, followed by refluxing for two hours. Then, phenylboric acid (70 mg) and bistriphenylphosphinepalladium dichloride (6.2 mg) were added, followed by further refluxing for two hours. Next, 30 ml of an aqueous sodium diethyldithiacarbamate solution was added to the resulting reaction solution, followed by stirring at 80°C for two hours. Thereafter, the reaction solution was cooled to 25°C, and then washed with water (70 ml) twice, a 3 wt% aqueous acetic acid solution (70 ml) twice and water (70 ml) twice and purified by allowing it to pass through an alumina column and a silica gel column to provide a toluene solution. Subsequently, the toluene solution was added dropwise to methanol (1 L), followed by stirring for one hour. Then, the resulting solid was filtered and dried to provide a polymer compound <P-7>. The yield of the resulting polymer compound <P-7> was 2.5 g. The resulting polymer compound <P-7> had a polystyrene equivalent weight average molecular weight (Mw) of 1.9 × 10⁵ and a polystyrene equivalent number average molecular weight (Mn) of 7.7 × 10⁴.

### [Production of polymer light-emitting device (electroluminescence device)]

### (Example 5)

An ITO film was laminated on a glass substrate at a thickness of 150 nm by sputtering. A suspension of poly(3,4)ethylenedioxythiophene/polystyrenesulfonic acid (manufactured by Bayer) was applied to the surface of the ITO film on the glass substrate at a thickness of about 65 nm by spin coating to form a first film, which was then dried on a hot plate under a temperature condition of 200°C for 15 minutes.

Next, the polymer compound <P-4> obtained in Synthetic Example 1 was dissolved in mixed xylene at a concentration of 1.5 wt% to provide a xylene solution. The xylene solution was applied to the surface of the first film by spin coating to form a second film, which was then dried in a nitrogen atmosphere at an oxygen concentration and a moisture concentration of 10 ppm or less (by weight) under a temperature condition of 200°C for one hour. After drying in this manner, the soluble matter was rinsed with mixed xylene in air so that the second film had a thickness of about 10 nm.

Next, the polymer compound <P-1> obtained in Example 1 was dissolved in mixed xylene at a concentration of 1.5 wt% to provide a liquid composition. The liquid composition was applied to the surface of the second film at a thickness of about 100 nm by spin coating to form a film of light-emitting layer, which was then dried in a nitrogen atmosphere at an oxygen concentration and a moisture concentration of 10 ppm or less (by weight) under a temperature condition of 130°C for one hour. Thereafter, the pressure was reduced to 1.0 × 10⁻⁴ Pa or less, and then barium was deposited at about 5 nm as a cathode on the surface of the light-emitting layer, followed by further deposition of aluminum at about 80 nm as a cathode. After deposition in this manner, the polymer light-emitting device of the present invention was prepared by sealing with a glass substrate.

### <Device configuration>

### ITO (anode)/first film (Baytron P: about 70 nm thickness)/second film (polymer compound <P-4>: 10 nm thickness)/light-emitting layer (polymer compound <P-1>: about 100 nm thickness)/Ba (cathode)/Al (cathode)

### <Evaluation of performance of polymer light-emitting device (EL device) obtained in Example 5>

Performance of the obtained polymer light-emitting device was evaluated by applying voltage. When a voltage of 6.0 V was applied, the polymer light-emitting device obtained in Example 2 emitted fluorescence having an emission wavelength peak at 645 nm. The luminance at that time was 499 cd/m². The maximum luminous efficiency was 1.88 cd/A at 4.0 V. Further, the time for reducing an initial luminance of 2000 cd/m² to a luminance of 50% (life) was 148.2 hours, resulting in a long life. The increase in voltage when driven until the luminance was 50% (difference between the voltage after driving and the voltage before driving) was 2.8 V. Thus, the increase in driving voltage was sufficiently small.

### (Comparative Example 3)

An ITO film was laminated on a glass substrate at a thickness of 150 nm by sputtering. A suspension of poly(3,4)ethylenedioxythiophene/polystyrenesulfonic acid (manufactured by Bayer) was applied to the surface of the ITO film on the glass substrate at a thickness of about 65 nm by spin coating to form a first film, which was dried on a hot plate at 200°C for 15 minutes. Next, the polymer compound <P-4> obtained in Synthetic Example 1 was dissolved in mixed xylene at a concentration of 1.5 wt% to provide a xylene solution. The xylene solution was applied to the surface of the first film by spin coating to form a second film, which was then dried in a nitrogen atmosphere at an oxygen concentration and a moisture concentration of 10 ppm or less (by weight) at 200°C for one hour. After drying in this manner, the soluble matter was rinsed with mixed xylene in air so that the second film had a thickness of about 10 nm.

Next, the polymer compound <P-2> obtained in Comparative Example 1 was dissolved in mixed xylene at a concentration of 1.5 wt% to provide a xylene solution. The xylene solution was applied to the surface of the second film at a thickness of about 100 nm by spin coating to form a film of light-emitting layer, which was then dried in a nitrogen atmosphere at an oxygen concentration and a moisture concentration of 10 ppm or less (by weight) under a temperature condition of 130°C for one hour. Thereafter, the pressure was reduced to 1.0 × 10⁻⁴ Pa or less, and then barium was deposited at about 5 nm as a cathode on the surface of the light-emitting layer, followed by further deposition of aluminum at about 80 nm as a cathode. After deposition in this manner, a polymer light-emitting device for comparison was prepared by sealing with a glass substrate.

### <Device configuration>

### ITO/first film (Baytron P: about 70 nm thickness)/second film (polymer compound <P-4>: 10 nm thickness)/light-emitting layer (polymer compound <P-2>: about 100 nm thickness)/Ba (cathode)/Al (cathode)

### <Evaluation of performance of polymer light-emitting device (EL device) obtained in Comparative

### Example 3>

Performance of the obtained polymer light-emitting device was evaluated by applying voltage. When a voltage of 6.0 V was applied, the polymer light-emitting device obtained in Comparative Example 3 emitted fluorescence having an emission wavelength peak at 645 nm. The luminance at that time was 161 cd/m². The maximum luminous efficiency was 2.02 cd/A at 4.6 V. Further, the time for reducing an initial luminance of 2000 cd/m² to a luminance of 50% (life) was 122.6 hours. The increase in voltage when driven until the luminance was 50% (difference between the voltage after driving and the voltage before driving) was 4.4 V.

### (Comparative Example 4)

An ITO film was laminated on a glass substrate at a thickness of 150 nm by sputtering. A suspension of poly(3,4)ethylenedioxythiophene/polystyrenesulfonic acid (manufactured by Bayer) was applied to the surface of the ITO film on the glass substrate at a thickness of about 65 nm by spin coating to form a first film, which was dried on a hot plate at 200°C for 15 minutes.

Next, the polymer compound <P-4> obtained in Synthetic Example 1 was dissolved in mixed xylene at a concentration of 1.5 wt% to provide a xylene solution. The xylene solution was applied to the surface of the first film by spin coating to form a second film, which was then dried in a nitrogen atmosphere at an oxygen concentration and a moisture concentration of 10 ppm or less (by weight) under a temperature condition of 200°C for one hour. After drying in this manner, the soluble matter was rinsed with mixed xylene in air so that the second film had a thickness of about 10 nm.

Next, the polymer compound <P-3> obtained in Comparative Example 2 was dissolved in mixed xylene at a concentration of 1.5 wt% to provide a xylene solution. The xylene solution was applied to the surface of the second film at a thickness of about 100 nm by spin coating to form a film of light-emitting layer, which was dried in a nitrogen atmosphere at an oxygen concentration and a moisture concentration of 10 ppm or less (by weight) under a temperature condition of 130°C for one hour. Thereafter, the pressure was reduced to 1.0 × 10⁻⁴ Pa or less, and then barium was deposited at about 5 nm as a cathode, followed by further deposition of aluminum at about 80 nm as a cathode. After deposition of the cathodes in this manner, a polymer light-emitting device was prepared by sealing with a glass substrate.

### <Device configuration>

### ITO/first film (Baytron P: about 70 nm thickness)/second film (polymer compound <P-4>: 10 nm thickness)/light-emitting layer (polymer compound <P-3>: about 100 nm thickness)/Ba (cathode)/Al (cathode)

### <Evaluation of performance of polymer light-emitting device (EL device) obtained in Comparative

### Example 4>

Performance of the obtained polymer light-emitting device was evaluated by applying voltage. When a voltage of 6.0 V was applied, the polymer light-emitting device obtained in Comparative Example 4 emitted fluorescence having an emission wavelength peak at 645 nm. The luminance at that time was 548 cd/m². The maximum luminous efficiency was 2.18 cd/A at 3.6 V. Further, the time for reducing an initial luminance of 2000 cd/m² to a luminance of 50% (life) was 121.6 hours. The increase in voltage when driven until the luminance was 50% (difference between the voltage after driving and the voltage before driving) was 4.8 V.

### INDUSTRIAL APPLICABILITY

As described above, the present invention can provide a block copolymer allowing production of a light-emitting device that can sufficiently suppress an increase in driving voltage and has a sufficiently long luminance half-life when used as a material for a light-emitting device, and a composition, a liquid composition, a light-emitting thin film and a polymer light-emitting device using the same.

Accordingly, the block copolymer of the present invention is particularly useful as a material for a curved or planar light source for a liquid crystal display backlight or illumination, a segment-type display device or a dot-matrix flat panel display, for example.

## Claims

1. A block copolymer **characterized by** comprising:
a block (A) containing at least one repeating unit represented by the following general formula (I), at least one repeating unit represented by the following general formula (II), and at least one repeating unit represented by the following general formula (III); and
a block (B) containing at least one repeating unit represented by the following general formula (III) and at least one repeating unit represented by the following formula (IV), 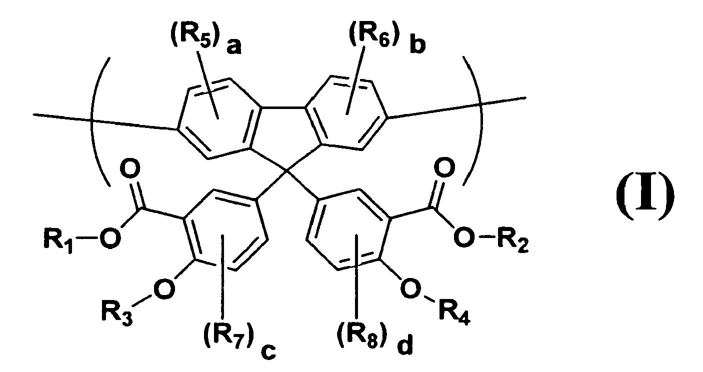 wherein R₁, R₂, R₃ and R₄ may be the same or different and each represent a hydrogen atom or an alkyl group, R₅, R₆, R₇ and R₈ may be the same or different and each represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, and a, b, c and d may be the same or different and each represent an integer of 0 to 3, provided that when a plurality of R₅, R₆, R₇ or R₈ are present, they may be the same or different,
-Ar₁- (II)
wherein Ar₁ represents a divalent heterocyclic group containing a five-membered ring,
-Ar₂- (III)
wherein Ar₂ represents an arylene group, and
-Ar₃- (IV)
wherein Ar₃ represents a divalent aromatic amine residue.

2. The block copolymer according to claim 1, wherein Ar₁ in the general formula (II) is a group represented by the following general formula (V): 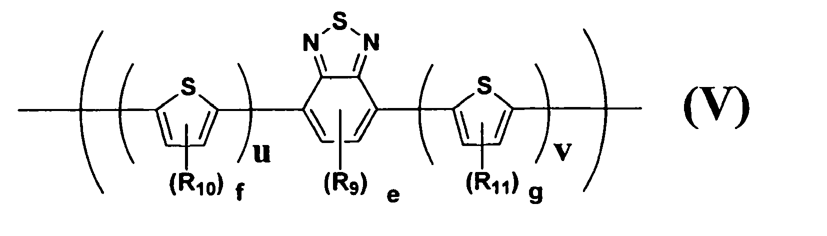 wherein R₉, R₁₀ and R₁₁ may be the same or different and
each represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, e, f and g may be the same or different and each represent an integer of 0 to 2, and u and v may be the same or different and each represent an integer of 0 to 2, provided that when a plurality of R₉, R₁₀ or R₁₁ are present, they may be the same or different.

3. The block copolymer according to claim 1 or 2, wherein Ar₂ in the general formula (III) is a group represented by the following general formula (VI): 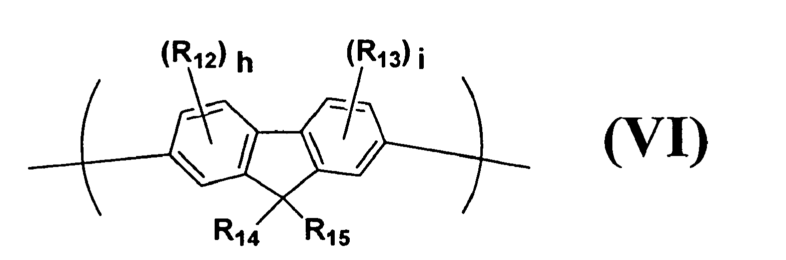 wherein R₁₂ and R₁₃ may be the same or different and each represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, h and i may be the same or different and each represent an integer of 0 to 3, and R₁₄ and R₁₅ may be the same or different and each represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, provided that when a plurality of R₁₂ or R₁₃ are present, they may be the same or different.

4. The block copolymer according to any one of claims 1 to 3, wherein Ar₃ in the general formula (IV) is a group represented by the following general formula (VII): 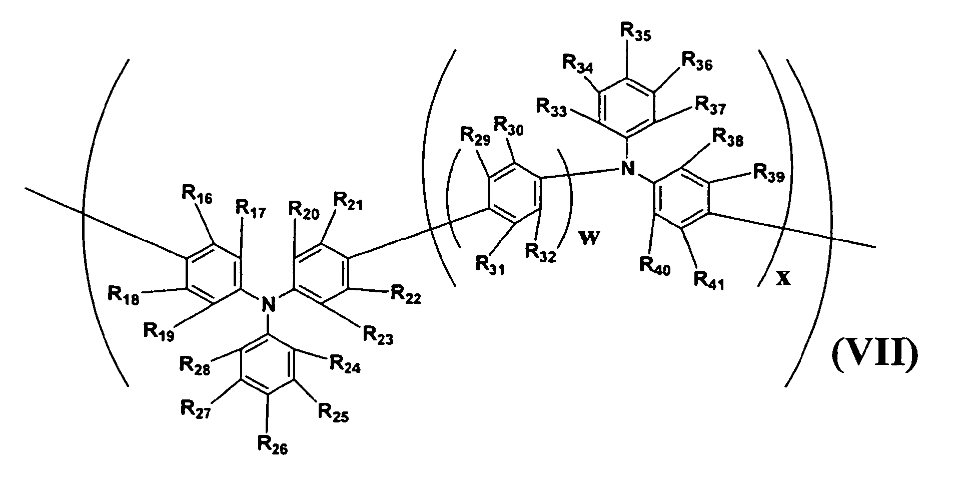 wherein R₁₆ to R₄₁ may be the same or different and each represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group, and w and × may be the same or different and each represent an integer of 0 or 1,
provided that the carbon atom to which R₁₇ is bonded and the carbon atom to which R₂₀ is bonded, the carbon atom to which R₁₉ is bonded and the carbon atom to which R₂₈ is bonded, the carbon atom to which R₃₂ is bonded and the carbon atom to which R₄₀ is bonded, or the carbon atom to which R₃₇ is bonded and the carbon atom to which R₃₈ is bonded, may be directly bonded or bonded via an oxygen atom or a sulfur atom to each other to form a ring, respectively, and when such a ring is formed, R₁₇ and R₂₀, R₁₉ and R₂₈, R₃₂ and R₄₀, or R₃₇ and R₃₈, together represent the direct bond, the oxygen atom or the sulfur atom, and
R₂₂ and R₃₁, or R₂₁ and R₂₉, may be directly bonded to each other to form a ring which may have a substituent, respectively.

5. The block copolymer according to claim 2, which comprises at least two types of repeating units represented by the general formula (V), as Ar₁ in the general formula (II).

6. The block copolymer according to claim 2 or 5, wherein the total content of the repeating unit(s) represented by the general formula (V) is 3 mol% or more and 40 mol% or less, as Ar₁ in the general formula (II) with respect to all repeating units in the block copolymer.

7. The polymer compound according to claim 4, wherein the group represented by the general formula (VII) is at least one selected from the group consisting of a group in which × in the formula (VII) is 0 and a group represented by the following general formula (VIII): 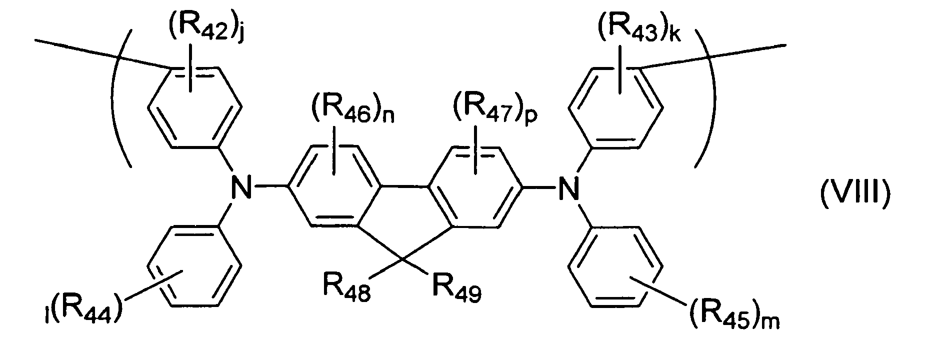 wherein R₄₂ to R₄₇ may be the same or different and each represent a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, an acyl group, an acyloxy group, an imine residue, an amide group, an acid imide group, a monovalent heterocyclic group, a carboxyl group, a substituted carboxyl group, a cyano group or a nitro group,
j and k may be the same or different and each represent an integer of 0 to 4,
l and m may be the same or different and each represent an integer of 0 to 5, and
n and p may be the same or different and each represent an integer of 0 to 3,
provided that when a plurality of at least one of groups among R₄₂, R₄₃, R₄₄, R₄₅, R₄₆ or R₄₇, they may be the same or different, and
R₄₈ and R₄₉ may be the same or different and each represent a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, a cyano group or a nitro group.

8. The block copolymer according to any one of claims 1 to 7, wherein the molar ratio of the block (A) to the block (B) ((A)/(B)) is 0.1 to 10.

9. The block copolymer according to any one of claims 1 to 8, which has a polystyrene equivalent weight average molecular weight of 10³ to 10⁷.

10. The block copolymer according to any one of claims 1 to 9, wherein the block (A) has a polystyrene equivalent weight average molecular weight of 10³ to 10⁵_{.}

11. A composition **characterized by** comprising the block copolymer according to any one of claims 1 to 10 and at least one material selected from the group consisting of a light-emitting material, a hole transport material and an electron transport material.

12. A liquid composition **characterized by c**omprising the block copolymer according to any one of claims 1 to 10 and a solvent.

13. A light-emitting thin film **characterized by** comprising the block copolymer according to any one of claims 1 to 10.

14. A polymer light-emitting device **characterized by** comprising, between electrodes consisting of an anode and a cathode, an organic layer containing the block copolymer according to any one of claims 1 to 10.

15. The polymer light-emitting device according to claim 14, wherein the organic layer is a light-emitting layer.

## Patentansprüche

1. Ein Blockcopolymer, **dadurch gekennzeichnet, dass** es umfasst:
einen Block (A), der mindestens eine durch die folgende allgemeine Formel (I) dargestellte wiederkehrende Einheit, mindestens eine durch die folgende allgemeine Formel (II) dargestellte wiederkehrende Einheit und mindestens eine durch die folgende allgemeine Formel (III) dargestellte wiederkehrende Einheit enthält; und
einen Block (B), der mindestens eine durch die folgende allgemeine Formel (III) dargestellte wiederkehrende Einheit und mindestens eine durch die folgende Formel (IV) dargestellte wiederkehrende Einheit enthält, 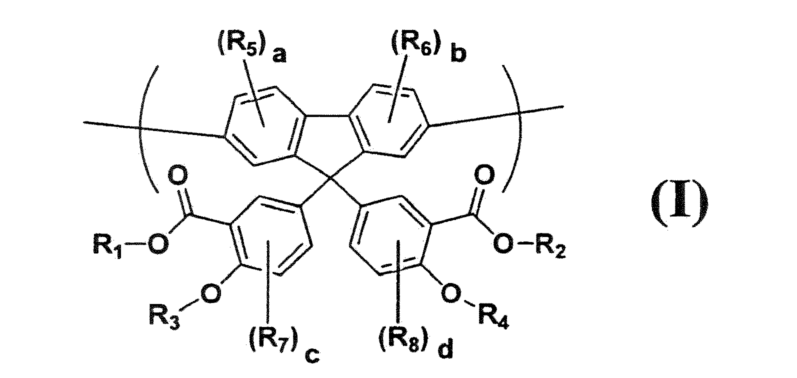
wobei R₁, R₂, R₃ und R₄ gleich oder verschieden sein können und jeweils ein Wasserstoffatom oder einen Alkylrest bedeuten, R₅, R₆, R₇ und R₈ gleich oder verschieden sein können und jeweils einen Alkylrest, einen Alkoxyrest, einen Alkylthiorest, einen Arylrest, einen Aryloxyrest, einen Arylthiorest, einen Arylalkylrest, einen Arylalkoxyrest, einen Arylalkylthiorest, einen Arylalkenylrest, einen Arylalkinylrest, eine Aminogruppe, eine substituierte Aminogruppe, eine Silylgruppe, eine substituierte Silylgruppe, ein Halogenatom, einen Acylrest, einen Acyloxyrest, einen Iminrest, einen Amidrest, einen Säureimidrest, einen einwertigen heterocyclischen Rest, eine Carboxylgruppe, eine substituierte Carboxylgruppe, eine Cyanogruppe oder eine Nitrogruppe bedeuten und a, b, c und d gleich oder verschieden sein können und jeweils eine ganze Zahl von 0 bis 3 bedeuten, mit der Maßgabe, dass, wenn eine Vielzahl von R₅, R₆, R₇ oder R₈ vorhanden sind, diese gleich oder verschieden sein können,
-Ar₁- (II)
wobei Ar₁ einen zweiwertigen heterocyclischen Rest, der einen fünfgliedrigen Ring enthält, bedeutet,
-Ar₂- (III)
wobei Ar₂ einen Arylenrest bedeutet, und
-Ar₃- (IV)
wobei Ar₃ einen zweiwertigen aromatischen Aminrest bedeutet.

2. Das Blockcopolymer nach Anspruch 1, wobei Ar₁ in der allgemeinen Formel (II) ein durch die folgende allgemeine Formel (V) dargestellter Rest ist: 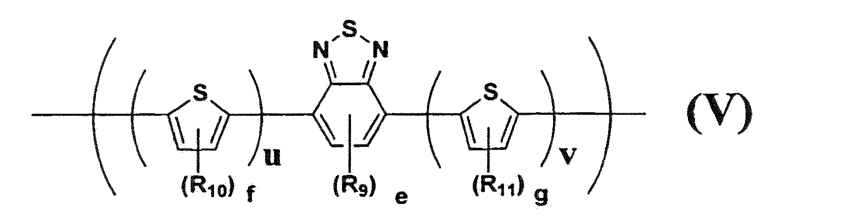 wobei R₉, R₁₀ und R₁₁ gleich oder verschieden sein können und jeweils einen Alkylrest, einen Alkoxyrest, einen Alkylthiorest, einen Arylrest, einen Aryloxyrest, einen Arylthiorest, einen Arylalkylrest, einen Arylalkoxyrest, einen Arylalkylthiorest, einen Arylalkenylrest, einen Arylalkinylrest, eine Aminogruppe, eine substituierte Aminogruppe, eine Silylgruppe, eine substituierte Silylgruppe, ein Halogenatom, einen Acylrest, einen Acyloxyrest, einen Iminrest, einen Amidrest, einen Säureimidrest, einen einwertigen heterocyclischen Rest, eine Carboxylgruppe, eine substituierte Carboxylgruppe, eine Cyanogruppe oder eine Nitrogruppe bedeuten, e, f und g gleich oder verschieden sein können und jeweils eine ganze Zahl von 0 bis 2 bedeuten und u und v gleich oder verschieden sein können und jeweils eine ganze Zahl von 0 bis 2 bedeuten, mit der Maßgabe, dass, wenn eine Vielzahl von R₉, R₁₀ oder R₁₁ vorhanden sind, diese gleich oder verschieden sein können.

3. Das Blockcopolymer nach Anspruch 1 oder 2, wobei Ar₂ in der allgemeinen Formel (III) ein durch die folgende allgemeine Formel (VI) dargestellter Rest ist: 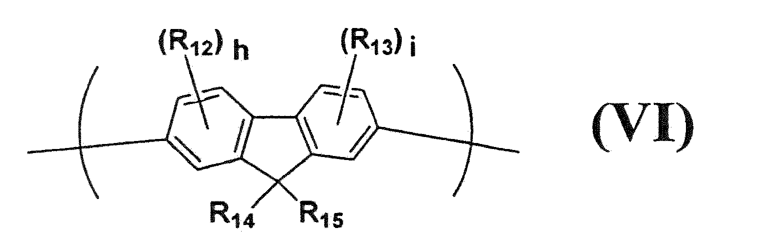 wobei R₁₂ und R₁₃ gleich oder verschieden sein können und jeweils einen Alkylrest, einen Alkoxyrest, einen Alkylthiorest, einen Arylrest, einen Aryloxyrest, einen Arylthiorest, einen Arylalkylrest, einen Arylalkoxyrest, einen Arylalkylthiorest, einen Arylalkenylrest, einen Arylalkinylrest, eine Aminogruppe, eine substituierte Aminogruppe, eine Silylgruppe, eine substituierte Silylgruppe, ein Halogenatom, einen Acylrest, einen Acyloxyrest, einen Iminrest, einen Amidrest, einen Säureimidrest, einen einwertigen heterocyclischen Rest, eine Carboxylgruppe, eine substituierte Carboxylgruppe, eine Cyanogruppe oder eine Nitrogruppe bedeuten, h und i gleich oder verschieden sein können und jeweils eine ganze Zahl von 0 bis 3 bedeuten und R₁₄ und R₁₅ gleich oder verschieden sein können und jeweils ein Wasserstoffatom, einen Alkylrest, einen Alkoxyrest, einen Alkylthiorest, einen Arylrest, einen Aryloxyrest, einen Arylthiorest, einen Arylalkylrest, einen Arylalkoxyrest, einen Arylalkylthiorest, einen Arylalkenylrest, einen Arylalkinylrest, eine Aminogruppe, eine substituierte Aminogruppe, eine Silylgruppe, eine substituierte Silylgruppe, ein Halogenatom, einen Acylrest, einen Acyloxyrest, einen Iminrest, einen Amidrest, einen Säureimidrest, einen einwertigen heterocyclischen Rest, eine Carboxylgruppe, eine substituierte Carboxylgruppe, eine Cyanogruppe oder eine Nitrogruppe bedeuten, mit der Maßgabe, dass, wenn eine Vielzahl von R₁₂ oder R₁₃ vorhanden sind, diese gleich oder verschieden sein können.

4. Das Blockcopolymer nach einem der Ansprüche 1 bis 3, wobei Ar₃ in der allgemeinen Formel (IV) ein durch die folgende allgemeine Formel (VII) dargestellter Rest ist: 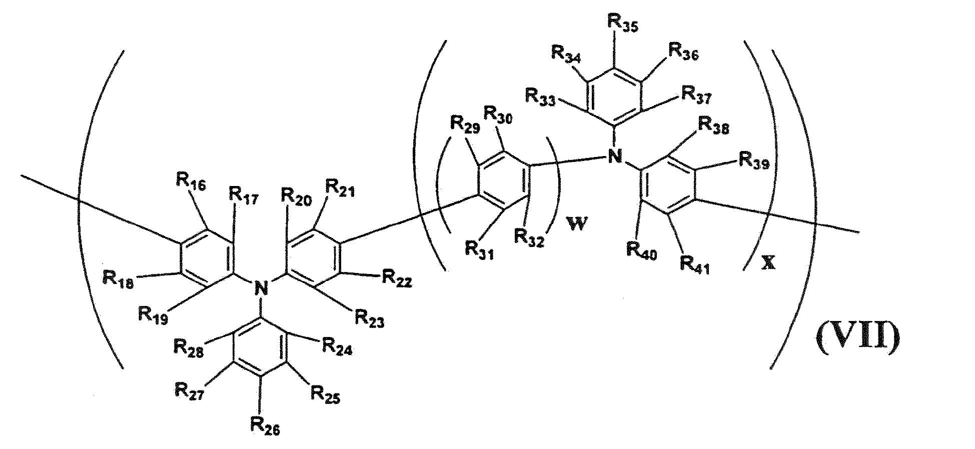 wobei R₁₆ bis R₄₁ gleich oder verschieden sein können und jeweils ein Wasserstoffatom, einen Alkylrest, einen Alkoxyrest, einen Alkylthiorest, einen Arylrest, einen Aryloxyrest, einen Arylthiorest, einen Arylalkylrest, einen Arylalkoxyrest, einen Arylalkylthiorest, einen Arylalkenylrest, einen Arylalkinylrest, eine Aminogruppe, eine substituierte Aminogruppe, eine Silylgruppe, eine substituierte Silylgruppe, ein Halogenatom, einen Acylrest, einen Acyloxyrest, einen Iminrest, einen Amidrest, einen Säureimidrest, einen einwertigen heterocyclischen Rest, eine Carboxylgruppe, eine substituierte Carboxylgruppe, eine Cyanogruppe oder eine Nitrogruppe bedeuten und w und x gleich oder verschieden sein können und jeweils eine ganze Zahl von 0 oder 1 bedeuten,
mit der Maßgabe, dass das Kohlenstoffatom, an das R₁₇ gebunden ist, und das Kohlenstoffatom, an das R₂₀ gebunden ist, das Kohlenstoffatom, an das R₁₉ gebunden ist, und das Kohlenstoffatom, an das R₂₈ gebunden ist, das Kohlenstoffatom, an das R₃₂ gebunden ist, und das Kohlenstoffatom, an das R₄₀ gebunden ist, oder das Kohlenstoffatom, an das R₃₇ gebunden ist, und das Kohlenstoffatom, an das R₃₈ gebunden ist, direkt oder über ein Sauerstoffatom bzw. ein Schwefelatom unter Bildung eines Rings aneinander gebunden sein können, und wenn ein derartiger Ring gebildet wird, R₁₇ und R₂₀, R₁₉ und R₂₈, R₃₂ und R₄₀ oder R₃₇ und R₃₈ zusammen die direkte Bindung, das Sauerstoffatom oder das Schwefelatom darstellen und
R₂₂ und R₃₁ bzw. R₂₁ und R₂₉ direkt unter Bildung eines Rings, der einen Substituenten aufweisen kann, aneinander gebunden sein können.

5. Das Blockcopolymer nach Anspruch 2, welches mindestens zwei Arten von durch die allgemeine Formel (V) dargestellten wiederkehrenden Einheiten als Ar₁ in der allgemeinen Formel (II) umfasst.

6. Das Blockcopolymer nach Anspruch 2 oder 5, wobei der Gesamtgehalt der durch die allgemeine Formel (V) dargestellten wiederkehrenden Einheit(en) 3 Mol-% oder mehr und 40 Mol-% oder weniger, als Ar₁ in der allgemeinen Formel (II) bezogen auf alle wiederkehrenden Einheiten in dem Blockcopolymer, beträgt.

7. Die Polymerverbindung nach Anspruch 4, wobei der durch die allgemeine Formel (VII) dargestellte Rest mindestens einer ist, der aus der Gruppe bestehend aus einem Rest, in dem x in der Formel (VII) 0 ist, und einem durch die folgende allgemeine Formel (VIII) dargestellten Rest ausgewählt ist: 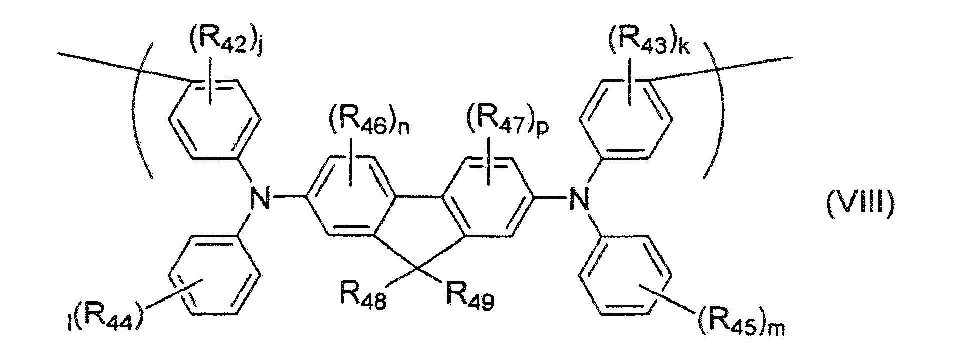 wobei R₄₂ bis R₄₇ gleich oder verschieden sein können und jeweils ein Halogenatom, einen Alkylrest, einen Alkoxyrest, einen Alkylthiorest, einen Arylrest, einen Aryloxyrest, einen Arylthiorest, einen Arylalkylrest, einen Arylalkoxyrest, einen Arylalkylthiorest, einen Arylalkenylrest, einen Arylalkinylrest, eine Aminogruppe, eine substituierte Aminogruppe, eine Silylgruppe, eine substituierte Silylgruppe, einen Acylrest, einen Acyloxyrest, einen Iminrest, einen Amidrest, einen Säureimidrest, einen einwertigen heterocyclischen Rest, eine Carboxylgruppe, eine substituierte Carboxylgruppe, eine Cyanogruppe oder eine Nitrogruppe bedeuten,
j und k gleich oder verschieden sein können und jeweils eine ganze Zahl von 0 bis 4 bedeuten,
1 und m gleich oder verschieden sein können und jeweils eine ganze Zahl von 0 bis 5 bedeuten und
n und p gleich oder verschieden sein können und jeweils eine ganze Zahl von 0 bis 3 bedeuten,
mit der Maßgabe, dass, wenn eine Vielzahl von mindestens einem der Reste aus R₄₂, R₄₃, R₄₄, R₄₅, R₄₆ oder R₄₇ vorhanden sind, diese gleich oder verschieden sein können, und R₄₈ und R₄₉ gleich oder verschieden sein können und jeweils ein Wasserstoffatom, einen Alkylrest, einen Alkoxyrest, einen Alkylthiorest, einen Arylrest, einen Aryloxyrest, einen Arylthiorest, einen Arylalkylrest, einen Arylalkoxyrest, einen Arylalkylthiorest, einen Arylalkenylrest, einen Arylalkinylrest, eine Aminogruppe, eine substituierte Aminogruppe, eine Silylgruppe, eine substituierte Silylgruppe, ein Halogenatom, einen Acylrest, einen Acyloxyrest, einen Iminrest, einen Amidrest, einen Säureimidrest, einen einwertigen heterocyclischen Rest, eine Carboxylgruppe, eine substituierte Carboxylgruppe, eine Cyanogruppe oder eine Nitrogruppe bedeuten.

8. Das Blockcopolymer nach einem der Ansprüche 1 bis 7, wobei das Molverhältnis des Blocks (A) zu dem Block (B) ((A)/(B)) 0,1 bis 10 beträgt.

9. Das Blockcopolymer nach einem der Ansprüche 1 bis 8, welches ein Polystyrol-äquivalentes Gewichtsmittel des Molekulargewichts von 10³ bis 10⁷ aufweist.

10. Das Blockcopolymer nach einem der Ansprüche 1 bis 9, wobei der Block (A) ein Polystyrol-äquivalentes Gewichtsmittel des Molekulargewichts von 10³ bis 10⁵ aufweist.

11. Eine Zusammensetzung, **dadurch gekennzeichnet, dass** sie das Blockcopolymer nach einem der Ansprüche 1 bis 10 und mindestens ein Material, ausgewählt aus der Gruppe bestehend aus einem lichtemittierenden Material, einem lochtransportierenden Material und einem elektronentransportierenden Material, umfasst.

12. Eine flüssige Zusammensetzung, **dadurch gekennzeichnet, dass** sie das Blockcopolymer nach einem der Ansprüche 1 bis 10 und ein Lösungsmittel umfasst.

13. Eine lichtemittierende Dünnfolie, **dadurch gekennzeichnet, dass** sie das Blockcopolymer nach einem der Ansprüche 1 bis 10 umfasst.

14. Eine polymere lichtemittierende Vorrichtung, **dadurch gekennzeichnet, dass** sie zwischen Elektroden, die aus einer Anode und einer Kathode bestehen, eine organische Schicht umfasst, die das Blockcopolymer nach einem der Ansprüche 1 bis 10 enthält.

15. Die polymere lichtemittierende Vorrichtung nach Anspruch 14, wobei die organische Schicht eine lichtemittierende Schicht ist.

## Revendications

1. Copolymère à blocs, **caractérisé en ce qu'**il comporte :
- un bloc (A) comportant au moins un motif répété représenté par la formule générale (I) présentée ci-dessous, au moins un motif répété représenté par la formule générale (II) présentée ci-dessous et au moins un motif répété représenté par la formule générale (III) présentée ci-dessous ;
- et un bloc (B) comportant au moins un motif répété représenté par la formule générale (III) présentée ci-dessous et au moins un motif répété représenté par la formule générale (IV) présentée ci-dessous ; 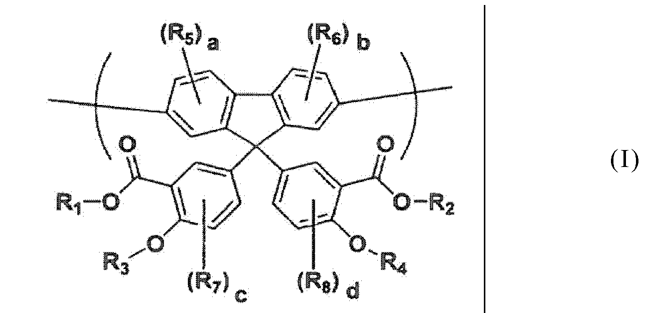
dans laquelle formule les symboles R₁, R₂, R₃ et R₄ représentent des entités qui peuvent être identiques ou différentes et représentent chacun un atome d'hydrogène ou un groupe alkyle, les symboles R₅, R₆, R₇ et R₈ représentent des entités qui peuvent être identiques ou différentes et représentent chacun un groupe alkyle, un groupe alcoxy, un groupe alkylthio, un groupe aryle, un groupe aryloxy, un groupe arylthio, un groupe aryl-alkyle, un groupe aryl-alcoxy, un groupe aryl-alkylthio, un groupe aryl-alcényle, un groupe aryl-alcynyle, un groupe amino, un groupe amino porteur d'un ou de substituant(s), un groupe silyle, un groupe silyle porteur d'un ou de substituant(s), un atome d'halogène, un groupe acyle, un groupe acyloxy, un résidu de type imine, un groupe de type amide, un groupe de type imide acide, un groupe hétérocyclique monovalent, un groupe carboxyle, un groupe carboxyle porteur d'un substituant, un groupe cyano ou un groupe nitro, et les indices a, b, c et d sont des nombres qui peuvent être identiques ou différents et sont chacun un nombre entier valant de 0 à 3, étant entendu que, s'il y a plusieurs entités représentées par R₅, R₆, R₇ ou R₈, elles peuvent être identiques ou différentes ;
-Ar₁- (II)
dans laquelle Ar₁ représente un groupe hétérocyclique divalent comportant un cycle à 5 chaînons ;
-Ar₂- (III)
dans laquelle Ar₂ représente un groupe arènediyle ;
-Ar₃- (IV)
dans laquelle Ar₃ représente un résidu divalent d'amine aromatique.

2. Copolymère à blocs conforme à la revendication 1, pour lequel, dans la formule générale (II), A1ₗ représente un groupe de formule générale (V) suivante : 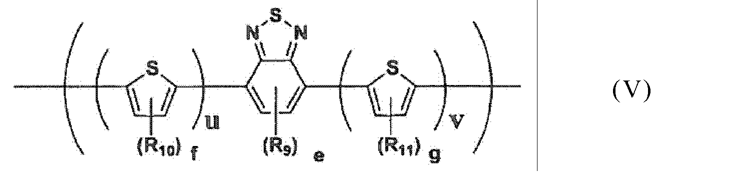 dans laquelle les symboles R₉, R₁₀ et R₁₁ représentent des entités qui peuvent être identiques ou différentes et représentent chacun un groupe alkyle, un groupe alcoxy, un groupe alkylthio, un groupe aryle, un groupe aryloxy, un groupe arylthio, un groupe aryl-alkyle, un groupe aryl-alcoxy, un groupe aryl-alkylthio, un groupe aryl-alcényle, un groupe aryl-alcynyle, un groupe amino, un groupe amino porteur d'un ou de substituant(s), un groupe silyle, un groupe silyle porteur d'un ou de substituant(s), un atome d'halogène, un groupe acyle, un groupe acyloxy, un résidu de type imine, un groupe de type amide, un groupe de type imide acide, un groupe hétérocyclique monovalent, un groupe carboxyle, un groupe carboxyle porteur d'un substituant, un groupe cyano ou un groupe nitro, les indices e, f et g sont des nombres qui peuvent être identiques ou différents et sont chacun un nombre entier valant de 0 à 2, et les indices u et v sont des nombres qui peuvent être identiques ou différents et sont chacun un nombre entier valant de 0 à 2, étant entendu que, s'il y a plusieurs entités représentées par R₉, R₁₀ ou R₁₁, elles peuvent être identiques ou différentes.

3. Copolymère à blocs conforme à la revendication 1 ou 2, pour lequel, dans la formule générale (III), Ar₂ représente un groupe de formule générale (VI) suivante : 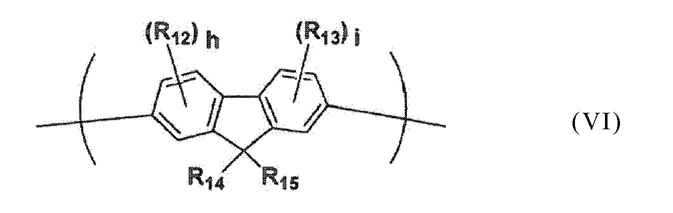 dans laquelle les symboles R₁₂ et R₁₃ représentent des entités qui peuvent être identiques ou différentes et représentent chacun un groupe alkyle, un groupe alcoxy, un groupe alkylthio, un groupe aryle, un groupe aryloxy, un groupe arylthio, un groupe aryl-alkyle, un groupe aryl-alcoxy, un groupe aryl-alkylthio, un groupe aryl-alcényle, un groupe aryl-alcynyle, un groupe amino, un groupe amino porteur d'un ou de substituant(s), un groupe silyle, un groupe silyle porteur d'un ou de substituant(s), un atome d'halogène, un groupe acyle, un groupe acyloxy, un résidu de type imine, un groupe de type amide, un groupe de type imide acide, un groupe hétérocyclique monovalent, un groupe carboxyle, un groupe carboxyle porteur d'un substituant, un groupe cyano ou un groupe nitro, les indices h et i sont des nombres qui peuvent être identiques ou différents et sont chacun un nombre entier valant de 0 à 3, et les symboles R₁₄ et R₁₅ représentent des entités qui peuvent être identiques ou différentes et représentent chacun un atome d'hydrogène, un groupe alkyle, un groupe alcoxy, un groupe alkylthio, un groupe aryle, un groupe aryloxy, un groupe arylthio, un groupe aryl-alkyle, un groupe aryl-alcoxy, un groupe aryl-alkylthio, un groupe aryl-alcényle, un groupe aryl-alcynyle, un groupe amino, un groupe amino porteur d'un ou de substituant(s), un groupe silyle, un groupe silyle porteur d'un ou de substituant(s), un atome d'halogène, un groupe acyle, un groupe acyloxy, un résidu de type imine, un groupe de type amide, un groupe de type imide acide, un groupe hétérocyclique monovalent, un groupe carboxyle, un groupe carboxyle porteur d'un substituant, un groupe cyano ou un groupe nitro, étant entendu que, s'il y a plusieurs entités représentées par R₁₂ ou R₁₃, elles peuvent être identiques ou différentes.

4. Copolymère à blocs conforme à l'une des revendications 1 à 3, pour lequel, dans la formule générale (IV), Ar₃ représente un groupe de formule générale (VII) suivante : 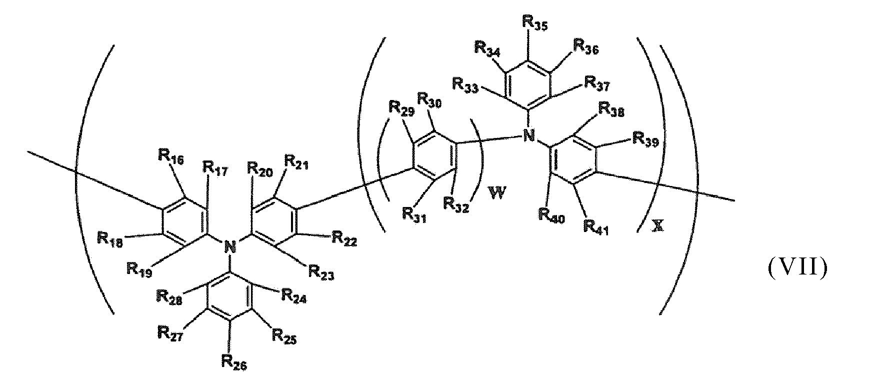 dans laquelle les symboles R₁₆ à R₄₁ représentent des entités qui peuvent être identiques ou différentes et représentent chacun un atome d'hydrogène, un groupe alkyle, un groupe alcoxy, un groupe alkylthio, un groupe aryle, un groupe aryloxy, un groupe arylthio, un groupe aryl-alkyle, un groupe aryl-alcoxy, un groupe aryl-alkylthio, un groupe aryl-alcényle, un groupe aryl-alcynyle, un groupe amino, un groupe amino porteur d'un ou de substituant(s), un groupe silyle, un groupe silyle porteur d'un ou de substituant(s), un atome d'halogène, un groupe acyle, un groupe acyloxy, un résidu de type imine, un groupe de type amide, un groupe de type imide acide, un groupe hétérocyclique monovalent, un groupe carboxyle, un groupe carboxyle porteur d'un substituant, un groupe cyano ou un groupe nitro, et les indices w et x sont des nombres qui peuvent être identiques ou différents et sont chacun un nombre entier valant 0 ou 1, étant entendu que l'atome de carbone auquel est liée l'entité R₁₇ et l'atome de carbone auquel est liée l'entité R₂₀, l'atome de carbone auquel est liée l'entité R₁₉ et l'atome de carbone auquel est liée l'entité R₂₈, l'atome de carbone auquel est liée l'entité R₃₂ et l'atome de carbone auquel est liée l'entité R₄₀, ou l'atome de carbone auquel est liée l'entité R₃₇ et l'atome de carbone auquel est liée l'entité R₃₈, peuvent respectivement être liés l'un à l'autre, par liaison directe ou par l'intermédiaire d'un atome d'oxygène ou d'un atome de soufre, de manière à former un cycle, et que, quand il y a formation d'un tel cycle, R₁₇ et R₂₀, R₁₉ et R₂₈, R₃₂ et R₄₀, ou R₃₇ et R₃₈, représentent conjointement cette liaison directe ou cet atome d'oxygène ou de soufre,
et étant entendu que les entités symbolisées par R₂₂ et R₃₁, ou par R₂₁ et R₂₉, peuvent respectivement être liées l'une à l'autre par liaison directe, de manière à former un cycle qui peut porter un substituant.

5. Copolymère à blocs conforme à la revendication 2, qui comporte des motifs répétés de formule générale (V) d'au moins deux types, en tant que motifs symbolisés par Ar₁ dans la formule générale (II)

6. Copolymère à blocs conforme à la revendication 2 ou 5, dans lequel la proportion totale de motifs répétés de formule générale (V), en tant que motifs symbolisés par Ar₁ dans la formule générale (II), vaut au moins 3 % en moles et au plus 40 % en moles, par rapport à l'ensemble de tous les motifs répétés présents dans le copolymère à blocs.

7. Composé polymère conforme à la revendication 4, dans lequel le motif représenté par la formule générale (VII) est au moins un motif choisi parmi un motif de formule (VII) où l'indice x vaut 0 et un motif représenté par la formule générale (VIII) suivante : 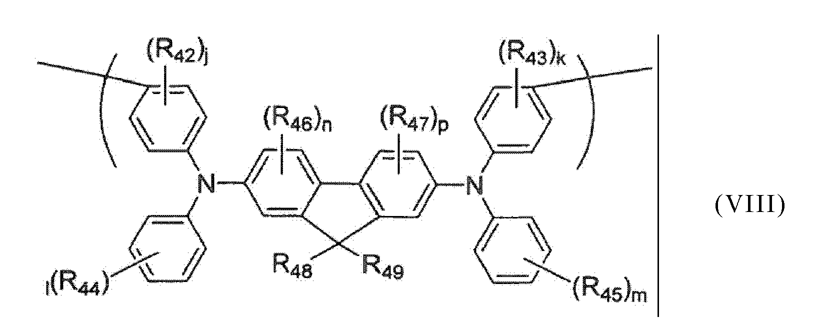 dans laquelle les symboles R₄₂ à R₄₇ représentent des entités qui peuvent être identiques ou différentes et représentent chacun un atome d'halogène, un groupe alkyle, un groupe alcoxy, un groupe alkylthio, un groupe aryle, un groupe aryloxy, un groupe arylthio, un groupe aryl-alkyle, un groupe aryl-alcoxy, un groupe aryl-alkylthio, un groupe aryl-alcényle, un groupe aryl-alcynyle, un groupe amino, un groupe amino porteur d'un ou de substituant(s), un groupe silyle, un groupe silyle porteur d'un ou de substituant(s), un groupe acyle, un groupe acyloxy, un résidu de type imine, un groupe de type amide, un groupe de type imide acide, un groupe hétérocyclique monovalent, un groupe carboxyle, un groupe carboxyle porteur d'un substituant, un groupe cyano ou un groupe nitro,
les indices j et k sont des nombres qui peuvent être identiques ou différents et sont chacun un nombre entier valant de 0 à 4,
les indices 1 et m sont des nombres qui peuvent être identiques ou différents et sont chacun un nombre entier valant de 0 à 5,
et les indices n et p sont des nombres qui peuvent être identiques ou différents et sont chacun un nombre entier valant de 0 à 3,
étant entendu que, s'il y a plusieurs entités représentées par l'un au moins des symboles R₄₂, R₄₃, R₄₄, R₄₅, R₄₆ et R₄₇, elles peuvent être identiques ou différentes,
et dans laquelle les symboles R₄₈ et R₄₉ représentent des entités qui peuvent être identiques ou différentes et représentent chacun un atome d'hydrogène, un groupe alkyle, un groupe alcoxy, un groupe alkylthio, un groupe aryle, un groupe aryloxy, un groupe arylthio, un groupe aryl-alkyle, un groupe aryl-alcoxy, un groupe aryl-alkylthio, un groupe aryl-alcényle, un groupe aryl-alcynyle, un groupe amino, un groupe amino porteur d'un ou de substituant(s), un groupe silyle, un groupe silyle porteur d'un ou de substituant(s), un atome d'halogène, un groupe acyle, un groupe acyloxy, un résidu de type imine, un groupe de type amide, un groupe de type imide acide, un groupe hétérocyclique monovalent, un groupe carboxyle, un groupe carboxyle porteur d'un substituant, un groupe cyano ou un groupe nitro.

8. Copolymère à blocs conforme à l'une des revendications 1 à 7, dans lequel le rapport molaire du bloc (A) au bloc (B), (A)/(B), vaut de 0,1 à 10.

9. Copolymère à blocs conforme à l'une des revendications 1 à 8, qui présente une masse molaire moyenne en poids, en équivalent polystyrène, de 10³ à 10⁷.

10. Copolymère à blocs conforme à l'une des revendications 1 à 9, dans lequel le bloc (A) présente une masse molaire moyenne en poids, en équivalent polystyrène, de 10³ à 10⁵.

11. Composition **caractérisée en ce qu'**elle comprend un copolymère à blocs conforme à l'une des revendications 1 à 10, et au moins un matériau choisi dans l'ensemble constitué par un matériau photo-émetteur, un matériau à transport de trous et un matériau à transport d'électrons.

12. Composition liquide **caractérisée en ce qu'**elle comprend un copolymère à blocs conforme à l'une des revendications 1 à 10 et un solvant.

13. Film mince photo-émetteur, **caractérisé en ce qu'**il comprend un copolymère à blocs conforme à l'une des revendications 1 à 10.

14. Dispositif photo-émetteur à polymère, **caractérisé en ce qu'**il comprend, entre des électrodes consistant en une anode et une cathode, une couche organique comprenant un copolymère à blocs conforme à l'une des revendications 1 à 10.

15. Dispositif photo-émetteur à polymère, conforme à la revendication 14, dans laquelle la couche organique est une couche photoémettrice.
